# EUROPEAN PATENT APPLICATION

(11) **EP 4 672 948 A1**
(43) Date of publication of application: **31.12.2025**
(21) Application number: 24760645.2
(22) Date of filing: 15.02.2024
(51) Int. Cl.: H10K 85/60, H10K 50/12, C09K 11/06, H10K 50/81, H10K 50/11

(54) **COMPOUND FOR ORGANIC OPTOELECTRONIC DEVICE, COMPOSITION FOR ORGANIC OPTOELECTRONIC DEVICE, ORGANIC OPTOELECTRONIC DEVICE, AND DISPLAY DEVICE**

(30) Priority: 23.02.2023 KR 20230024477; 15.01.2024 KR 20240006320
(71) Applicant: SAMSUNG SDI CO., LTD., Yongin-si, Gyeonggi-do 17084 (KR)
(72) Inventor: KIM, Changwoo, Suwon-si, Gyeonggi-do 16678 (KR); LEE, Mijin, Suwon-si, Gyeonggi-do 16678 (KR); KANG, Dong Min, Suwon-si, Gyeonggi-do 16678 (KR); JUNG, Sung-Hyun, Suwon-si, Gyeonggi-do 16678 (KR); KIM, Hyung Sun, Suwon-si, Gyeonggi-do 16678 (KR); SHIN, Jihun, Suwon-si, Gyeonggi-do 16678 (KR); JANG, Kipo, Suwon-si, Gyeonggi-do 16678 (KR); SEO, Hansol, Suwon-si, Gyeonggi-do 16678 (KR); KIM, Yunsoo, Suwon-si, Gyeonggi-do 16678 (KR)
(74) Representative: Michalski Hüttermann & Partner Patentanwälte mbB
(86) International application number: PCT/KR2024/095250
(87) International publication number: WO 2024/177457

(57) **Abstract**

Disclosed are a compound for an organic optoelectronic device represented by Chemical Formula 1A or Chemical Formula 1B, an organic optoelectronic device including the same, and a display device.

The contents of Chemical Formula 1A and Chemical Formula 1B are as defined in the specification.

## Description

### [Technical Field]

A compound for an organic optoelectronic device, a composition for an organic optoelectronic device, an organic optoelectronic device, and a display device are disclosed.

### [Background Art]

An organic optoelectronic device (organic optoelectronic diode) is a device capable of converting electrical energy and optical energy to each other.

Organic optoelectronic devices may be largely divided into two types according to a principle of operation. One is a photoelectric device that generates electrical energy by separating excitons formed by light energy into electrons and holes, and transferring the electrons and holes to different electrodes, respectively and the other is light emitting device that generates light energy from electrical energy by supplying voltage or current to the electrodes.

Examples of the organic optoelectronic device include an organic photoelectric device, an organic light emitting diode, an organic solar cell, and an organic photoconductor drum.

Among them, organic light emitting diodes (OLEDs) are attracting much attention in recent years due to increasing demands for flat panel display devices. The organic light emitting diode is a device that converts electrical energy into light, and the performance of the organic light emitting diode is greatly influenced by an organic material between electrodes.

### [Disclosure]

### [Technical Problem]

An embodiment provides a compound for an organic optoelectronic device capable of implementing a high-efficiency and long life-span organic optoelectronic device.

Another embodiment provides a composition for an organic optoelectronic device including the compound for the organic optoelectronic device.

Another embodiment provides an organic optoelectronic device including the compound for the organic optoelectronic device.

Another embodiment provides a display device including the organic optoelectronic device.

### [Technical Solution]

According to an embodiment, a compound for an organic optoelectronic device represented by Chemical Formula 1A or Chemical Formula 1B is provided.

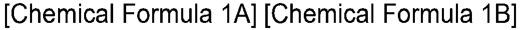

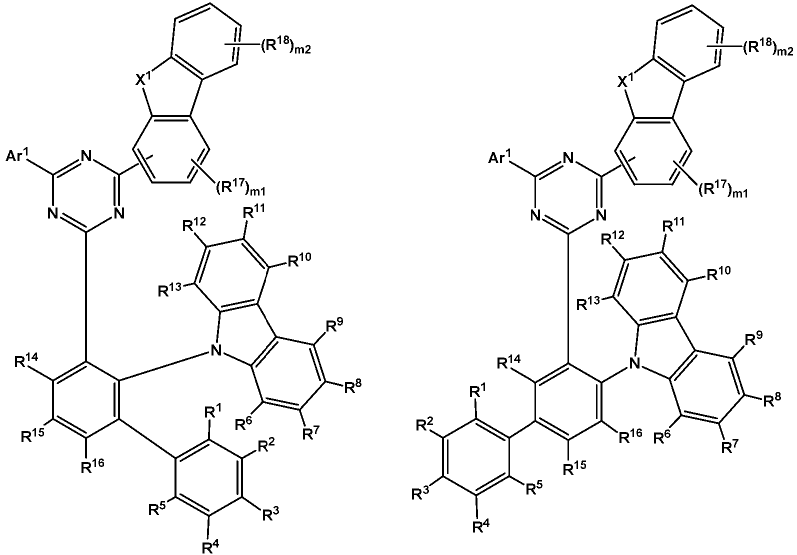

In Chemical Formula 1,
X¹ is O or S,
R¹ to R¹³, R¹⁷, and R¹⁸ are each independently hydrogen, deuterium, a substituted or unsubstituted C1 to C10 alkyl group, a substituted or unsubstituted C6 to C20 aryl group, or a substituted or unsubstituted C2 to C20 heterocyclic group,
R¹⁴ to R¹⁶ are each independently hydrogen or deuterium,
Ar¹ is a substituted or unsubstituted C6 to C20 aryl group or a substituted or unsubstituted C2 to C20 heterocyclic group,
m1 is one of integers of 1 to 3,
m2 is one of integers of 1 to 4,
when m1 is 2 or more, each R¹⁷ is the same or different from each other, and
when m2 is 2 or more, each R¹⁸ is the same or different from each other.

According to another embodiment, a composition for an organic optoelectronic device including a first compound and a second compound is provided.

The first compound may be the aforementioned compound for the organic optoelectronic device, and the second compound may be represented by Chemical Formula 2; a combination of Chemical Formula 3 and Chemical Formula 4; or Chemical Formula 5.

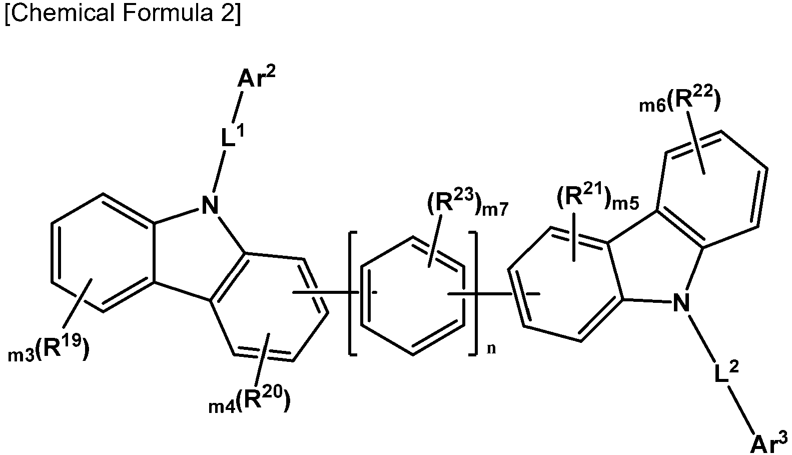

In Chemical Formula 2,
R¹⁹ to R²³ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar² and Ar³ are each independently a substituted or unsubstituted C6 to C20 aryl group or a substituted or unsubstituted C2 to C30 heterocyclic group,
L¹ and L² are each independently a single bond or a substituted or unsubstituted C6 to C20 arylene group,
m3, m6, and m7 are each independently one of integers of 1 to 4,
m4 and m5 are each independently one of integers of 1 to 3, and
n is one of integers of 0 to 2; 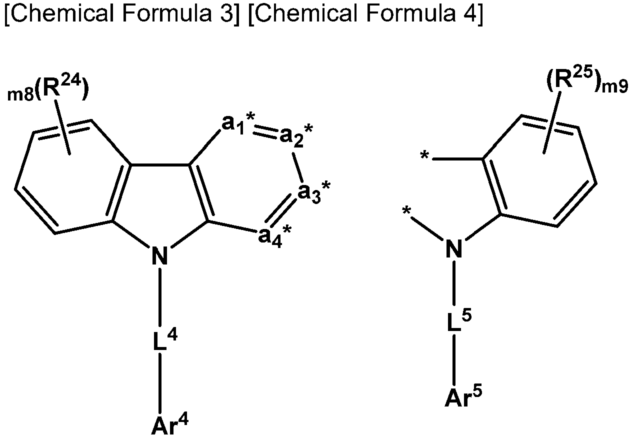
wherein, in Chemical Formula 3 and Chemical Formula 4,
a₁* to a₄* in Chemical Formula 3 are each independently a linking carbon (C) or C-L^{a}-R^{a},
among a₁* to a₄* in Chemical Formula 3, two adjacent ones are each linked to *s in Chemical Formula 4,
L^{a}, L⁴, and L⁵ are each independently a single bond or a substituted or unsubstituted C6 to C20 arylene group,
R^{a}, R²⁴, and R²⁵ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group, and
m8 and m9 are each independently one of integers of 1 to 4;

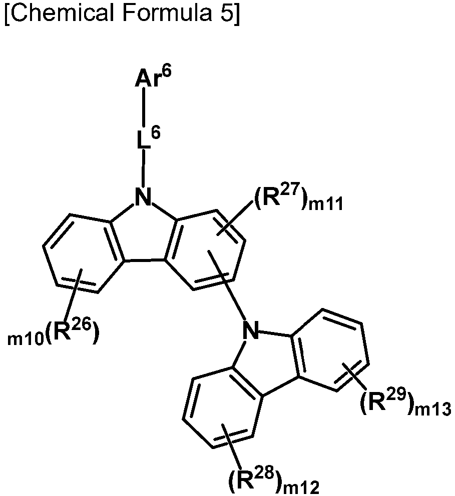

In Chemical Formula 5,
L⁶ are each independently a single bond or a substituted or unsubstituted C6 to C20 arylene group,
R²⁶ to R²⁹ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁶ is a substituted or unsubstituted C6 to C20 aryl group or a substituted or unsubstituted C2 to C30 heterocyclic group,
m10, m12, and m13 are each independently one of integers of 1 to 4,
m11 is one of integers of 1 to 3,
when m10 is 2 or more, each R²⁶ is the same or different from each other,
when m11 is 2 or more, each R²⁷ is the same or different from each other,
when m12 is 2 or more, each R²⁸ is the same or different from each other, and
when m13 is 2 or more, each R²⁹ is the same or different from each other.

According to another embodiment, an organic optoelectronic device includes an anode and a cathode facing each other, and at least one organic layer between the anode and the cathode, wherein the organic layer includes the compound for the organic optoelectronic device.

According to another embodiment, a display device including the organic optoelectronic device is provided.

### [Advantageous Effects]

An organic optoelectronic device having high efficiency and a long life-span may be realized.

### [Description of the Drawings]

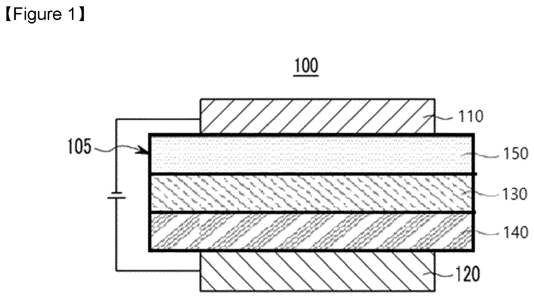

FIG. 1 is a cross-sectional view illustrating an organic light emitting diode according to an embodiment.

### <Description of Symbols>

100: organic light emitting diode
105: organic layer
110: cathode
120: anode
130: light emitting layer
140: hole transport region
150: electron transport region

### [Best Mode]

Hereinafter, embodiments of the present invention are described in detail. However, these embodiments are exemplary, and this disclosure is not limited thereto.

As used herein, when a definition is not otherwise provided, "substituted" refers to replacement of at least one hydrogen of a substituent or a compound by deuterium, a halogen, a hydroxyl group, an amino group, a substituted or unsubstituted C1 to C30 amine group, a nitro group, a substituted or unsubstituted C1 to C40 silyl group, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, a C1 to C20 alkoxy group, a C1 to C10 trifluoroalkyl group, a cyano group, or a combination thereof.

In one example of the present invention, the "substituted" refers to replacement of at least one hydrogen of a substituent or a compound by deuterium, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, or a cyano group. In specific example of the present invention, the "substituted" refers to replacement of at least one hydrogen of a substituent or a compound by deuterium, a C1 to C20 alkyl group, a C6 to C30 aryl group, or a cyano group. In specific example of the present invention, the "substituted" refers to replacement of at least one hydrogen of a substituent or a compound by deuterium, a C1 to C5 alkyl group, a C6 to C18 aryl group, or a cyano group. In specific example of the present invention, the "substituted" refers to replacement of at least one hydrogen of a substituent or a compound by deuterium, a cyano group, a methyl group, an ethyl group, a propyl group, a butyl group, a phenyl group, a biphenyl group, a terphenyl group, or a naphthyl group.

In the present specification, "unsubstituted" refers to non-replacement of a hydrogen atom by another substituent and remaining of the hydrogen atom.

In the present specification, "hydrogen substitution (-H)" may include "deuterium substitution (-D)" or "tritium substitution (-T)."

As used herein, when a definition is not otherwise provided, "hetero" refers to one including one to three heteroatoms selected from N, O, S, P, and Si, and remaining carbons in one functional group.

As used herein, "aryl group" refers to a group including at least one hydrocarbon aromatic moiety, and all elements of the hydrocarbon aromatic moiety have p-orbitals which form conjugation, for example a phenyl group, a naphthyl group, and the like, two or more hydrocarbon aromatic moieties may be linked by a sigma bond and may be, for example a biphenyl group, a terphenyl group, a quaterphenyl group, and the like, and two or more hydrocarbon aromatic moieties are fused directly or indirectly to provide a non-aromatic fused ring, for example a fluorenyl group.

The aryl group may include a monocyclic, polycyclic, or fused ring polycyclic (i.e., rings sharing adjacent pairs of carbon atoms) functional group.

As used herein, "heterocyclic group" is a generic concept of a heteroaryl group, and may include at least one heteroatom selected from N, O, S, P, and Si instead of carbon (C) in a cyclic compound such as aryl group, a cycloalkyl group, a fused ring thereof, or a combination thereof. When the heterocyclic group is a fused ring, the entire ring or each ring of the heterocyclic group may include one or more heteroatoms.

As an example, "heteroaryl group" may refer to aryl group including at least one heteroatom selected from N, O, S, P, and Si. Two or more heteroaryl groups are linked by a sigma bond directly, or when the heteroaryl group includes two or more rings, the two or more rings may be fused. When the heteroaryl group is a fused ring, each ring may include one to three heteroatoms.

More specifically, the substituted or unsubstituted C6 to C30 aryl group may be a substituted or unsubstituted phenyl group, a substituted or unsubstituted naphthyl group, a substituted or unsubstituted anthracenyl group, a substituted or unsubstituted phenanthrenyl group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted o-terphenyl group, a substituted or unsubstituted chrysenyl group, a substituted or unsubstituted benzophenanthrenyl group, a substituted or unsubstituted triphenylene group, a substituted or unsubstituted perylenyl group, a substituted or unsubstituted fluorenyl group, a substituted or unsubstituted indenyl group, or a combination thereof, but is not limited thereto.

More specifically, the substituted or unsubstituted C2 to C30 heterocyclic group may be a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted carbazolyl group, a substituted or unsubstituted dibenzofuranyl group, or a substituted or unsubstituted dibenzothiophenyl group, a substituted or unsubstituted benzonaphthofuranyl group, a substituted or unsubstituted benzonaphthothiophenyl group, a substituted or unsubstituted benzofuranofluorenyl group, a substituted or unsubstituted benzothiophenefluorenyl group, or a combination thereof, but is not limited thereto.

As used herein, hole characteristics refer to an ability to donate an electron to form a hole when an electric field is applied and that a hole formed in the anode may be easily injected into the light emitting layer and transported in the light emitting layer due to conductive characteristics according to a highest occupied molecular orbital (HOMO) level.

In addition, electronic characteristics refer to an ability to accept an electron when an electric field is applied and that electron formed in the cathode may be easily injected into the light emitting layer and transported in the light emitting layer due to conductive characteristics according to a lowest unoccupied molecular orbital (LUMO) level.

Hereinafter, a compound for an organic optoelectronic device according to an embodiment is described.

The compound for the organic optoelectronic device according to an embodiment is represented by Chemical Formula 1.

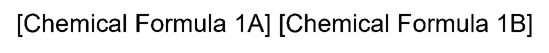

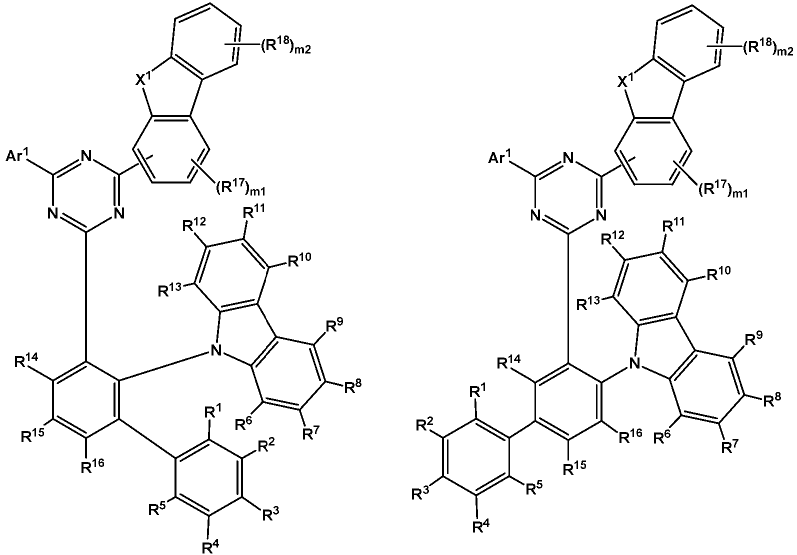

In Chemical Formula 1,
X¹ is O or S,
R¹ to R¹³, R¹⁷, and R¹⁸ are each independently hydrogen, deuterium, a substituted or unsubstituted C1 to C10 alkyl group, a substituted or unsubstituted C6 to C20 aryl group, or a substituted or unsubstituted C2 to C20 heterocyclic group,
R¹⁴ to R¹⁶ are each independently hydrogen or deuterium,
Ar¹ is a substituted or unsubstituted C6 to C20 aryl group or a substituted or unsubstituted C2 to C20 heterocyclic group,
m1 is one of integers of 1 to 3, and
m2 is one of integers of 1 to 4.

Compounds represented by Chemical Formula 1A and Chemical Formula 1B have N-carbazole substituted at the ortho position of phenylene linked to triazine, a substituted or unsubstituted phenyl group substituted at the meta position of phenylene with respect to the triazine, and the triazine substituted with at least one dibenzofuran (or dibenzothiophene).

The compound represented by Chemical Formula 1A or Chemical Formula 1B has a structure including ortho-carbazole in triazine and has particularly excellent energy transfer efficiency as a phosphorescent dopant, and thus it can be used as an advantageous material as a phosphorescent host. The meta-biphenyl structure substituted with the triazine contained in Chemical Formula 1A or Chemical Formula 1B can improve the life-span when applied as a phosphorescent host by accelerating the electron mobility and increasing the stability compared to the mono-phenyl structure. In addition, the phenyl group at the end of the meta-biphenyl structure is substituted at the ortho and para positions with respect to the carbazole moiety, respectively, which helps expand the resonance structure of the carbazole moiety, and this helps stabilize the hole transport part within the molecule. This results in an optimization of charge balance between the electron transport and hole transport parts within the molecule, which further helps to improve the life-span.

In addition, when carbazole is substituted at the ortho position of the triazine, the dihedral angle increases due to the steric hindrance between the triazine and carbazole, and the triazine moiety and the carbazole moiety twist with each other, thereby increasing the dihedral angle. This means that the electron clouds of the HOMO level and LUMO level are mostly separated without overlapping, and because it has a small ΔEst, rapid energy transfer is enabled, and high efficiency characteristics may be exhibited, especially when applied as a phosphorescent host. In addition, the side reaction path in the excited state is reduced, and thus the life-span increase effect can be further obtained.

In addition, by substituting the triazine with at least one dibenzofuran (or dibenzothiophene), the electron mobility may be accelerated and the stability may be increased compared to diphenyl triazine or bis-biphenyl triazine, thereby improving the driving effect and life-span.

In addition, by designing the three substituents differently around the six-membered nitrogen ring, steric hindrance is achieved, resulting in a low deposition temperature, and thus the life-span characteristics of the organic light emitting diode to which it is applied may be significantly improved.

Chemical Formula 1A and Chemical Formula 1B, when two or more R¹⁷s are substituted, each R¹⁷ may be the same or different from each other.

In Chemical Formula 1A and Chemical Formula 1B, when two or more R¹⁸s are substituted, each R¹⁸ may be the same or different from each other.

For example, Chemical Formula 1A may be represented by any one of Chemical Formula 1A-1 to Chemical Formula 1A-4.

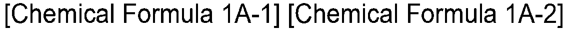

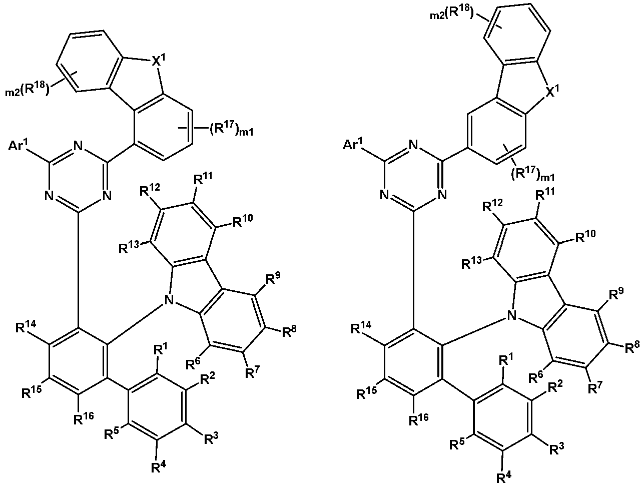

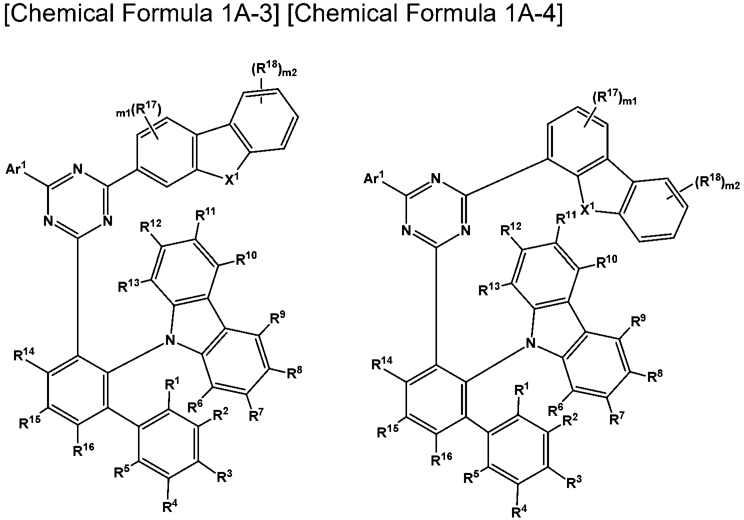

In Chemical Formula 1A-1 to Chemical Formula 1A-4,
the definitions of R¹ to R¹⁸, Ar¹, m1, and m2 are the same as described above.

For example, Chemical Formula 1B may be represented by any one of Chemical Formula 1B-1 to Chemical Formula 1B-4.

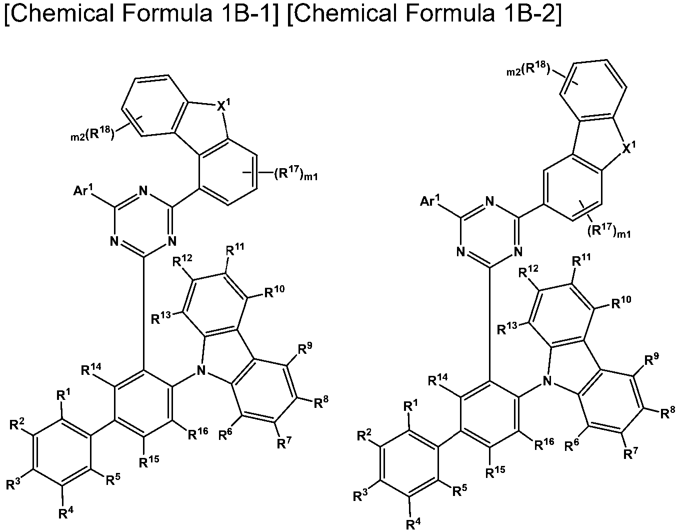

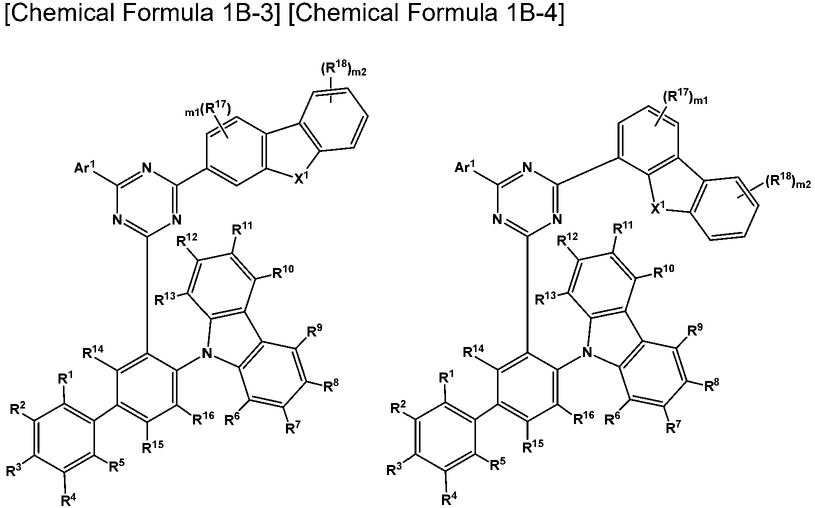

In Chemical Formula 1B-1 to Chemical Formula 1B-4,
the definitions of R¹ to R¹⁸, Ar¹, m1, and m2 are the same as described above.

As a specific example, above Chemical Formula 1 may be represented by Chemical Formula 1A-3 or Chemical Formula 1B-3.

For example, Ar¹ may be a substituted or unsubstituted phenyl group, a substituted or unsubstituted biphenyl group, or a substituted or unsubstituted terphenyl group.

For example, R¹ to R¹³, R¹⁷, and R¹⁸ may each independently be hydrogen, deuterium, or a substituted or unsubstituted C6 to C12 aryl group.

As a specific example, R¹⁷ and R¹⁸ may each independently be hydrogen, deuterium, or a substituted or unsubstituted phenyl group.

In the most specific embodiment, the compound represented by Chemical Formula 1 may be one selected from the compounds listed in Group 1, but is not limited thereto. 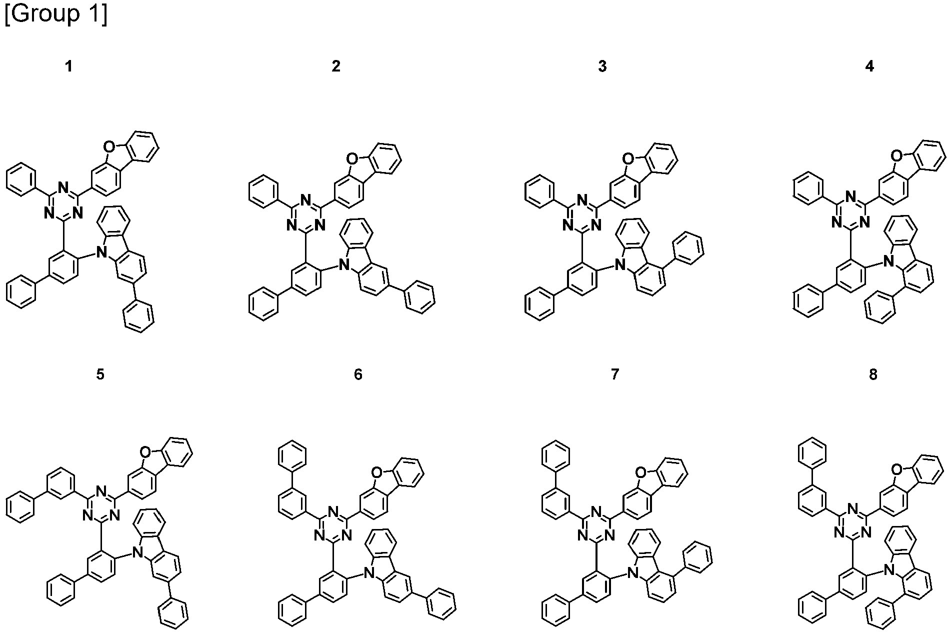 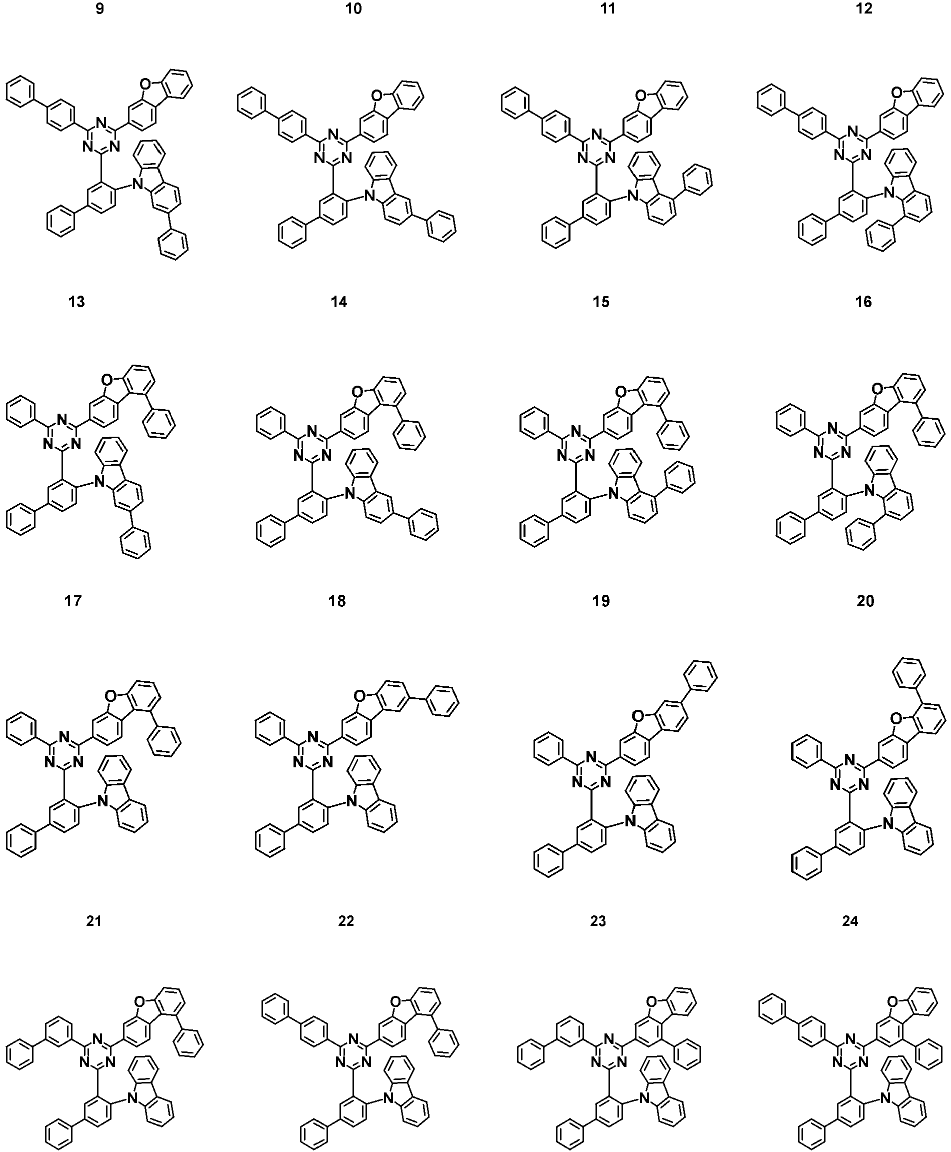 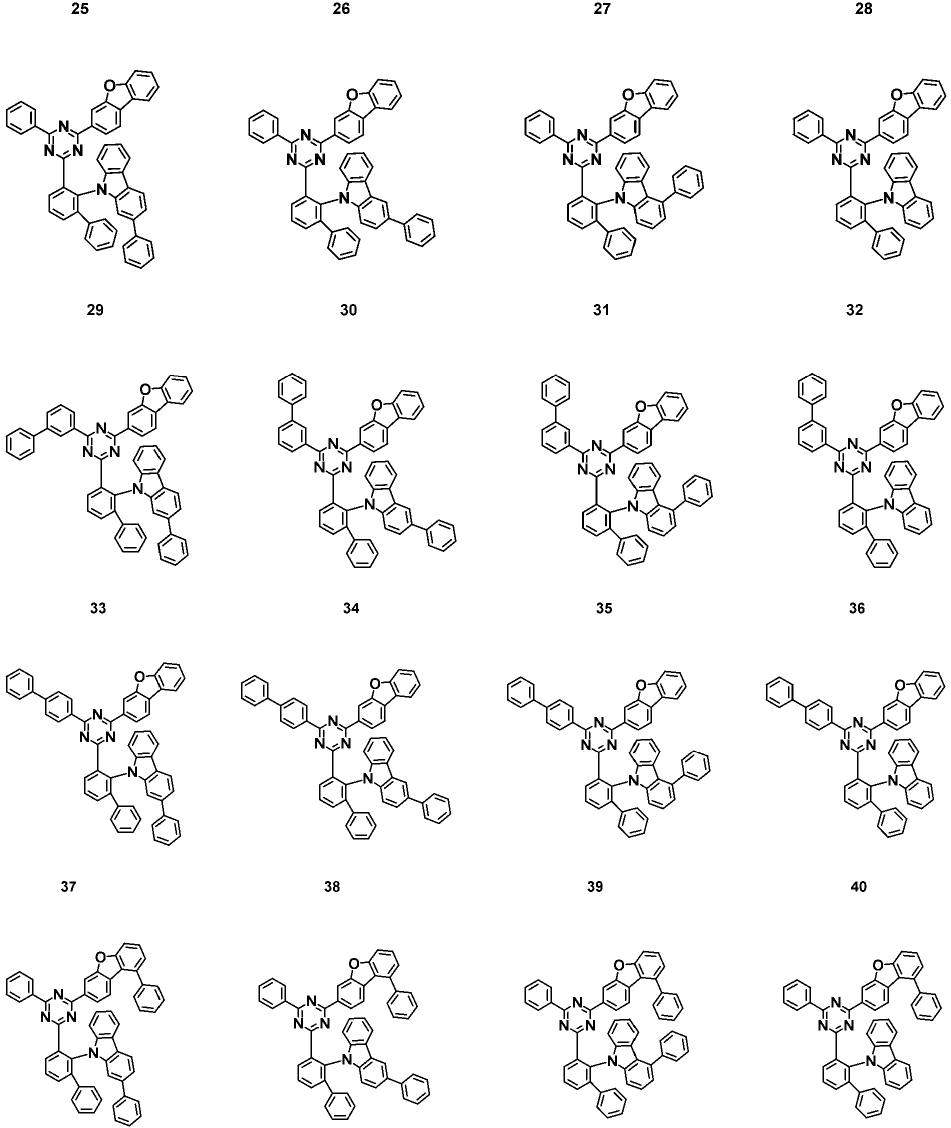 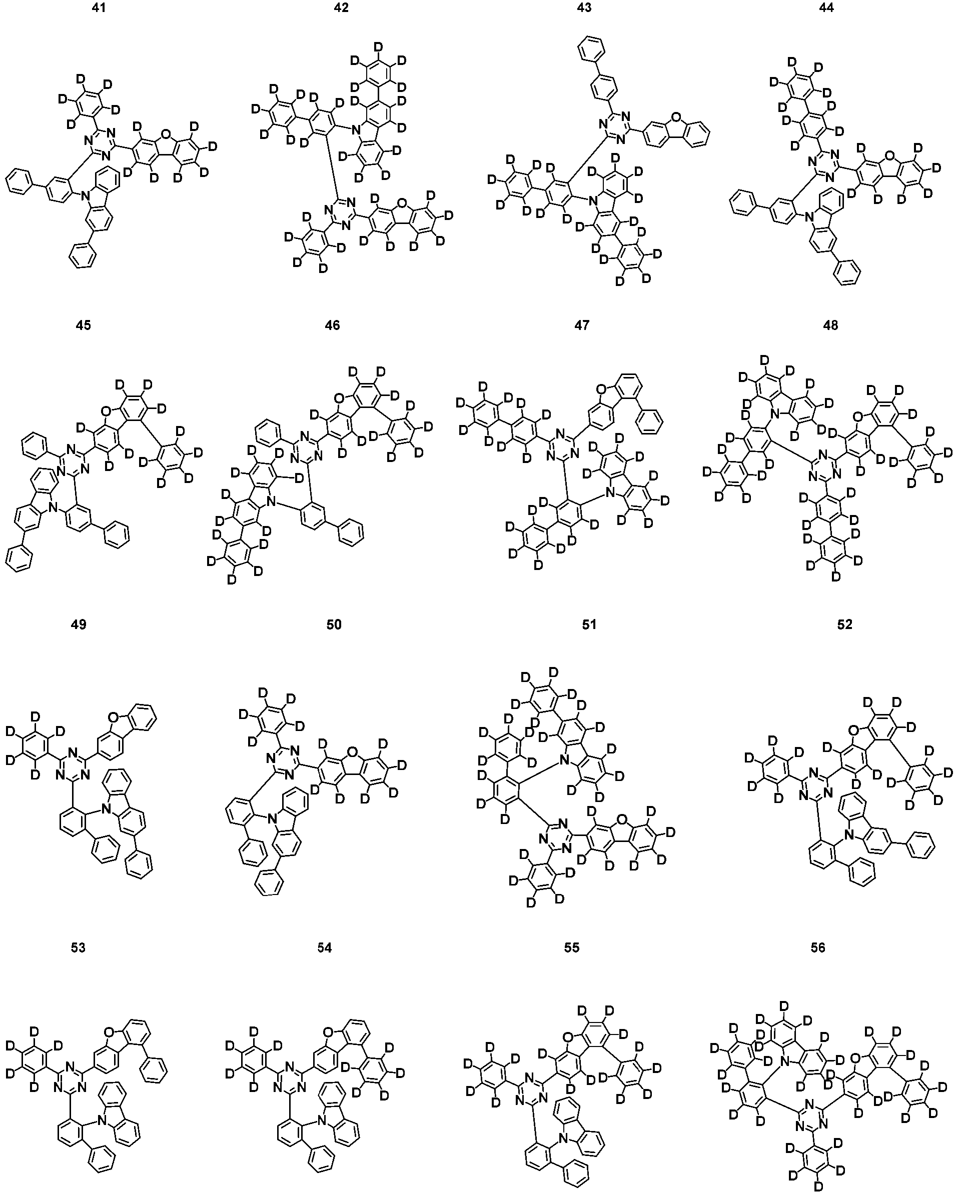 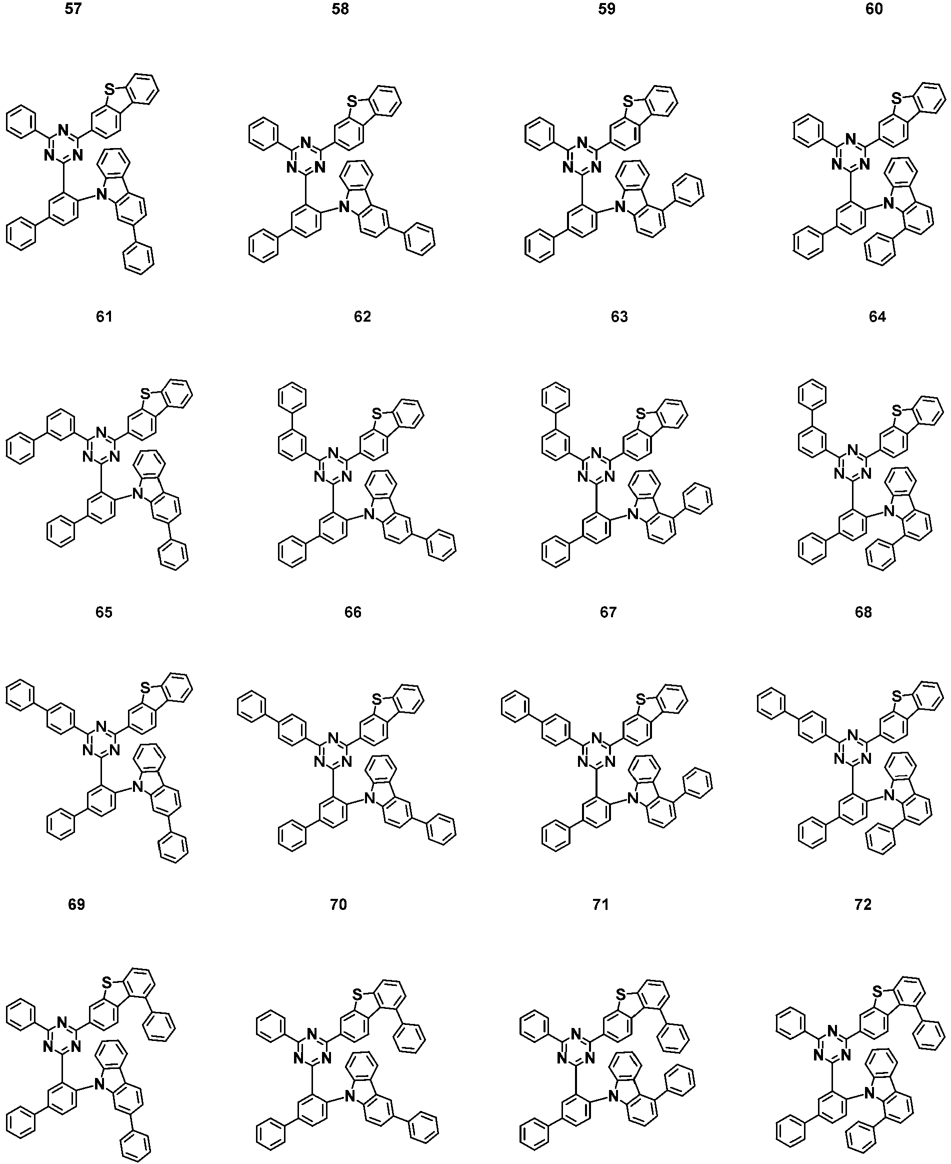 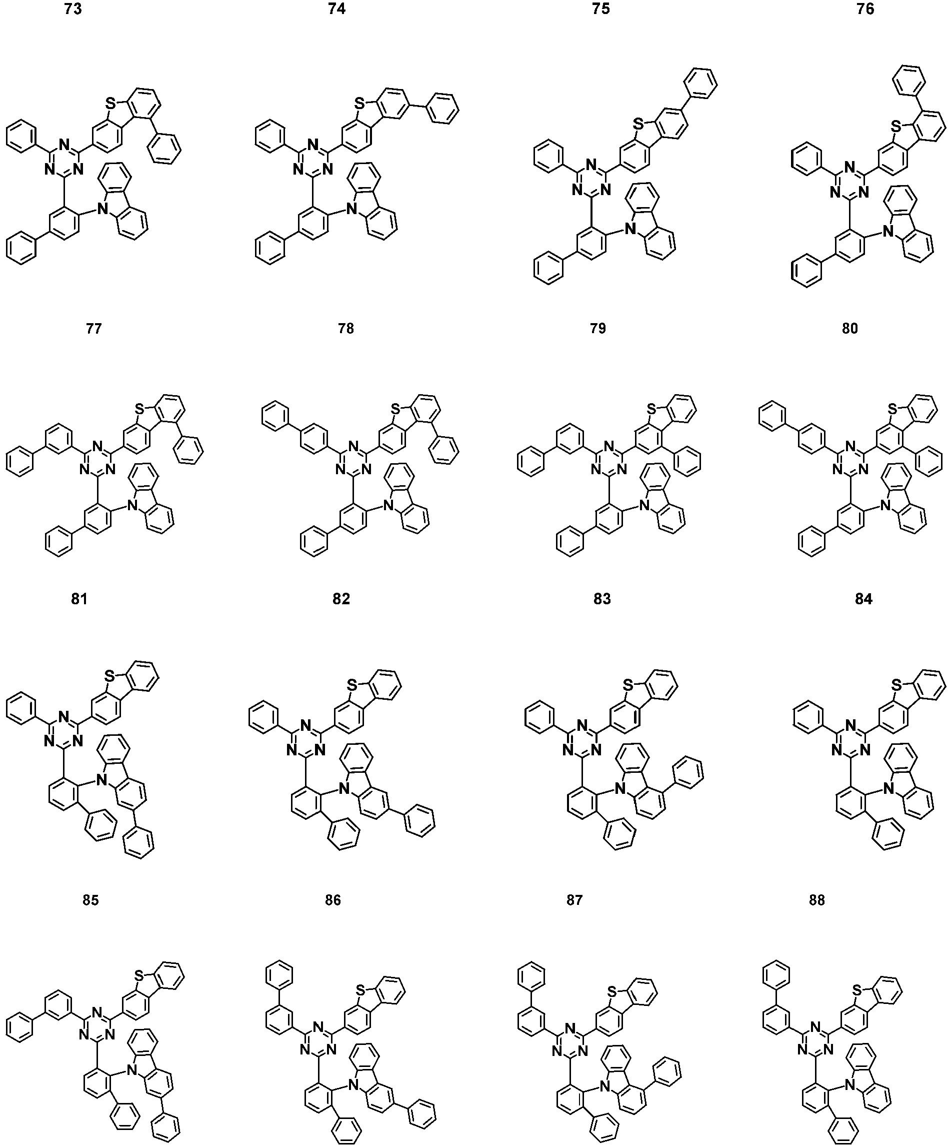 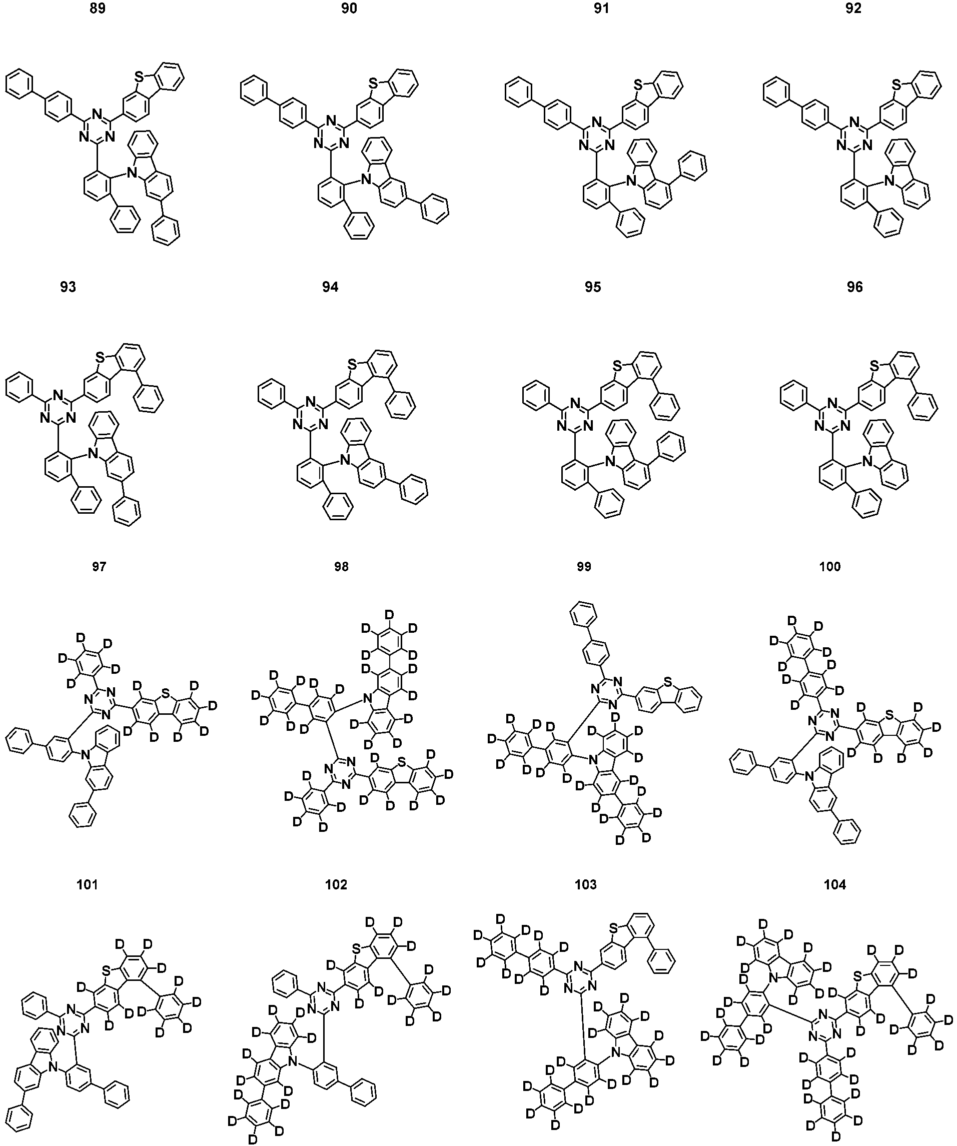 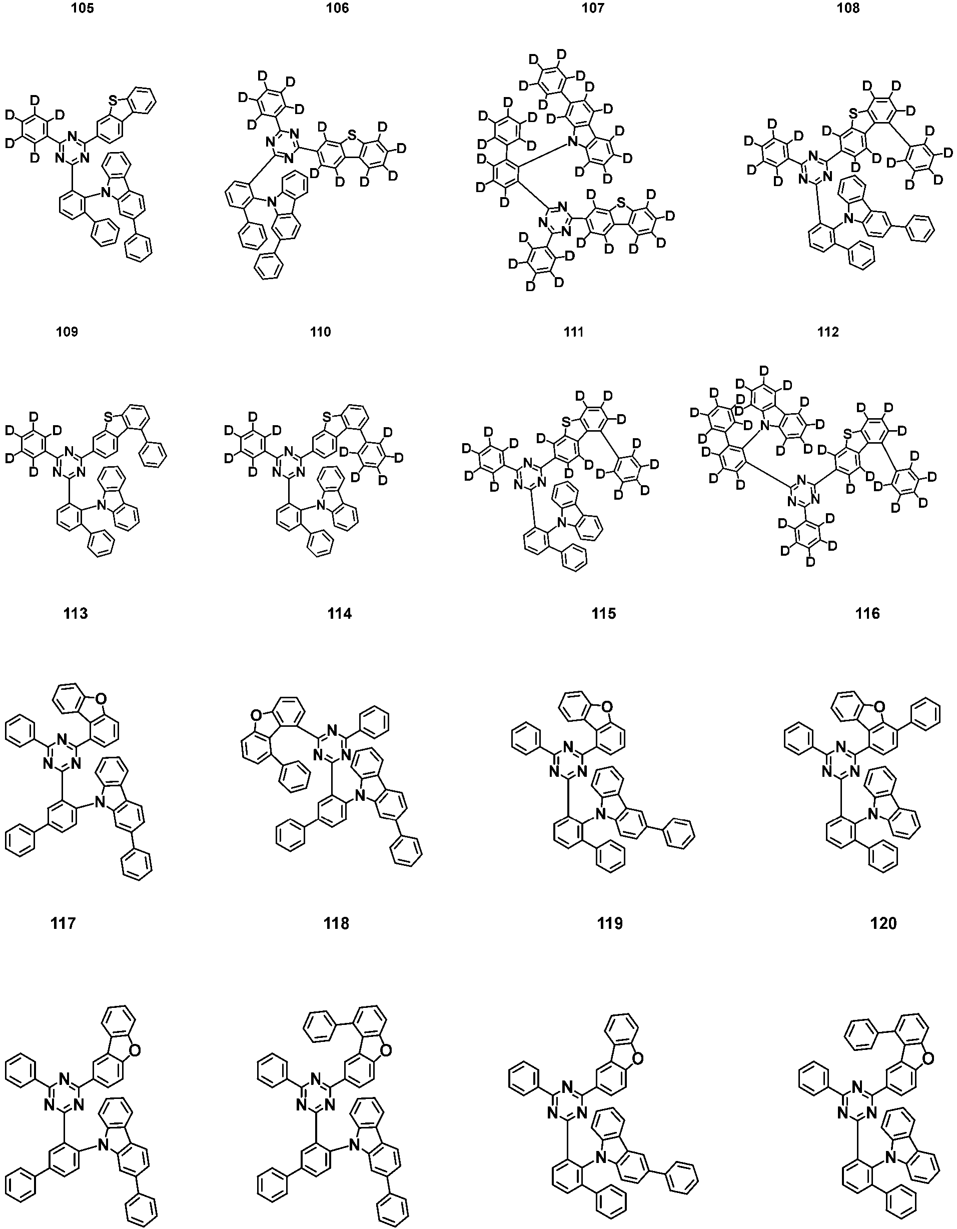 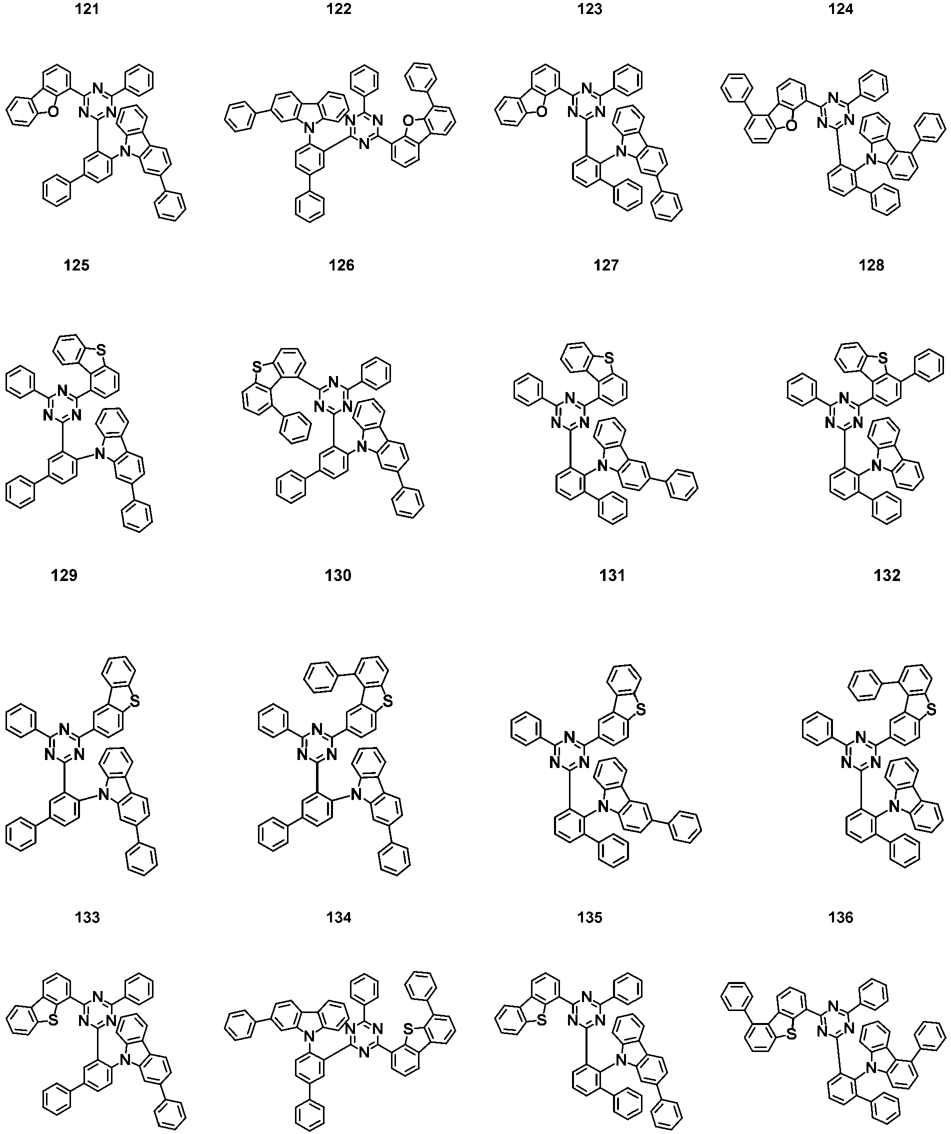 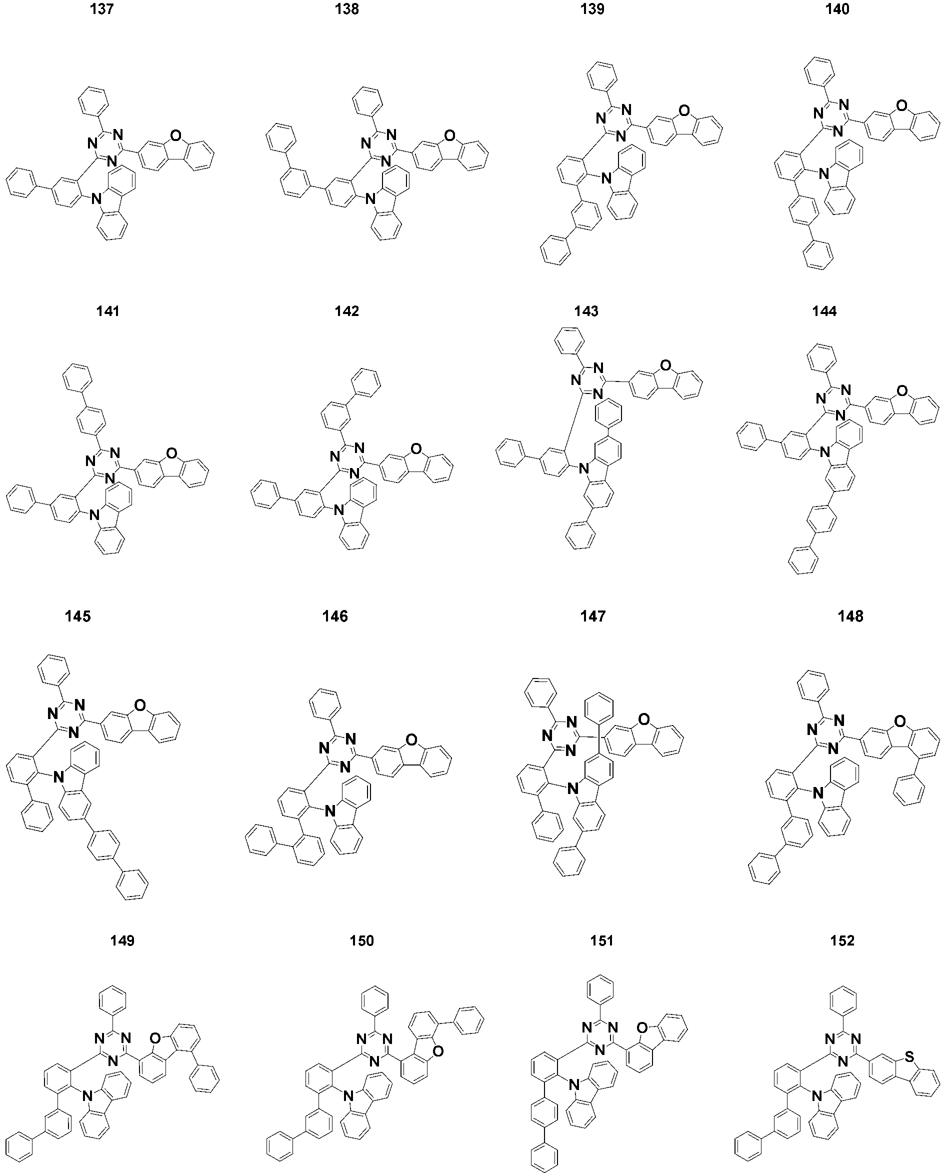 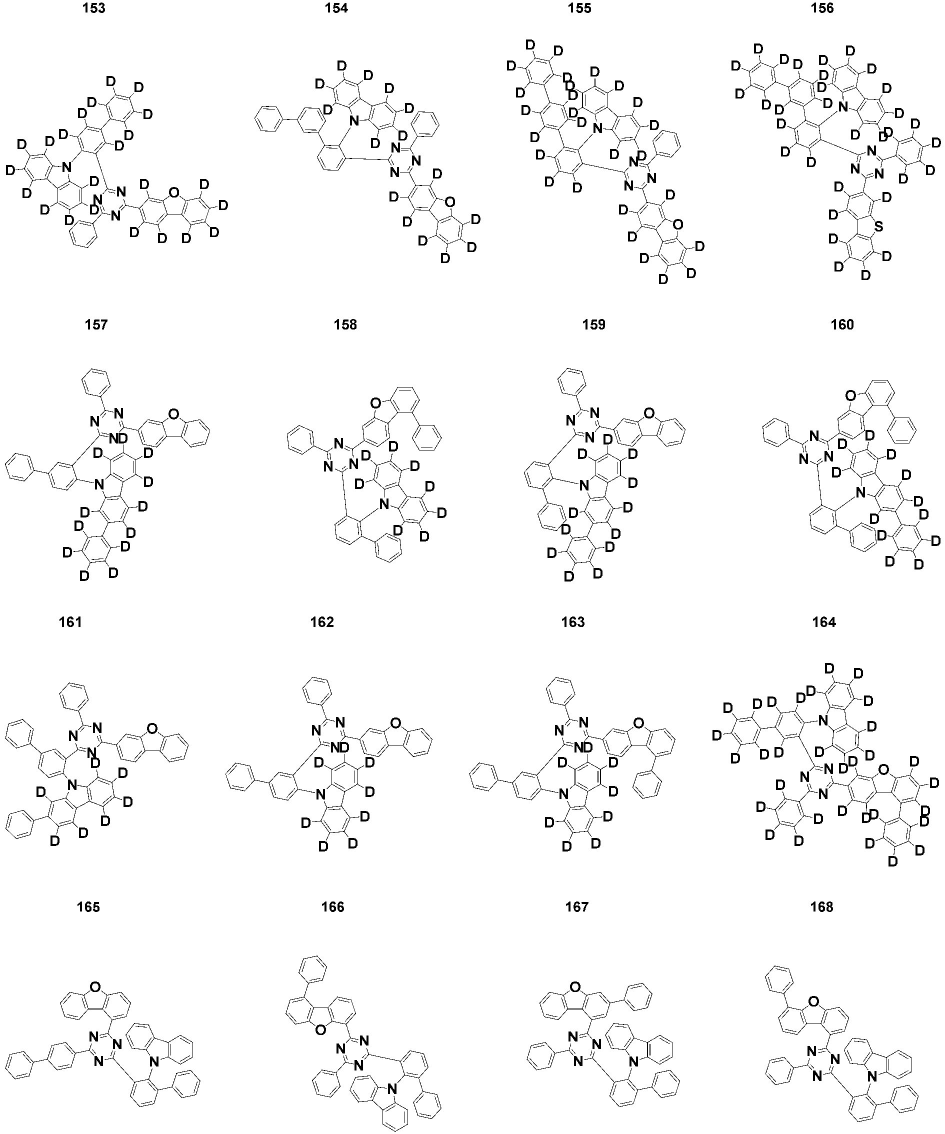 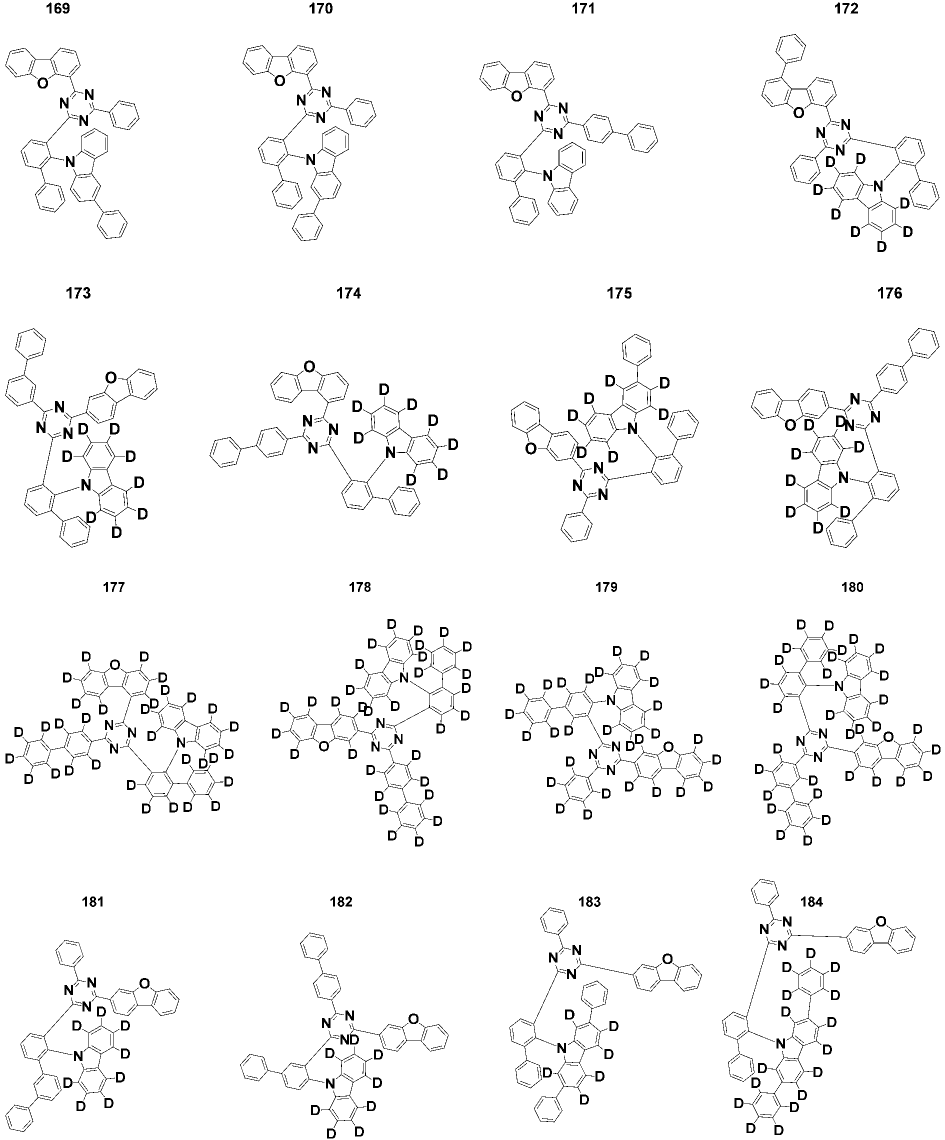 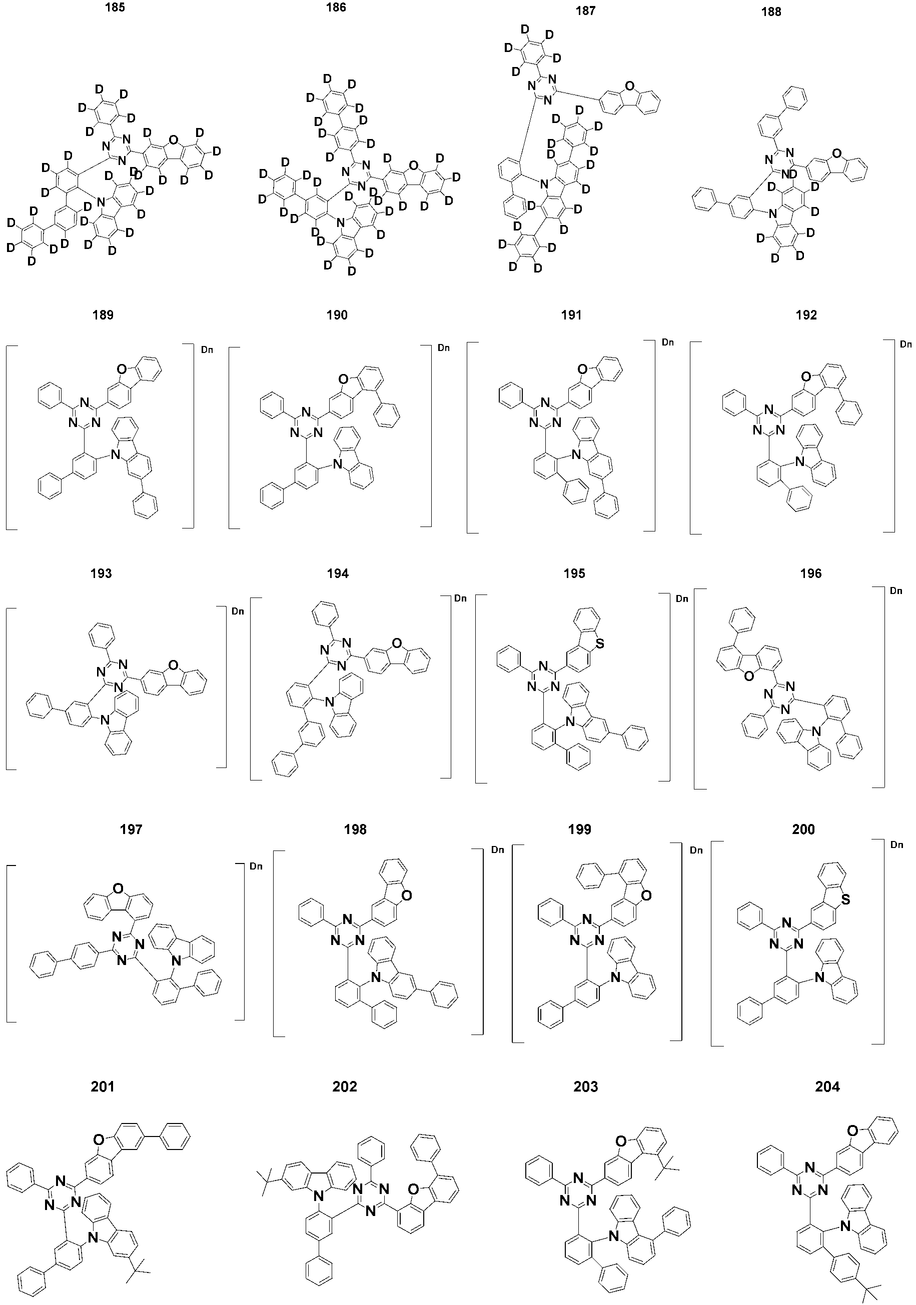 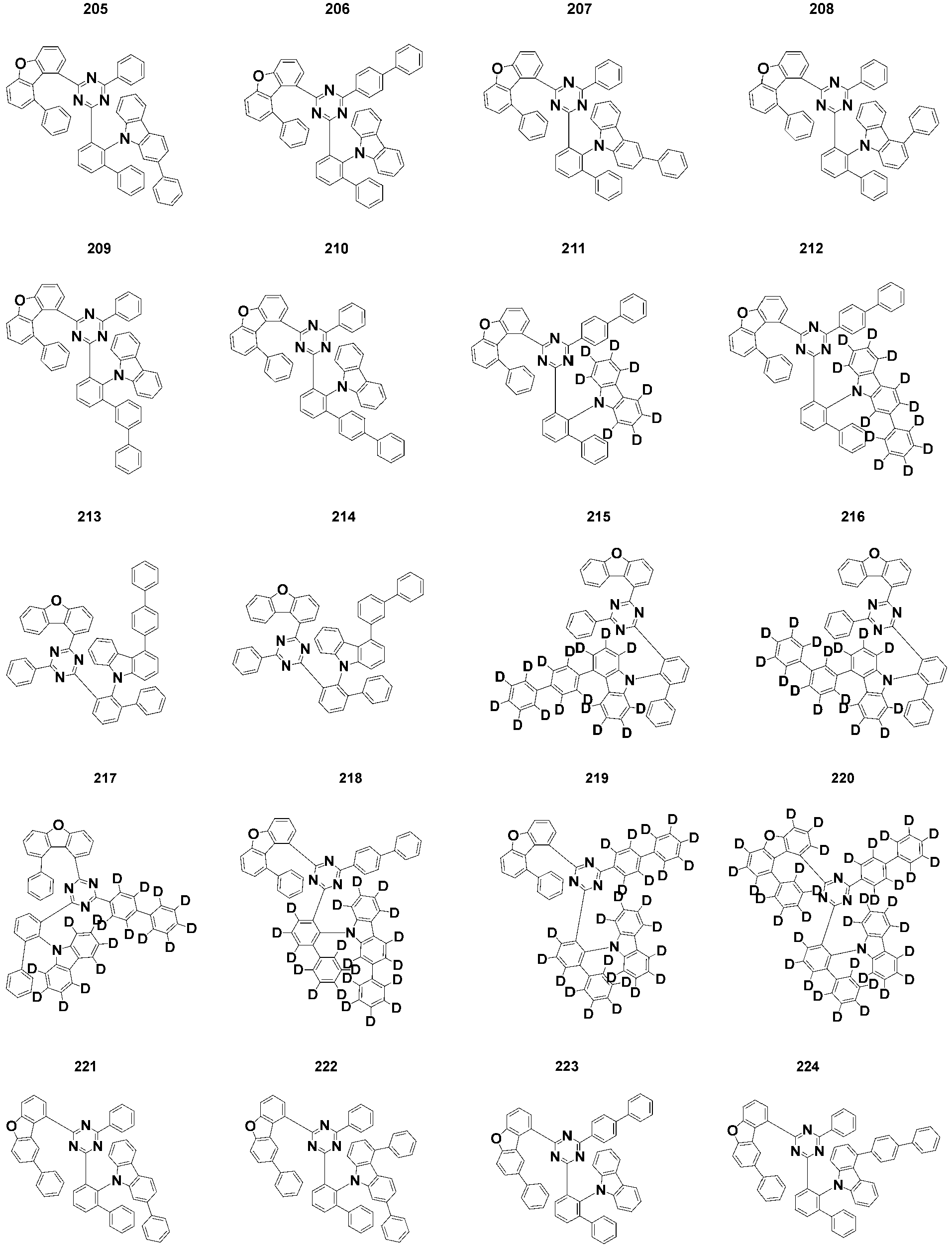 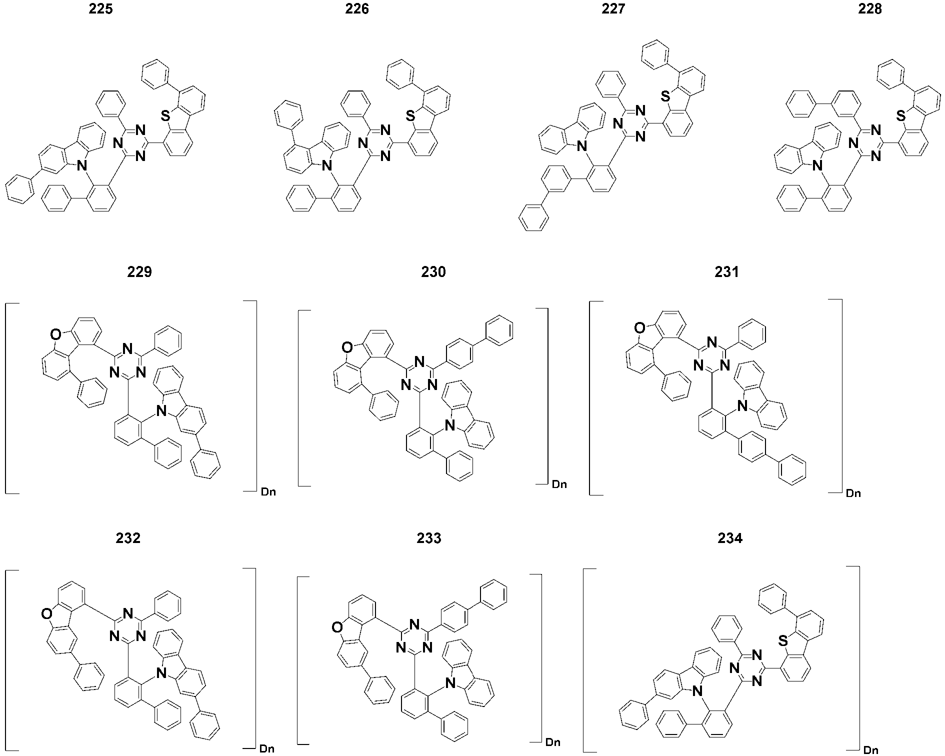 (Dn refers to the number of deuterium atoms substituted, and indicates a structure in which one or more deuterium atoms are substituted)

An organic optoelectronic device composition according to an embodiment includes a first compound and a second compound, wherein the first compound is the compound for the aforementioned organic optoelectronic device, and the second compound may be represented by Chemical Formula 2; a combination of Chemical Formula 3 and Chemical Formula 4; or Chemical Formula 5.

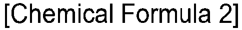

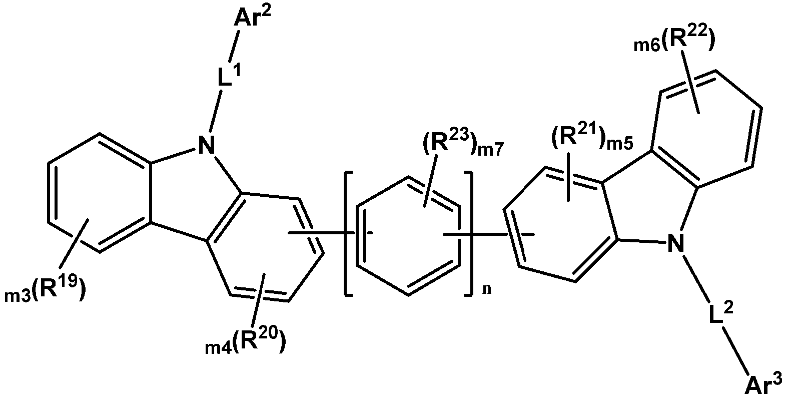

In Chemical Formula 2,
R¹⁹ to R²³ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar² and Ar³ are each independently a substituted or unsubstituted C6 to C20 aryl group or a substituted or unsubstituted C2 to C30 heterocyclic group,
L¹ and L² are each independently a single bond or a substituted or unsubstituted C6 to C20 arylene group,
m3, m6, and m7 are each independently one of integers of 1 to 4,
m4 and m5 are each independently one of integers of 1 to 3, and
n is one of integers of 0 to 2; 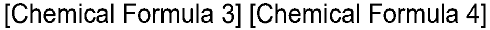 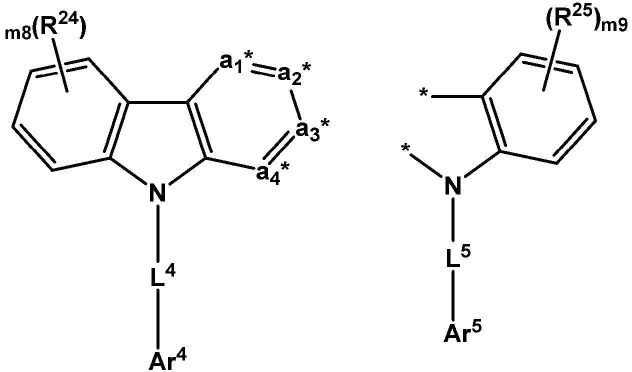
wherein, in Chemical Formula 3 and Chemical Formula 4,
a₁* to a₄* in Chemical Formula 3 are each independently a linking carbon (C) or C-L^{a}-R^{a},
among a₁* to a₄* in Chemical Formula 3, two adjacent ones are each linked to *s in Chemical Formula 4,
L^{a}, L⁴, and L⁵ are each independently a single bond or a substituted or unsubstituted C6 to C20 arylene group,
R^{a}, R²⁴, and R²⁵ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group, and
m8 and m9 are each independently one of integers of 1 to 4; 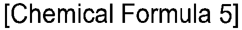 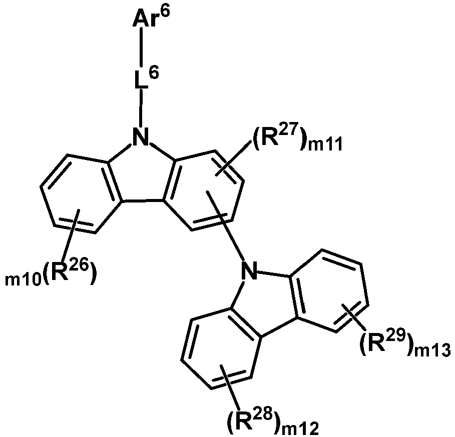
wherein, in Chemical Formula 5,
L⁶s are each independently a single bond or a substituted or unsubstituted C6 to C20 arylene group,
R²⁶ to R²⁹ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁶ is a substituted or unsubstituted C6 to C20 aryl group or a substituted or unsubstituted C2 to C30 heterocyclic group,
m10, m12, and m13 are each independently one of integers of 1 to 4, and
m11 is one of integers of 1 to 3.

The second compound may be used in a light emitting layer together with the aforementioned first compound to improve luminous efficiency and life-span characteristics by increasing charge mobility and enhancing stability.

In Chemical Formula 2, when m3 is 2 or more, each R¹⁹ may be the same or different from each other.

In Chemical Formula 2, when m4 is 2 or more, each R²⁰ may be the same or different from each other.

In Chemical Formula 2, when m5 is 2 or more, each R²¹ may be the same or different from each other.

In Chemical Formula 2, when m6 is 2 or more, each R²² may be the same or different from each other.

In Chemical Formula 2 m7 is 2 or more, each R²³ may be the same or different from each other.

In Chemical Formula 3 and Chemical Formula 4, when m8 is 2 or more, each R²⁴ may be the same or different from each other.

In Chemical Formula 3 and Chemical Formula 4, when m9 is 2 or more, each R²⁵ may be the same or different from each other.

In Chemical Formula 3 and Chemical Formula 4, when R^{a} is 2 or more, each R^{a} may be the same or different from each other.

In Chemical Formula 5, when m10 is 2 or more, each R²⁶ may be the same or different from each other.

In Chemical Formula 5, when m11 is 2 or more, each R²⁷ may be the same or different from each other.

In Chemical Formula 5, when m12 is 2 or more, each R²⁸ may be the same or different from each other.

In Chemical Formula 5, when m13 is 2 or more, each R²⁹ may be the same or different from each other.

For example, in Chemical Formula 2, Ar² and Ar³ may each independently b a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted triphenylenyl group, a substituted or unsubstituted carbazolyl group, a substituted or unsubstituted dibenzothiophenyl group, a substituted or unsubstituted dibenzofuranyl group, or a substituted or unsubstituted fluorenyl group,
in Chemical Formula 2, L² and L³ may each independently be a single bond, a substituted or unsubstituted phenylene group, or a substituted or unsubstituted biphenylene group,
in Chemical Formula 2, R¹⁹ to R²³ may each independently be hydrogen, deuterium, or a substituted or unsubstituted C6 to C12 aryl group,
n may be 0 or 1.

For example, in Chemical Formula 2, "substituted" means that at least one hydrogen is substituted with deuterium, a C1 to C4 alkyl group, a C6 to C18 aryl group, or a C2 to C30 heteroaryl group.

For example, in Chemical Formula 2, Ar² and Ar³ may each independently, be a substituted or unsubstituted carbazolyl group, a substituted or unsubstituted dibenzothiophenyl group, a substituted or unsubstituted dibenzofuranyl group, or a substituted or unsubstituted fluorenyl group.

In a specific embodiment of the present invention, Chemical Formula 2 may be represented by one of Chemical Formula 2-1 to Chemical Formula 2-15.

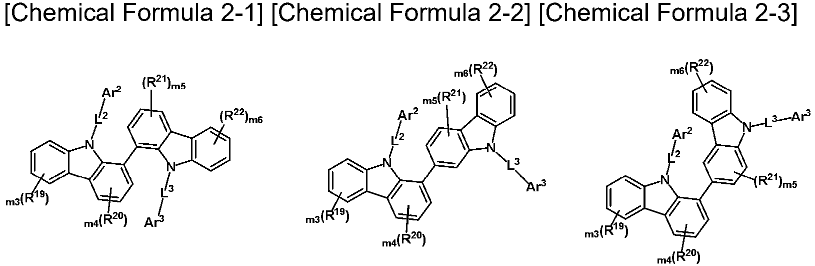

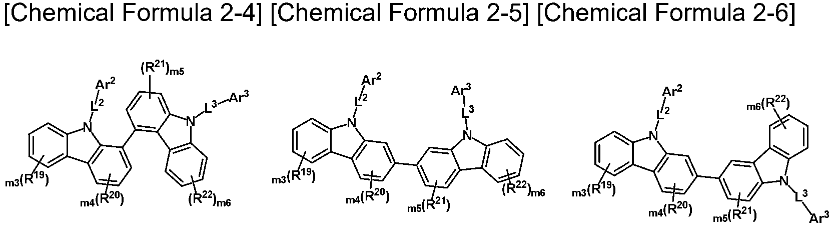

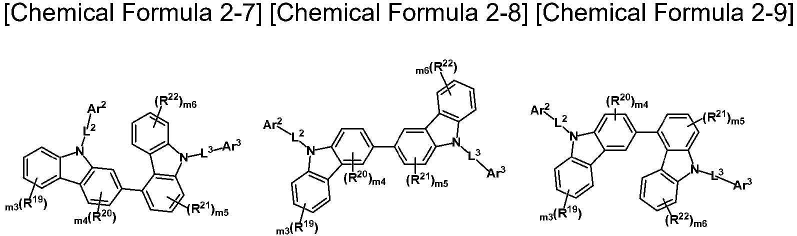

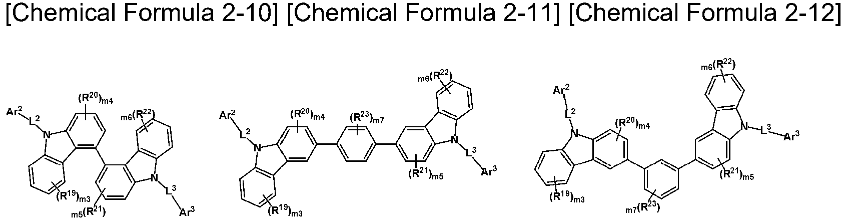

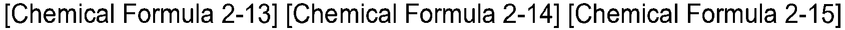

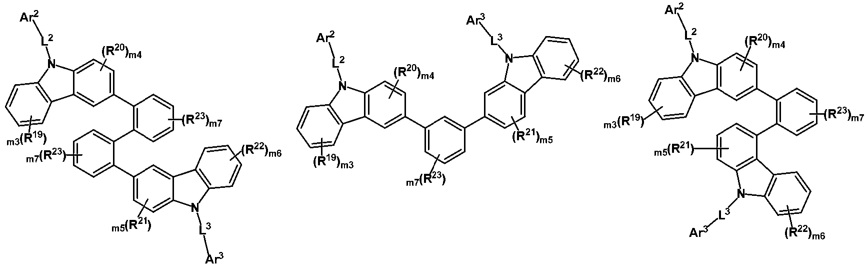

In Chemical Formula 2-1 to Chemical Formula 2-15, R¹⁹ to R²³ may each independently be hydrogen, deuterium, or a substituted or unsubstituted C6 to C12 aryl group, and L²-Ar² and L³-Ar³ may each independently be one of substituents listed in Group I.

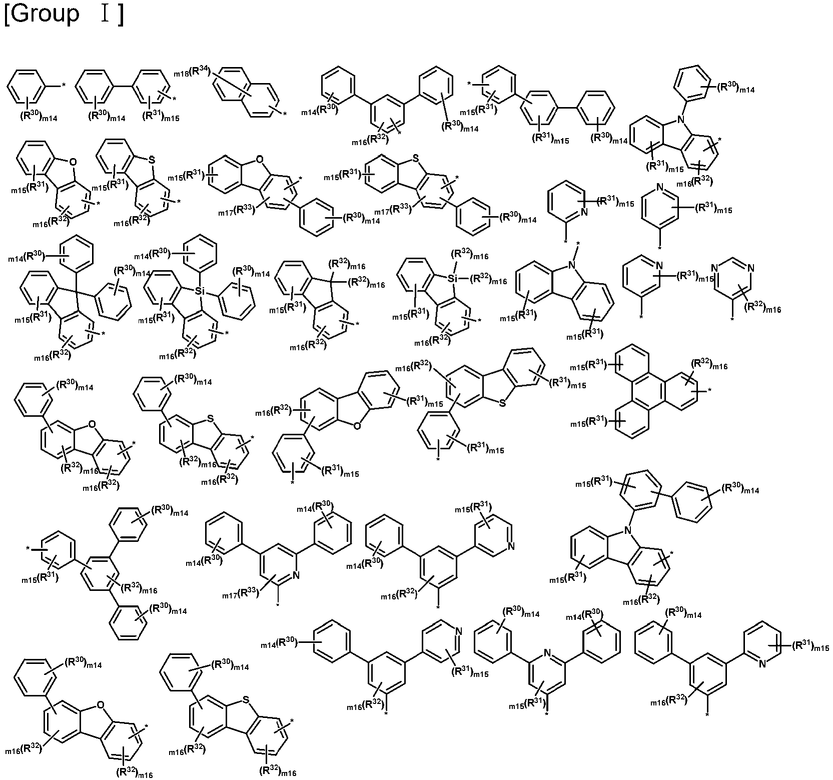

In Group I ,
R³⁰ to R³⁴ are each independently hydrogen, deuterium, a cyano group, a C1 to C10 alkyl group, or a C6 to C12 aryl group,
m14 is one of integers of 1 to 5,
m15 is one of integers of 1 to 4,
m16 is one of integers of 1 to 3,
m17 is an integer of 1 or 2,
m18 is one of integers of 1 to 7, and
* is a linking point.

In Group I, when m14 is 2 or more, each R²⁶ may be the same or different from each other.

In Group I, when m15 is 2 or more, each R²⁷ may be the same or different from each other.

In Group I, when m16 is 2 or more, each R²⁸ may be the same or different from each other.

In Group I, when m17 is 2 or more, each R²⁹ may be the same or different from each other.

In Group I, when m18 is 2 or more, each R³⁰ may be the same or different from each other.

The combination of Chemical Formula 3 and Chemical Formula 4 may be for example, represented by any one of Chemical Formula 3A, Chemical Formula 3B, Chemical Formula 3C, Chemical Formula 3D, and Chemical Formula 3E.

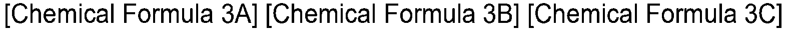

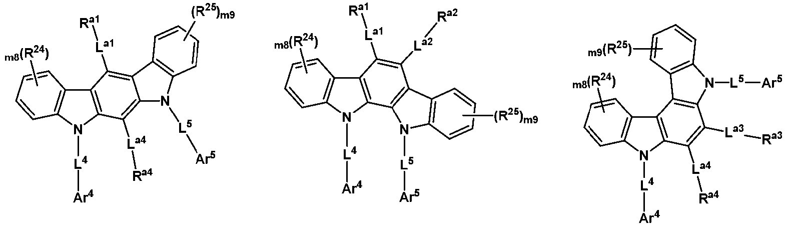

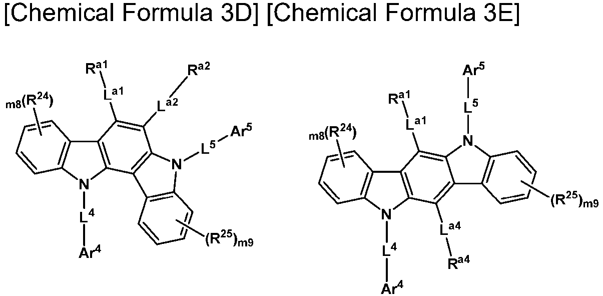

In Chemical Formula 3A to Chemical Formula 3E, L⁴, L⁵, Ar⁴, Ar⁵, R²⁴, and R²⁵ are the same as described above,
L^{a1} to L^{a4} are defined as L⁴ and L⁵ described above, and
R^{a1} to R^{a4} are defined as R²⁴ and R²⁵ described above.

For example, in Chemical Formulas 3 and 4, Ar⁴ and Ar⁵ may each independently be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted triphenylenyl group, a substituted or unsubstituted carbazolyl group, a substituted or unsubstituted dibenzothiophenyl group, a substituted or unsubstituted dibenzofuranyl group, or a substituted or unsubstituted fluorenyl group, and
R^{a1} to R^{a4}, R²⁴, and R²⁵ may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

In another specific embodiment of the present invention, in Chemical Formulas 3 and 4, L⁴-Ar⁴ and L⁵-Ar⁵ may each independently be one of the substituents listed in Group I .

In an embodiment, R^{a1} to R^{a4}, R²⁴, and R²⁵ may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

For example, R^{a1} to R^{a4}, R²⁴, and R²⁵ may each independently be hydrogen, deuterium, a cyano group, or a substituted or unsubstituted phenyl group, and
in a specific embodiment, R^{a1} to R^{a4}, R²⁴, and R²⁵ may each independently be hydrogen, deuterium, or a substituted or unsubstituted phenyl group.

In another specific embodiment of the present invention, the second compound may be represented by Chemical Formula 2-8, and in Chemical Formula 2-8, Ar² and Ar³ may each independently be a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group, L² and L³ may each independently be a single bond, or a substituted or unsubstituted C6 to C20 arylene group, and R¹⁹ to R²² may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

For example, in Chemical Formula 2-8, R¹⁹ to R²² may each independently be hydrogen, deuterium or a substituted or unsubstituted C6 to C12 aryl group, and L²-Ar² and L³-Ar³ may each independently be one of the substituents listed in Group I.

In another specific embodiment of the present invention, the second compound may be represented by Chemical Formula 3C, and in Chemical Formula 3C, L^{a3} and L^{a4} may be a single bond, L⁴ and L ⁵ may each independently be a single bond or a substituted or unsubstituted C6 to C12 arylene group, R²⁴, R²⁵, R^{a3}, and R^{a4} may each be hydrogen, deuterium or phenyl group, and Ar² and Ar³ may each independently be a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

For example, in Chemical Formula 3C, L^{a3} and L^{a4} may be a single bond, R²⁴, R²⁵, R^{a3}, and R^{a4} may each independently be hydrogen, deuterium, or a C6 to C12 aryl group, and L⁴-Ar⁴ and L⁵-Ar⁵ may each independently be one of the substituents listed in Group I .

The Chemical Formula 5 may be, for example, represented by any one of Chemical Formula 5-1 to Chemical Formula 5-4.

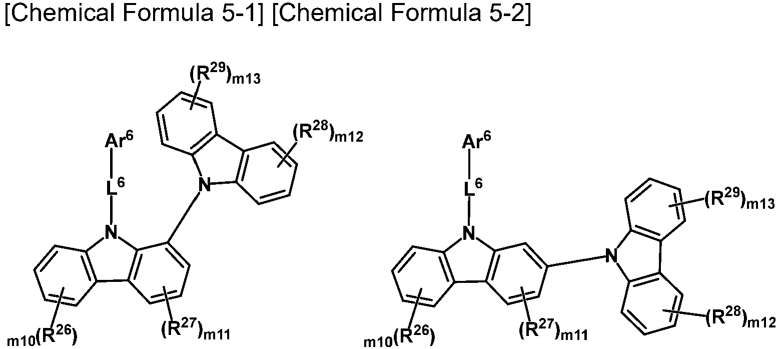

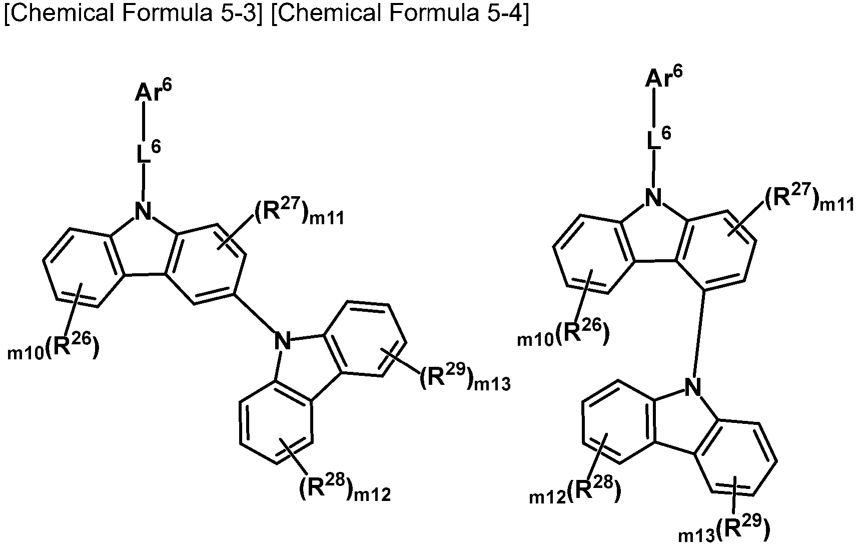

In Chemical Formula 5-1 to Chemical Formula 5-4, L⁶, Ar⁶, and R²⁶ to R²⁹ are the same as described above.

For example, in Chemical Formula 5, Ar⁶ may be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted triphenylenyl group, a substituted or unsubstituted carbazolyl group, a substituted or unsubstituted dibenzothiophenyl group, a substituted or unsubstituted dibenzofuranyl group, or a substituted or unsubstituted fluorenyl group, and

R²⁶ to R²⁹ may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

In another specific embodiment of the present invention, in Chemical Formula 5, L⁶-Ar⁶ may be selected from the substituents listed in Group I .

For example, R²⁶ to R²⁹ may each independently be hydrogen, deuterium, a cyano group, or a substituted or unsubstituted phenyl group.

For example, the compound for the second organic optoelectronic device may be one selected from the compounds listed in Group 2, but is not limited thereto.

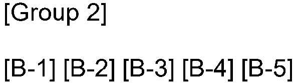

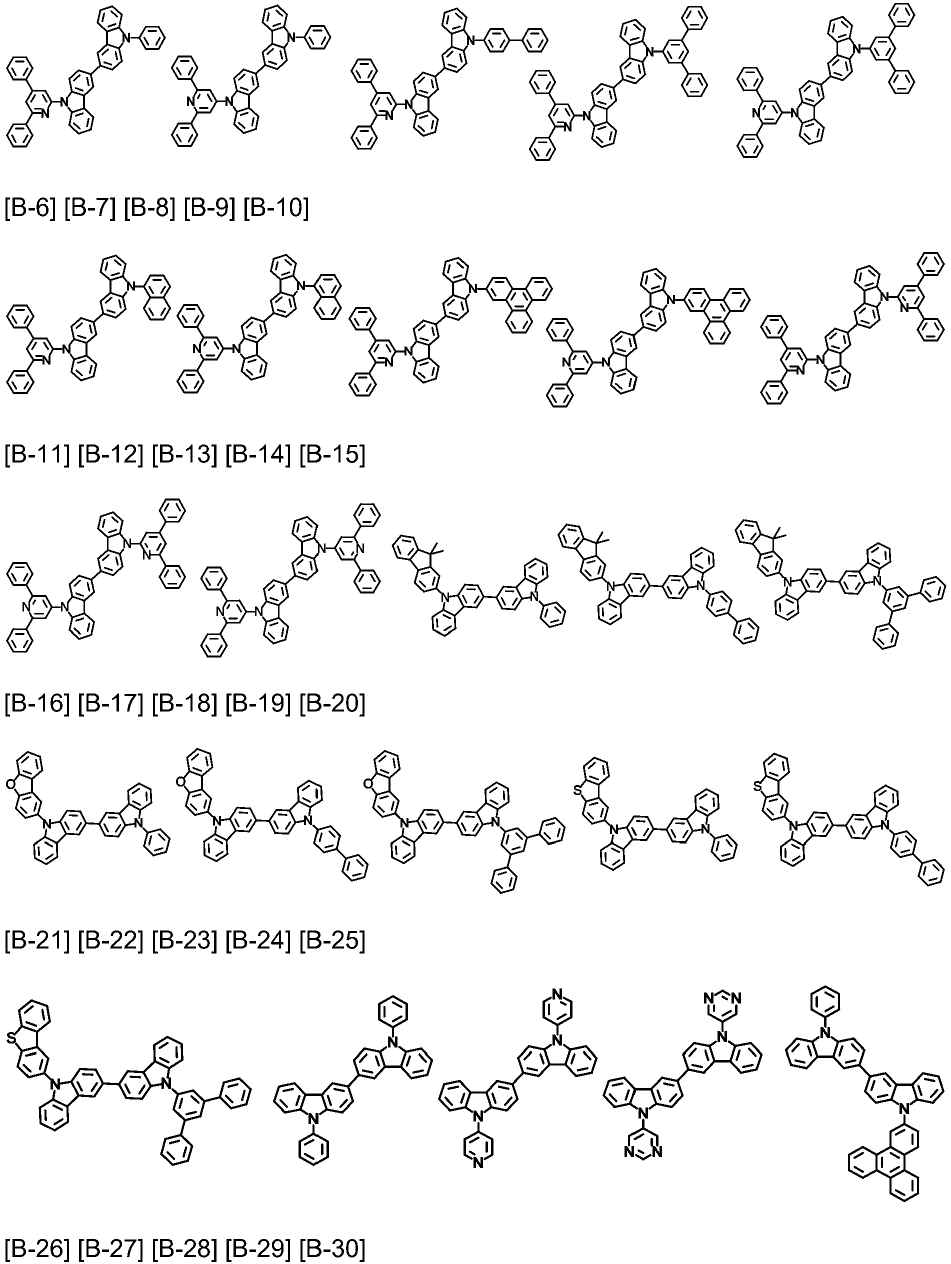

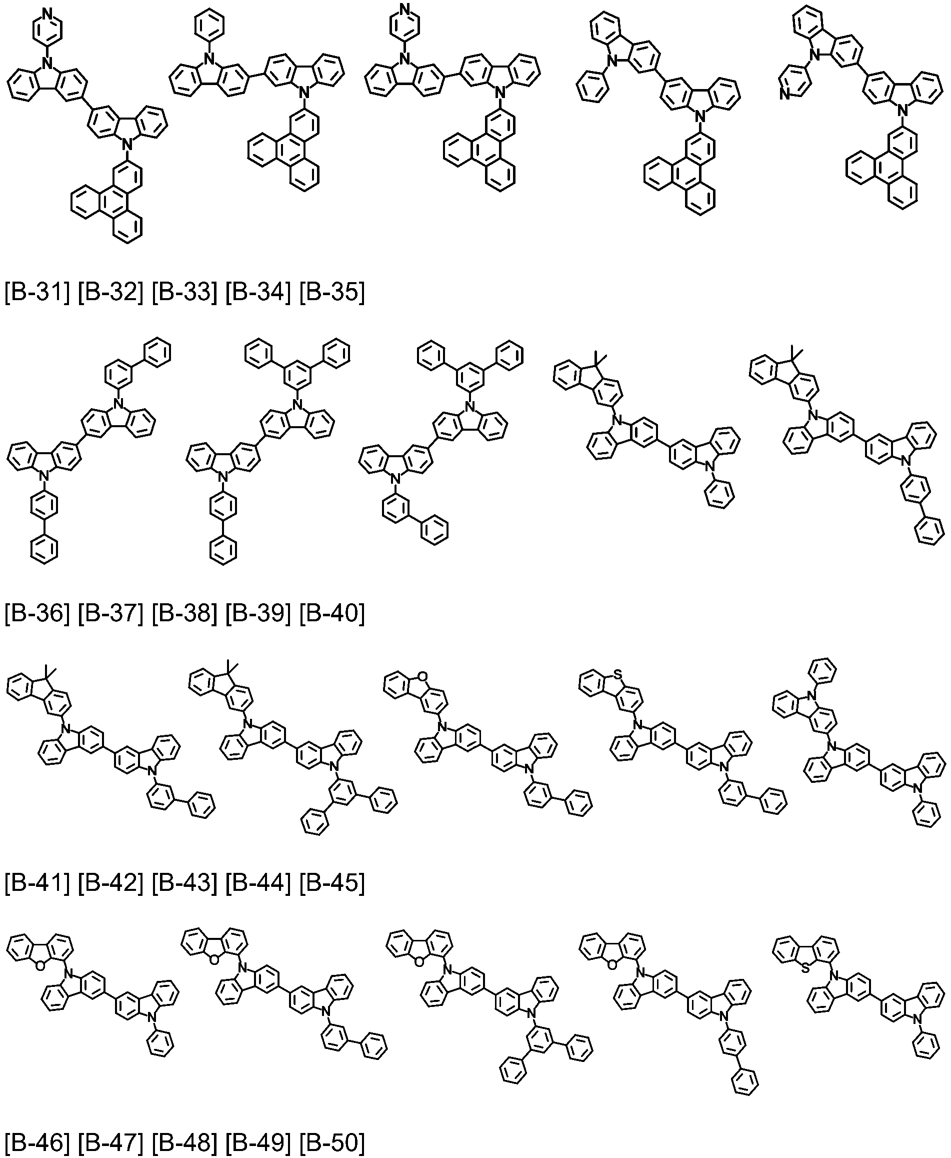

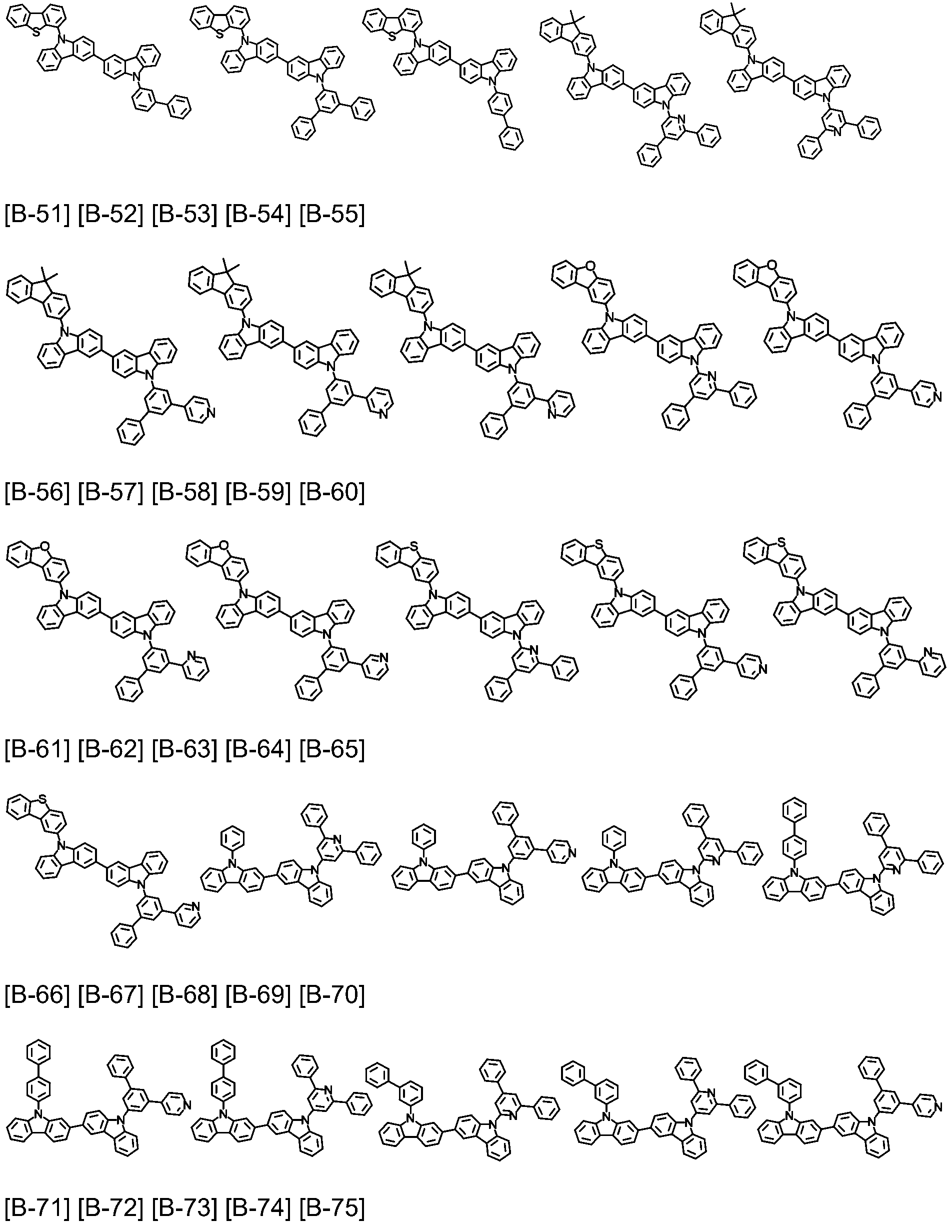

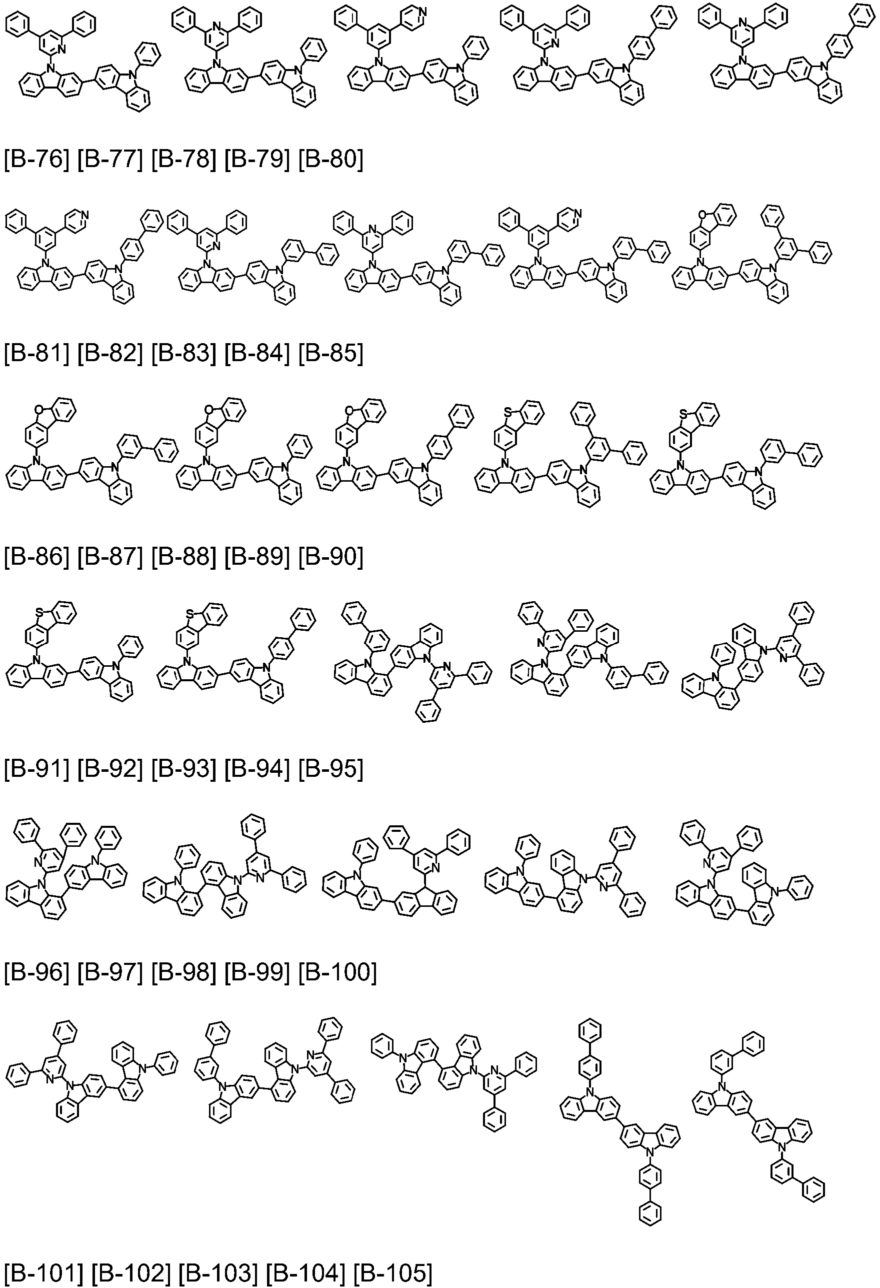

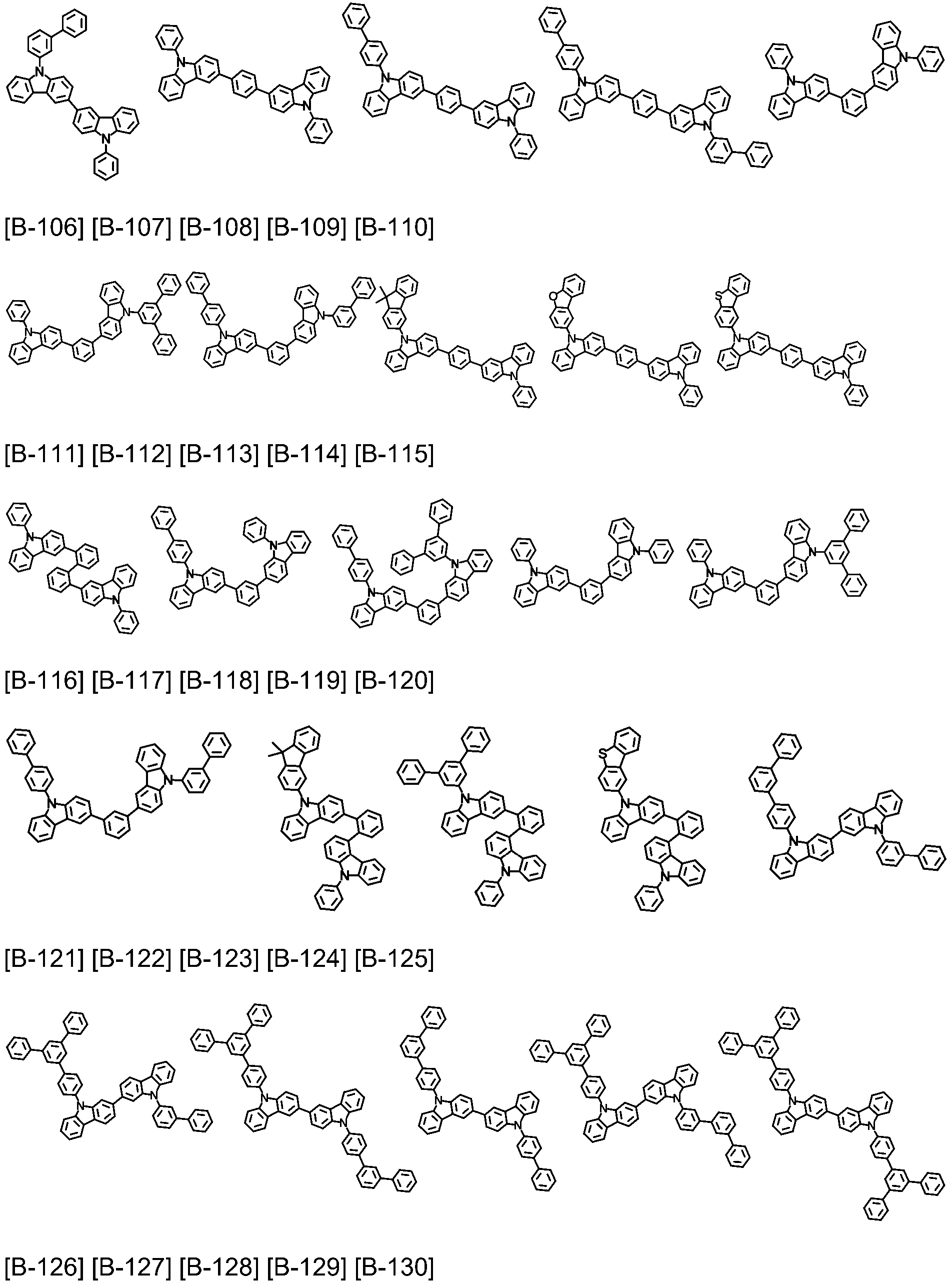

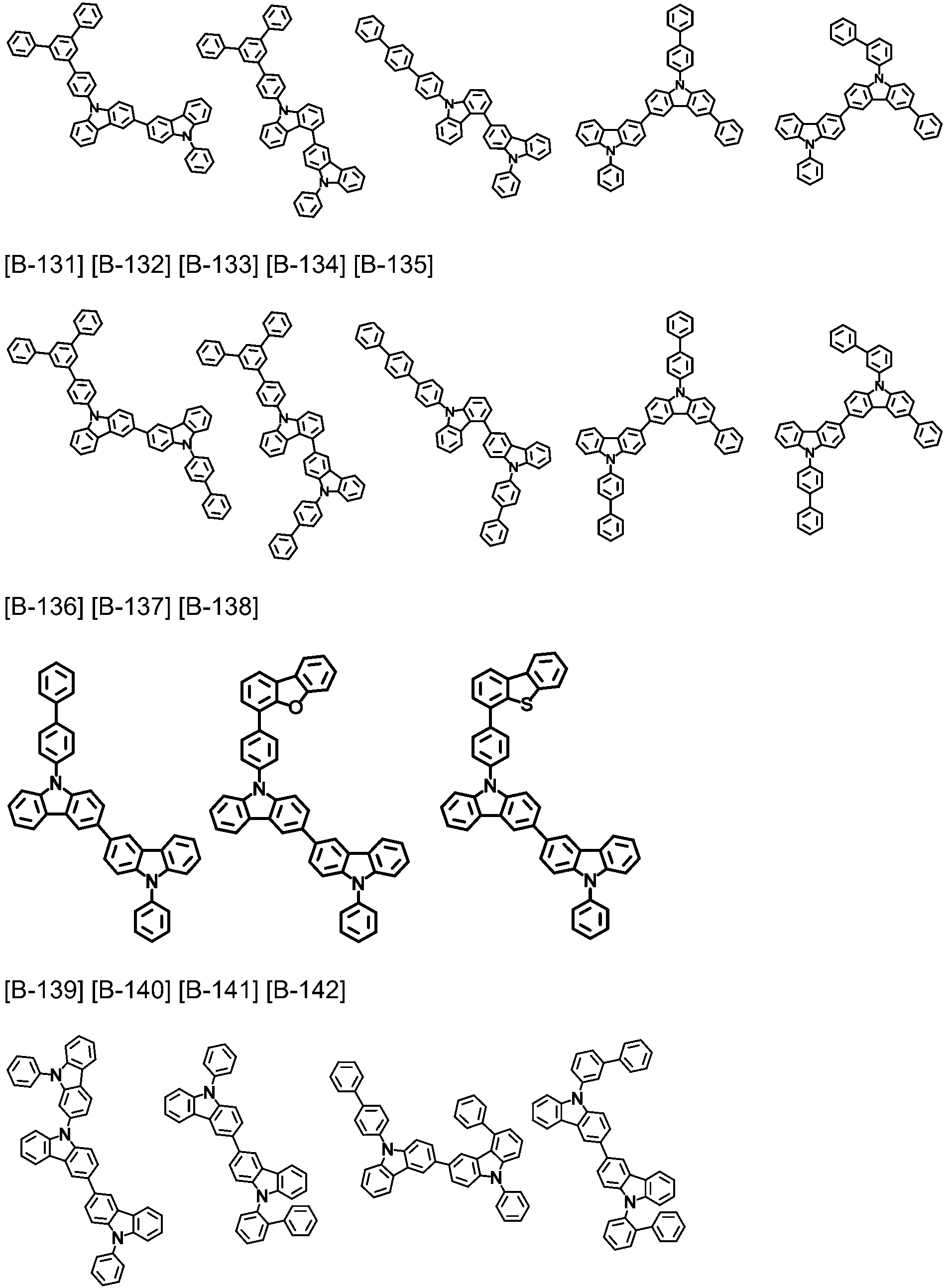

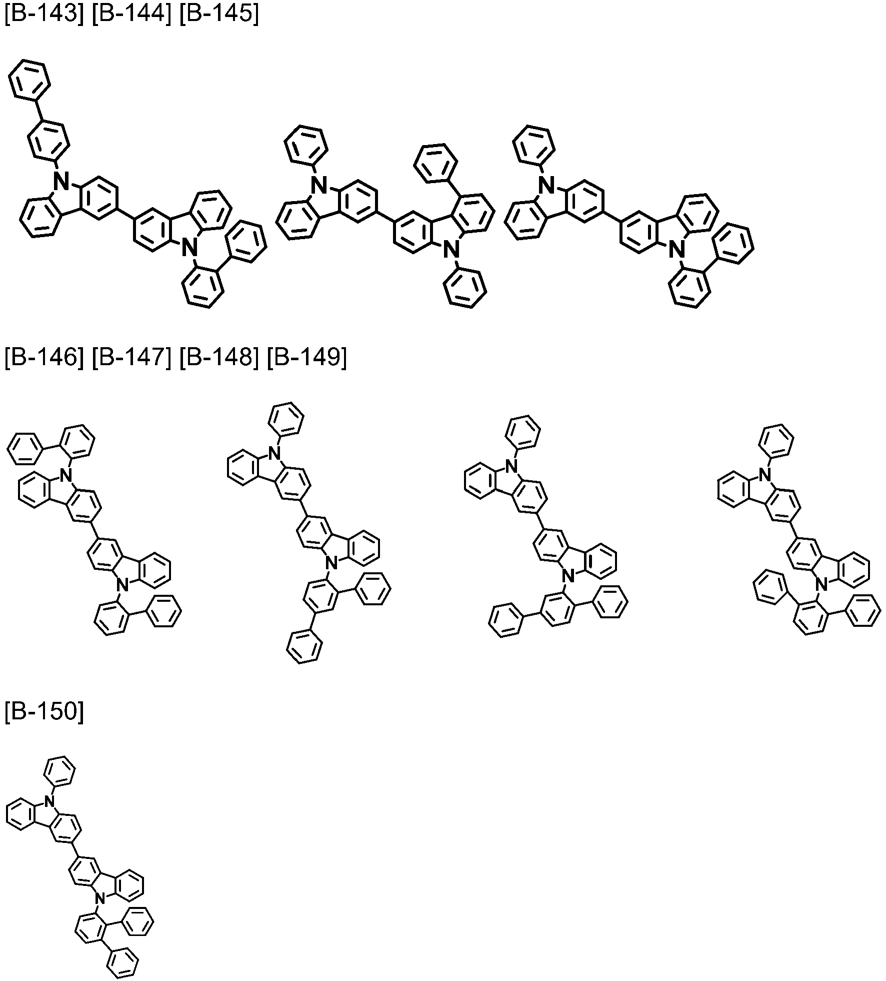

Additionally, examples of Compound B-1 to Compound B-150 listed in Group 2 in which at least one hydrogen is replaced with deuterium are shown below, but the present invention is not limited thereto. 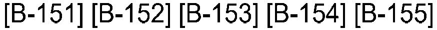 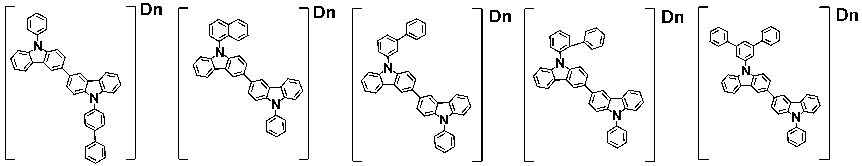 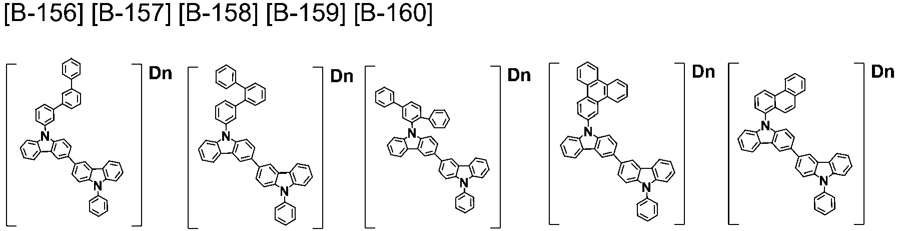 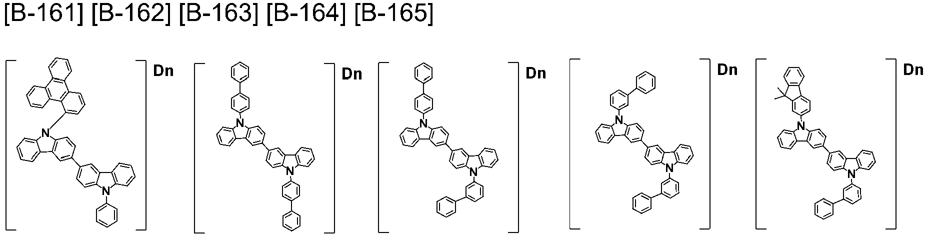 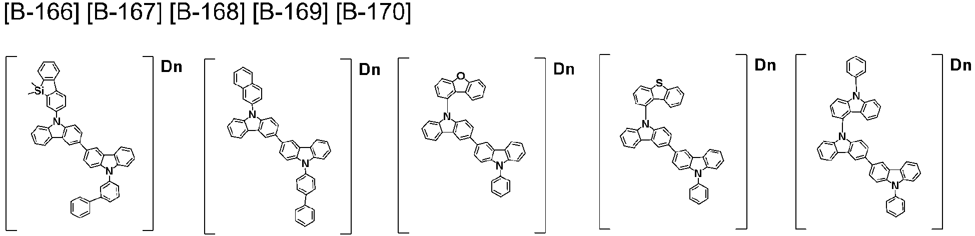 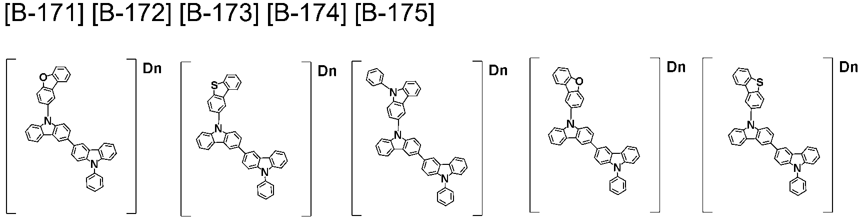 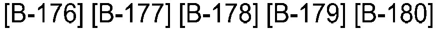 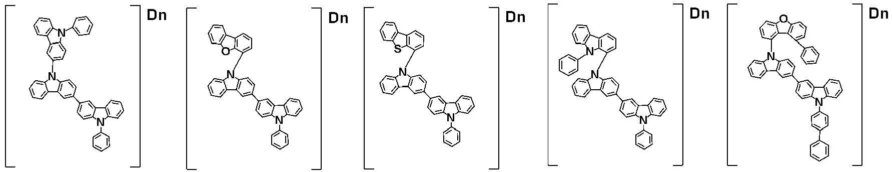 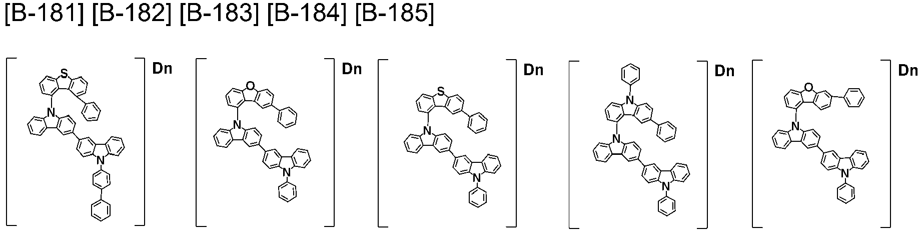 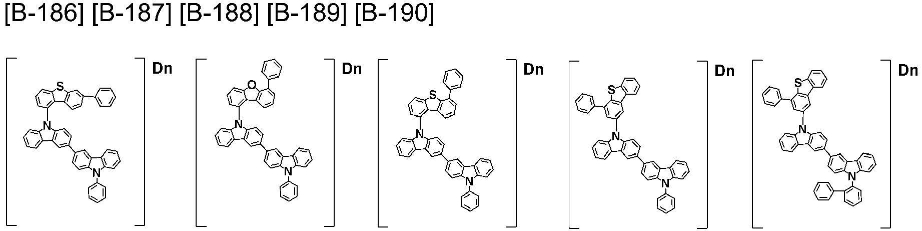 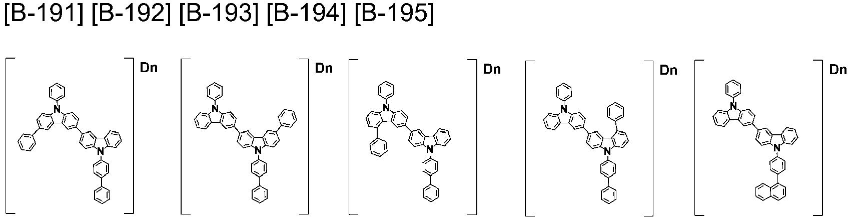 (Dn refers to the number of deuterium atoms substituted, and indicates a structure in which one or more deuterium atoms are substituted)

The most specific structures for Compound B-151 to Compound B-195 of Group 2 are presented below as examples according to the position and substitution degree of deuterium substitution, which is not to limit the scope of rights to compounds not shown below.

The scope of the present invention is determined by the claims, and when deuterium is substituted, it is not limited to the compounds exemplified below, and the position of deuterium substitution and the substitution degree of deuterium substitution may include all changeable ranges within the range of Compound B-1 to Compound B-195.

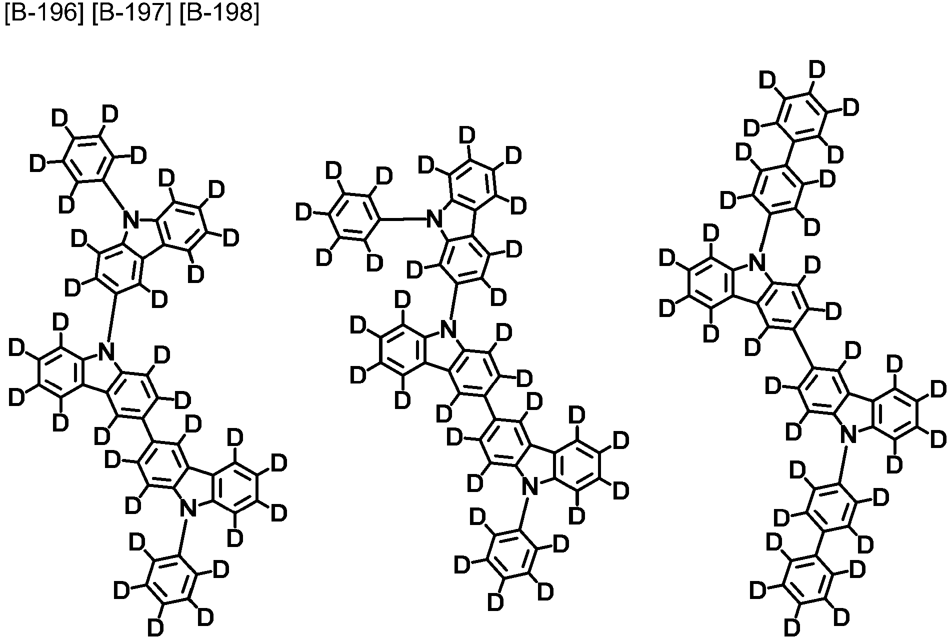

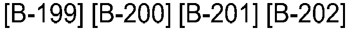

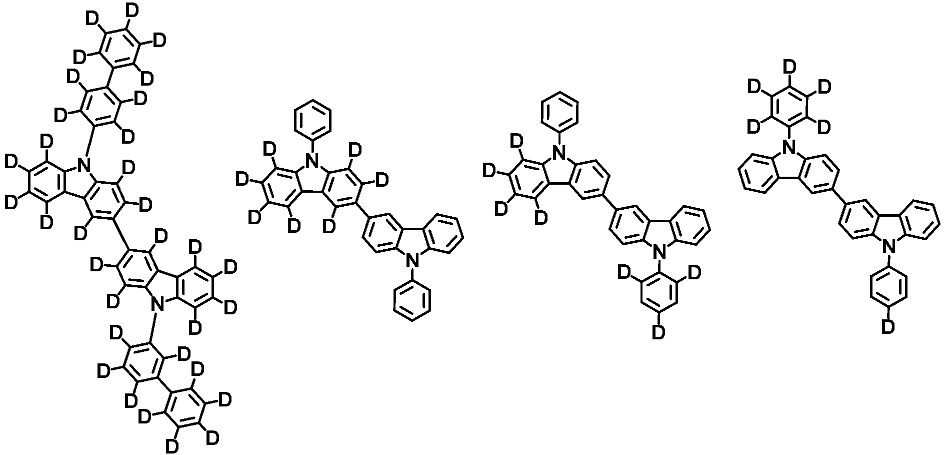

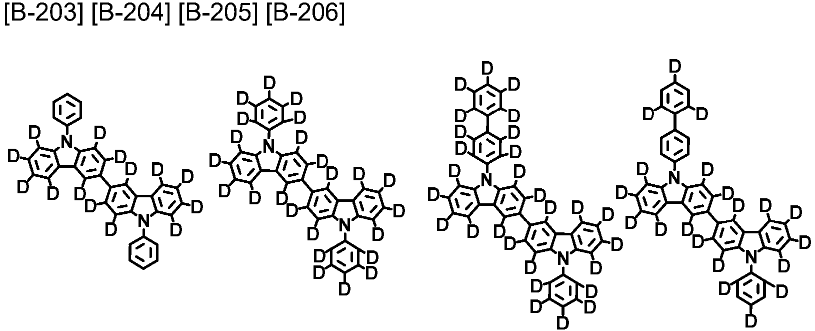

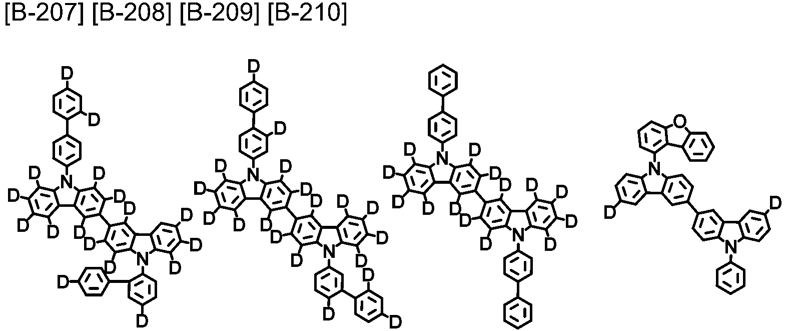

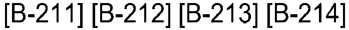

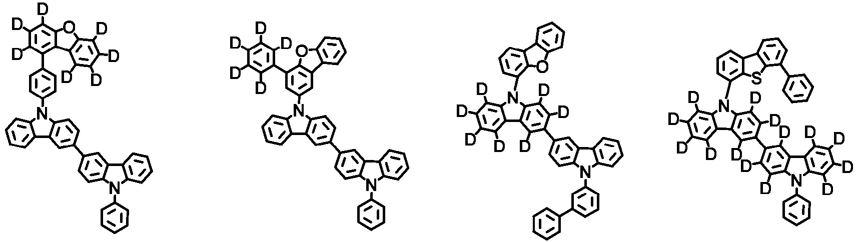

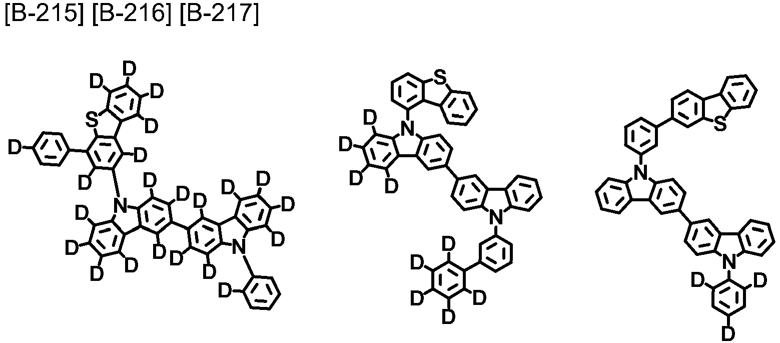

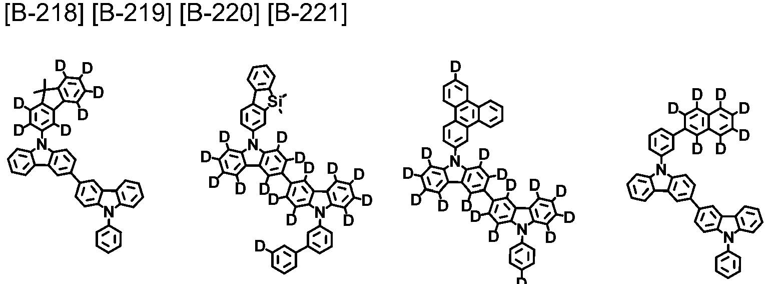

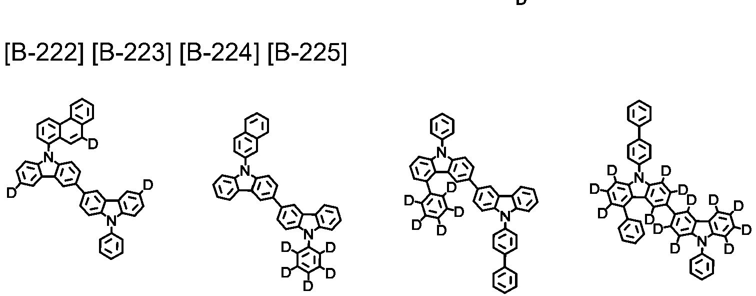

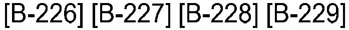

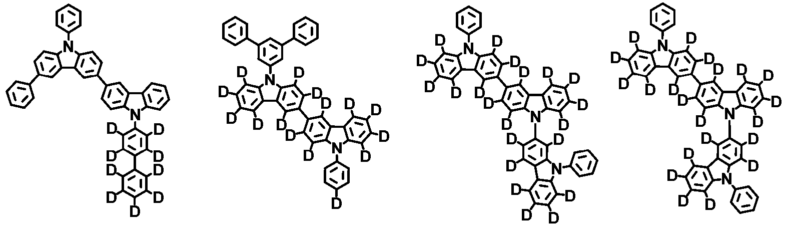

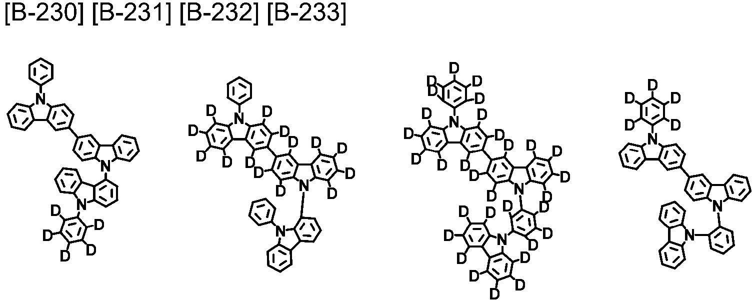

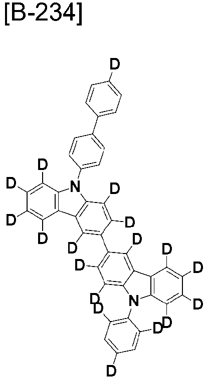

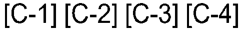

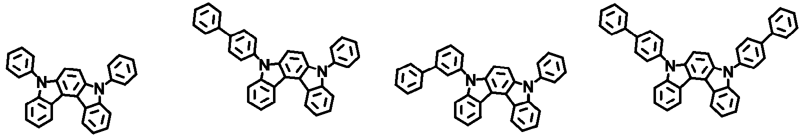

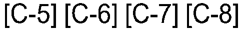

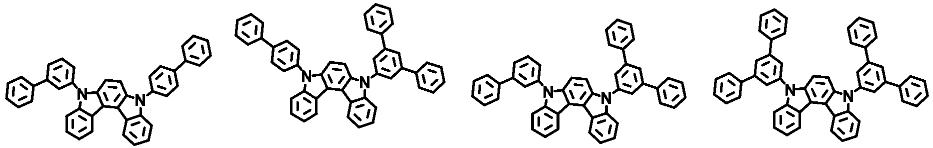

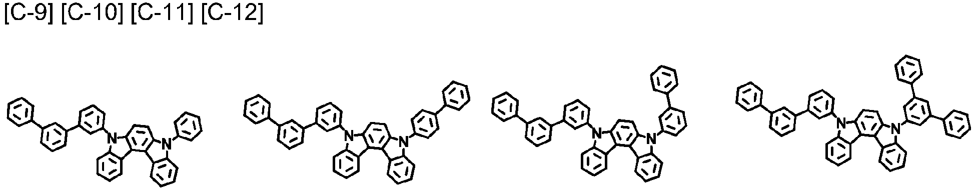

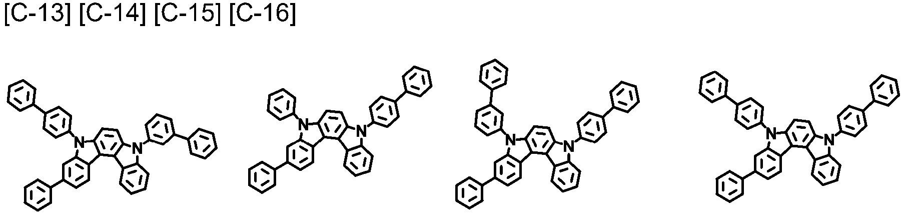

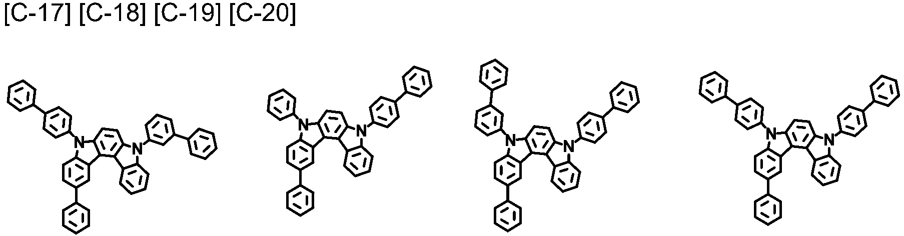

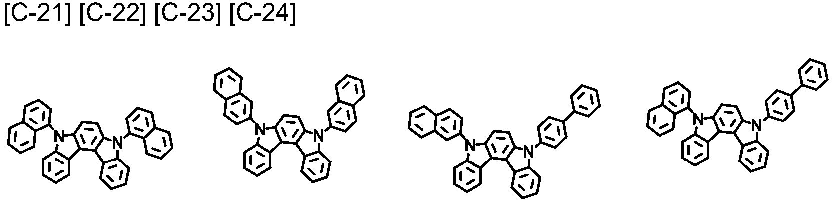

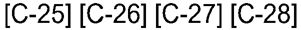

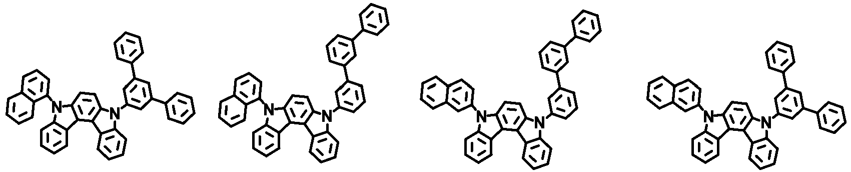

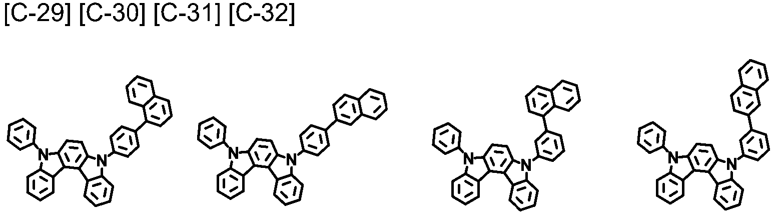

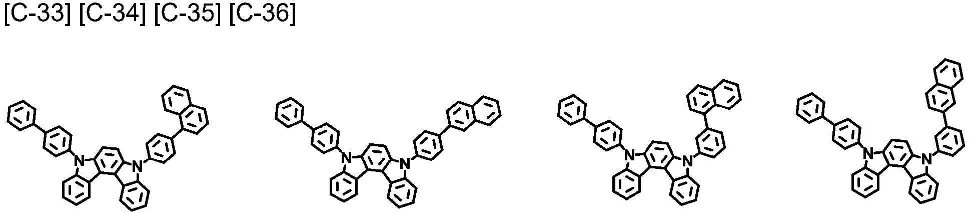

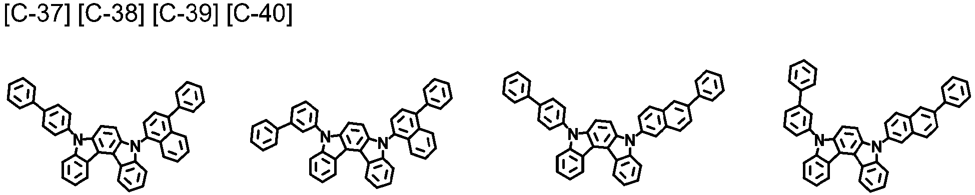

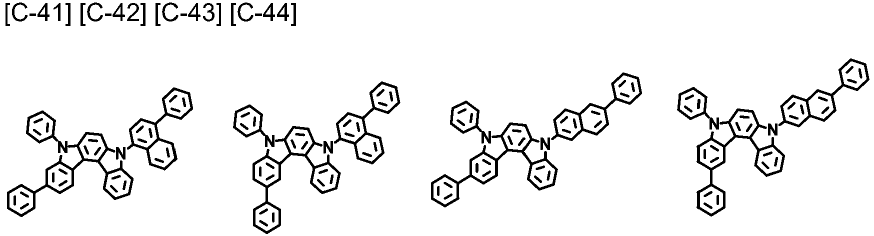

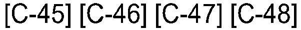

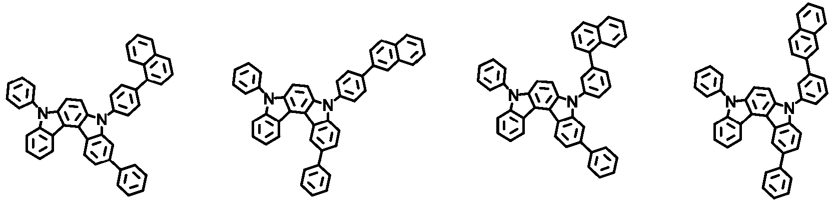

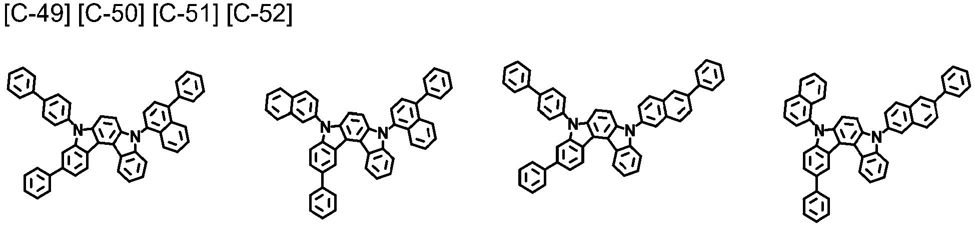

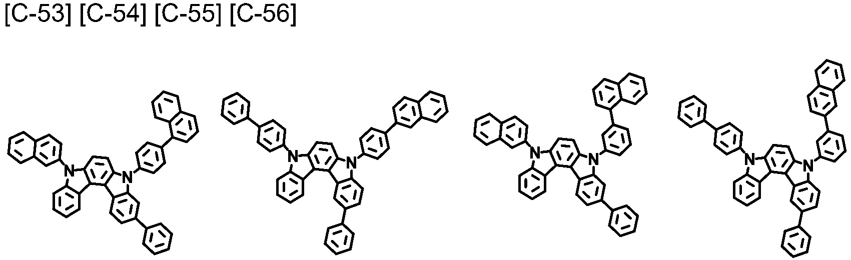

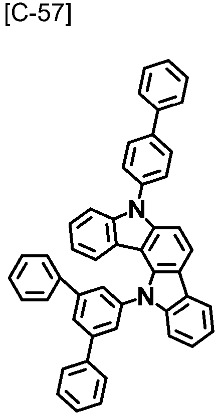

Additionally, examples of Compound C-1 to Compound C-57 listed in Group 2 in which at least one hydrogen is replaced with deuterium are shown below, but the present invention is not limited thereto. 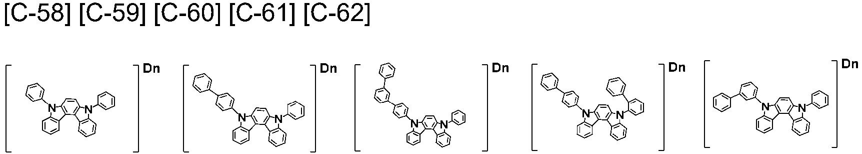 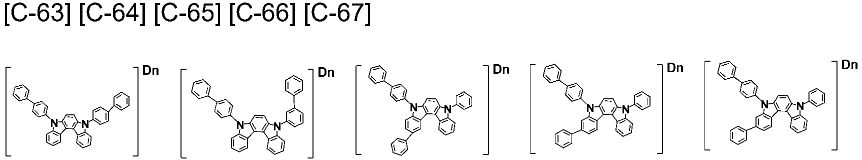 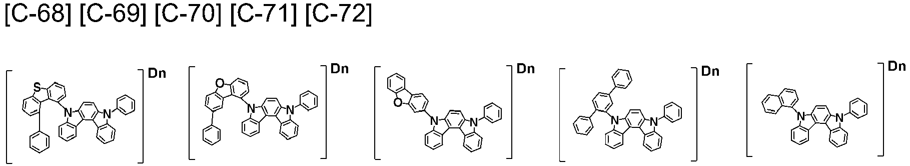 (Dn refers to the number of deuterium atoms substituted, and indicates a structure in which one or more deuterium atoms are substituted)

The most specific structures for Compound C-58 to Compound C-72 of Group 2 are presented below as examples according to the position and substitution degree of deuterium substitution, which is not to limit the scope of rights to compounds not shown below.

The scope of the present invention is determined by the claims, and when deuterium is substituted, it is not limited to the compounds exemplified below, and the position of deuterium substitution and the substitution degree of deuterium substitution may include all changeable ranges within the range of Compound C-1 to Compound C-72.

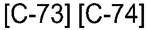

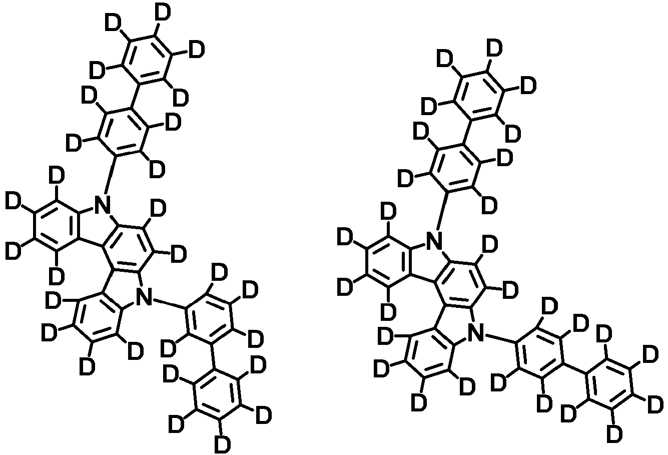

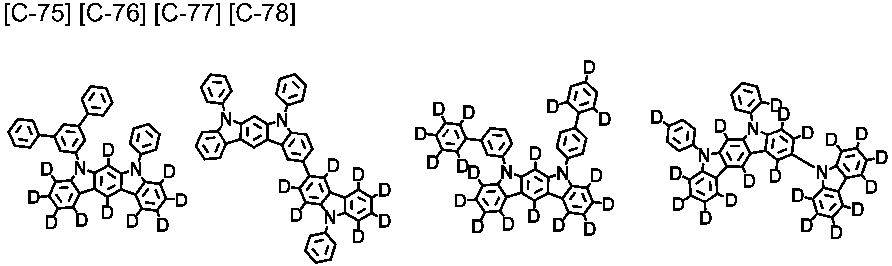

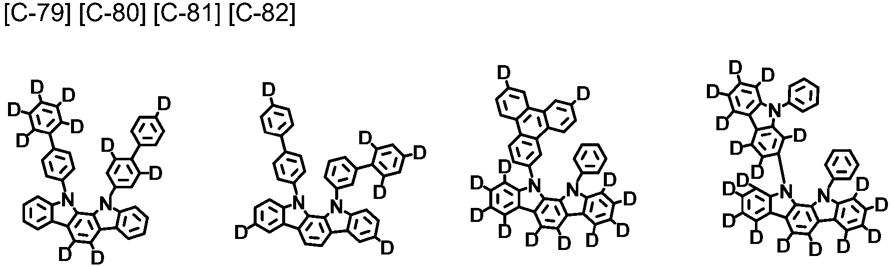

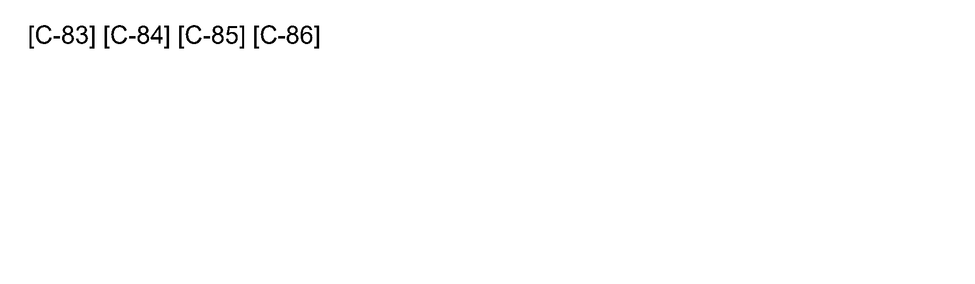

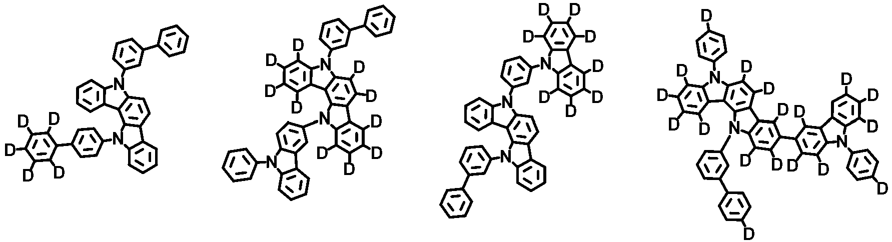

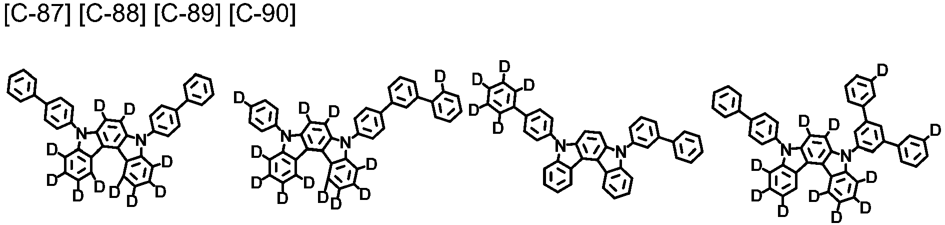

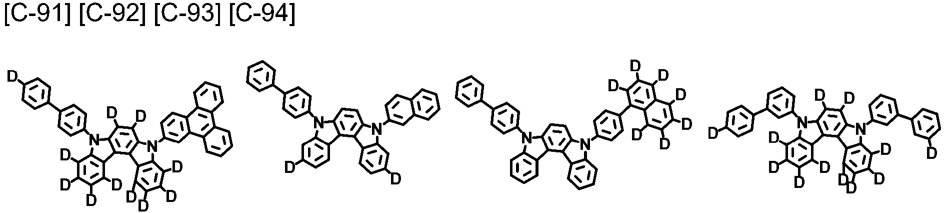

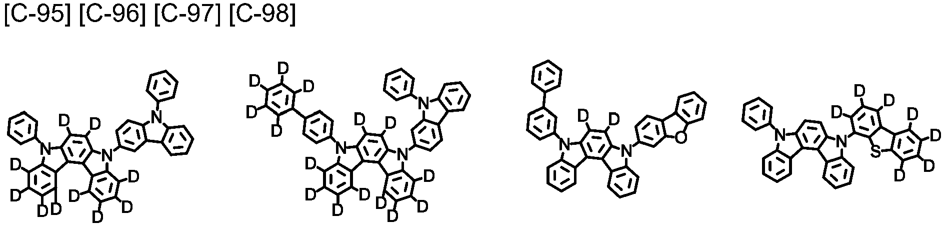

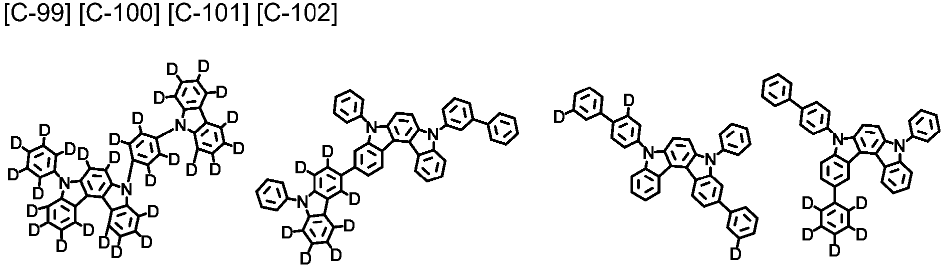

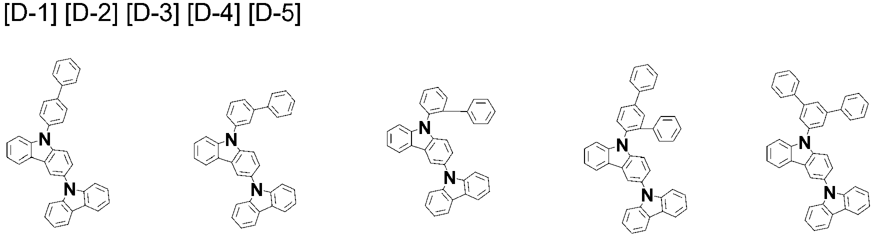

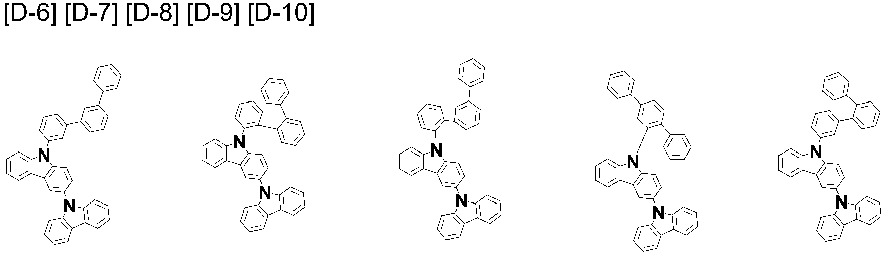

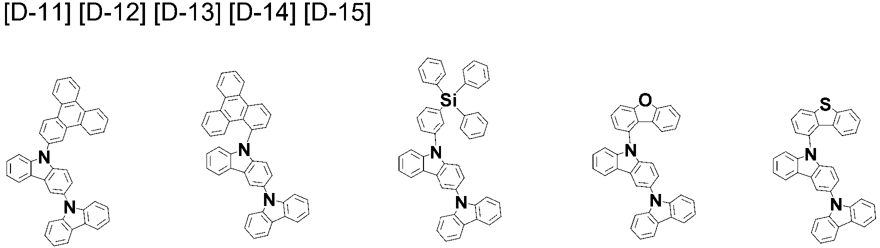

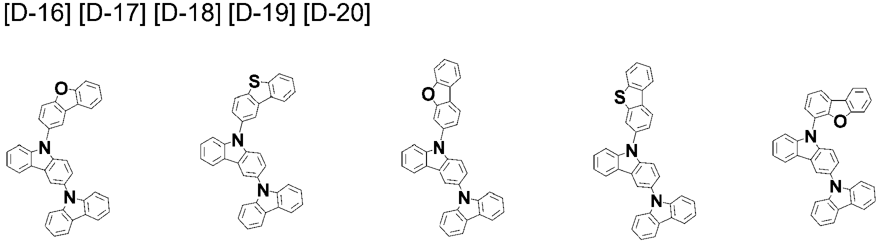

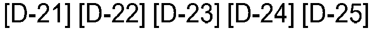

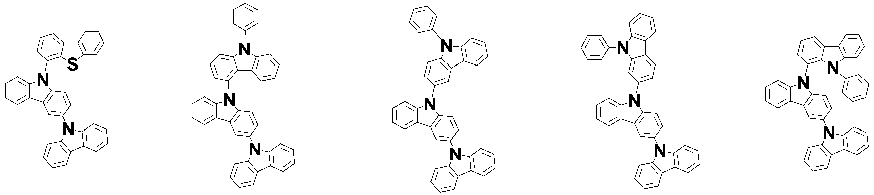

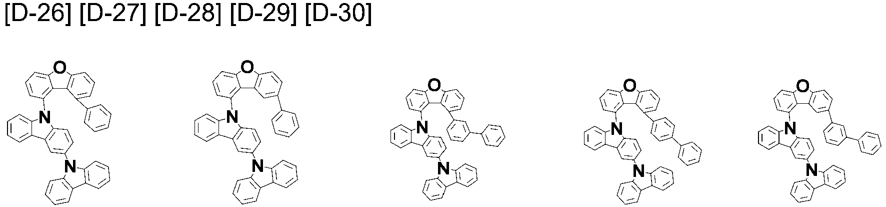

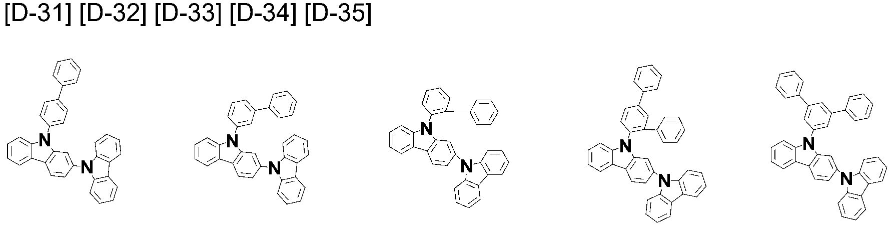

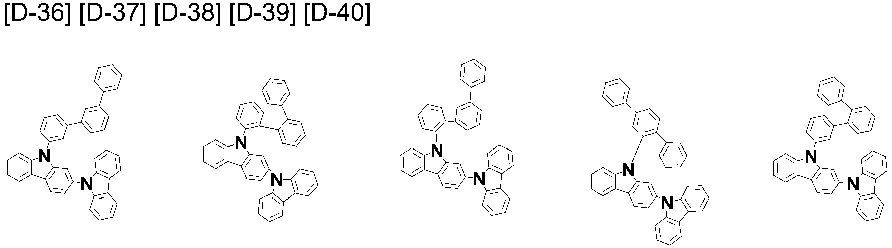

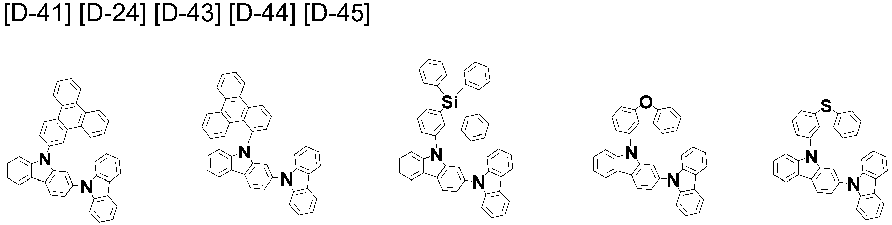

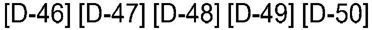

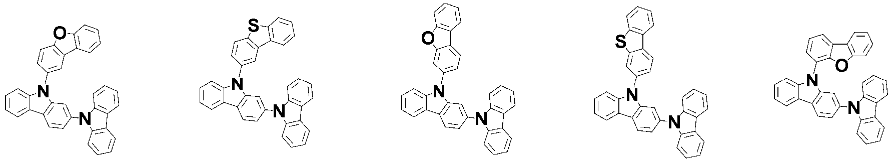

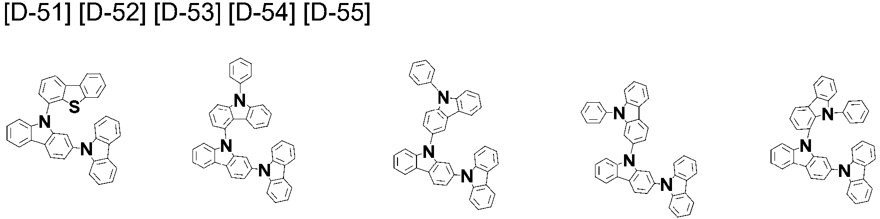

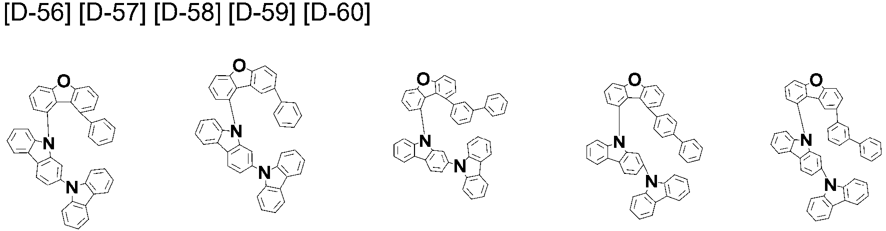

Additionally, examples of Compound D-1 to Compound D-60 listed in Group 2 in which at least one hydrogen is replaced with deuterium are shown below, but the present invention is not limited thereto. 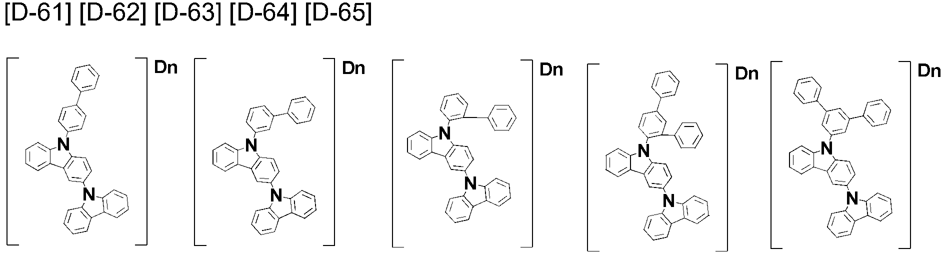 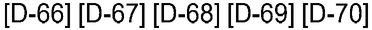 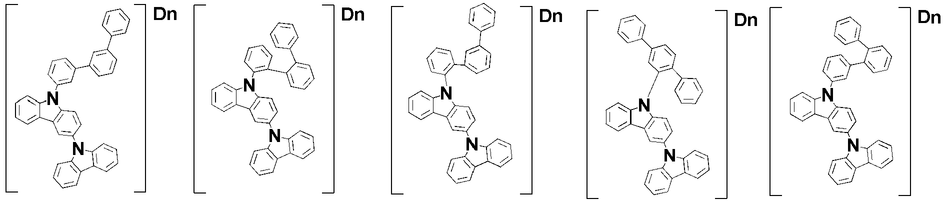 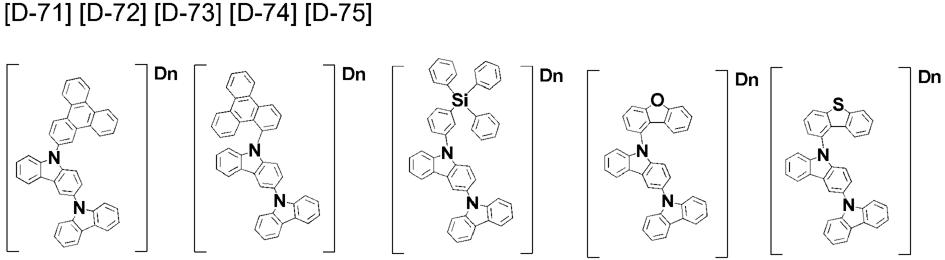 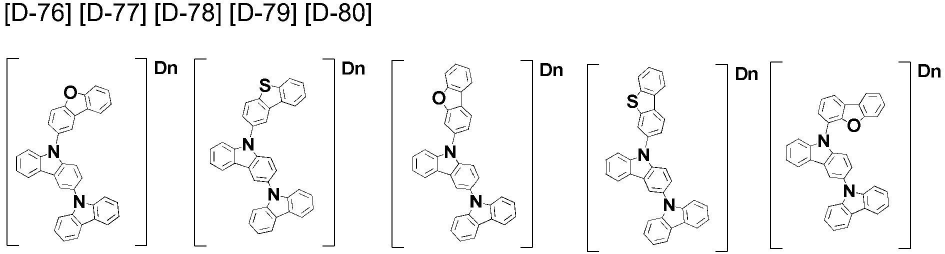 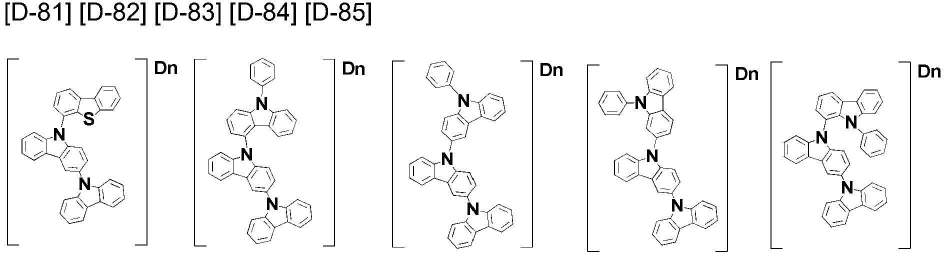 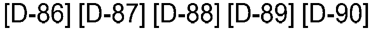 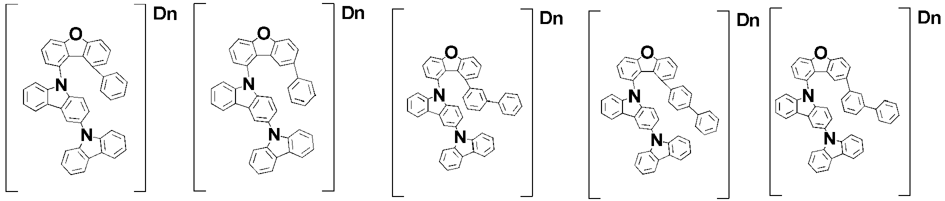 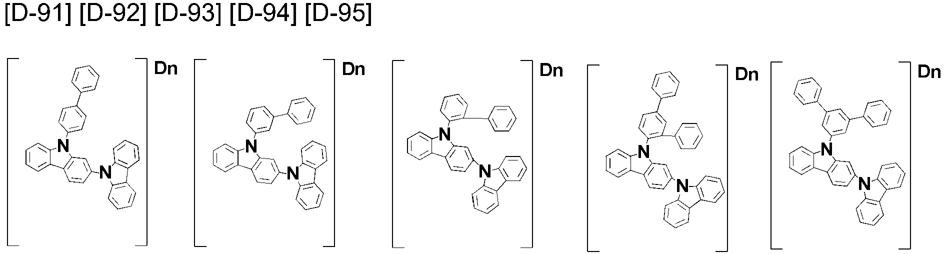 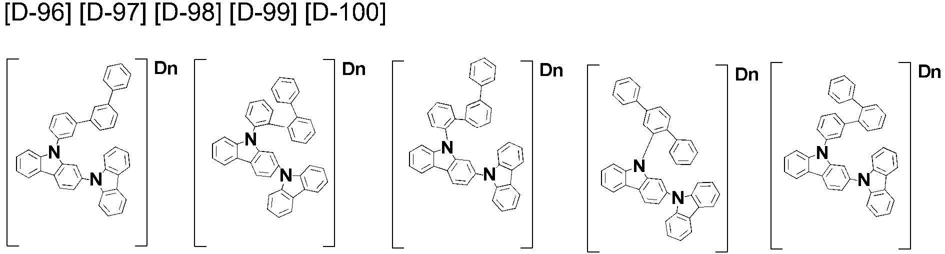 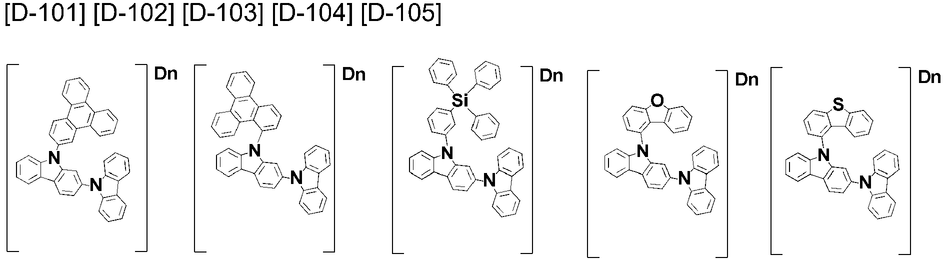 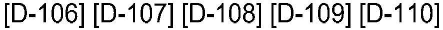 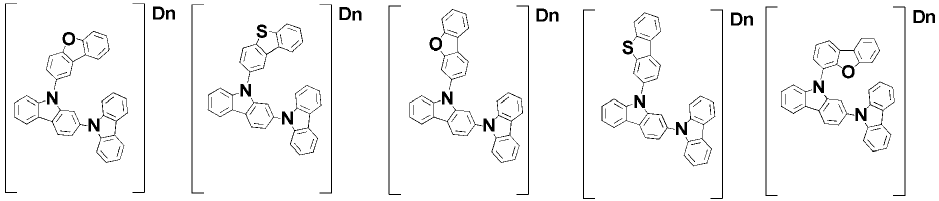 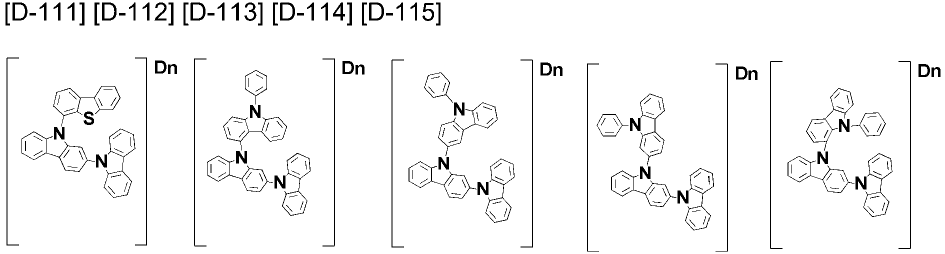 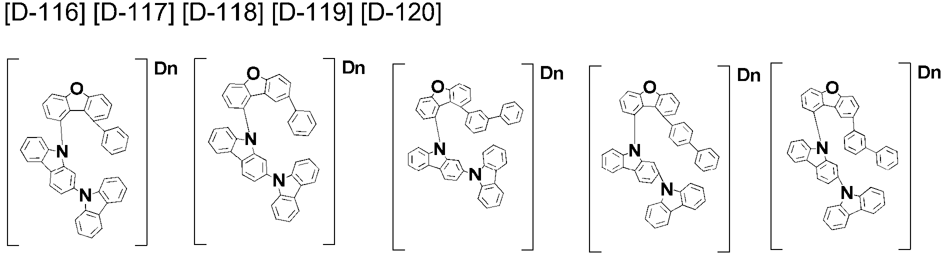 (Dn refers to the number of deuterium atoms substituted, and indicates a structure in which one or more deuterium atoms are substituted)

In the most specific embodiment, the first compound may be represented by Chemical Formula 1A-3 or Chemical Formula 1B-3, and the second compound may be represented by Chemical Formula 2-8.

The first compound and the second compound may be included in a weight ratio of, for example, 1:99 to 99:1. Within the range, a desirable weight ratio may be adjusted using an electron transport capability of the first compound and a hole transport capability of the second compound to realize bipolar characteristics and thus to improve efficiency and life-span. Within the above range, for example, they may be included in a weight ratio of about 10:90 to 90:10, about 20:80 to 80:20, for example, about 20:80 to about 70:30, about 20:80 to about 60:40, and about 30:70 to about 60:40. As a specific example, they may be included in a weight ratio of 40:60, 50:50, or 60:40.

In addition to the aforementioned first compound and second compound, one or more compounds may be further included.

The aforementioned compound for the organic optoelectronic device or composition for the organic optoelectronic device may be a composition that further includes a dopant.

The dopant may be, for example, a phosphorescent dopant, for example, a red, green or blue phosphorescent dopant, and may be, for example, a red or green phosphorescent dopant.

The dopant is a material mixed with the compound or composition for the organic optoelectronic device in a small amount to cause light emission, and may be generally a material such as a metal complex that emits light by multiple excitation into a triplet or more. The dopant may be, for example, an inorganic, organic, or organic-inorganic compound, and one or more types thereof may be used.

Examples of the dopant may be a phosphorescent dopant and examples of the phosphorescent dopant may be an organic metal compound including Ir, Pt, Os, Ti, Zr, Hf, Eu, Tb, Tm, Fe, Co, Ni, Ru, Rh, Pd, or a combination thereof. The phosphorescent dopant may be, for example, a compound represented by Chemical Formula Z, but is not limited thereto.

[Chemical Formula Z] L⁶MX²

In Chemical Formula Z, M is a metal, and L⁶ and X² are the same or different, and are a ligand to form a complex compound with M.

The M may be for example Ir, Pt, Os, Ti, Zr, Hf, Eu, Tb, Tm, Fe, Co, Ni, Ru, Rh, Pd, or a combination thereof and the L⁶ and X² may be, for example, a bidentate ligand.

Examples of ligands represented by L⁶ and X² may be selected from the Chemical Formulas listed in Group A, but are not limited thereto.

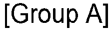

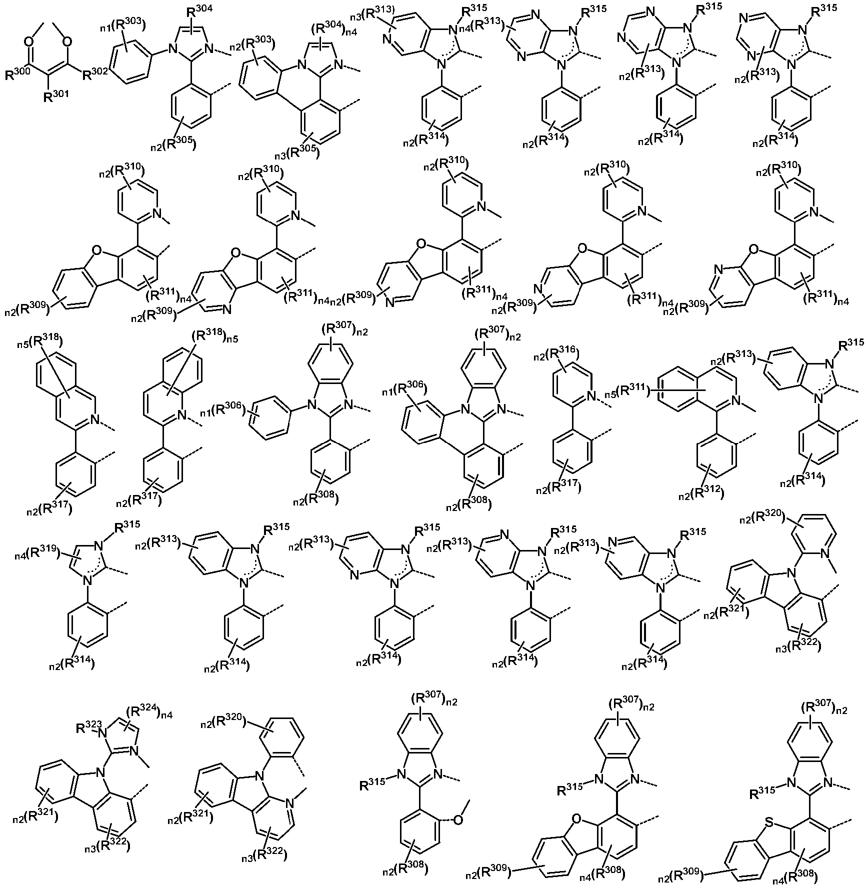

In Group A,
R³⁰⁰ to R³⁰² are each independently hydrogen, deuterium, a C1 to C30 alkyl group substituted or unsubstituted with halogen, a C6 to C30 aryl group substituted or unsubstituted with C1 to C30 alkyl or a halogen, and
R³⁰³ to R³²⁴ are each independently hydrogen, deuterium, a halogen, a substituted or unsubstituted C1 to C30 alkyl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C6 to C30 aryl group, a substituted or unsubstituted C1 to C30 heteroaryl group, a substituted or unsubstituted C1 to C30 amino group, a substituted or unsubstituted C6 to C30 arylamino group, SF₅, a trialkylsilyl group having a substituted or unsubstituted C1 to C30 alkyl group, a dialkylarylsilyl group having a substituted or unsubstituted C1 to C30 alkyl group and a C6 to C30 aryl group, or a triarylsilyl group having a substituted or unsubstituted C6 to C30 aryl group.

The dopant according to an embodiment may be an iridium complex, and may be represented, for example, by Chemical Formula 4-1 or Chemical Formula 4-2.

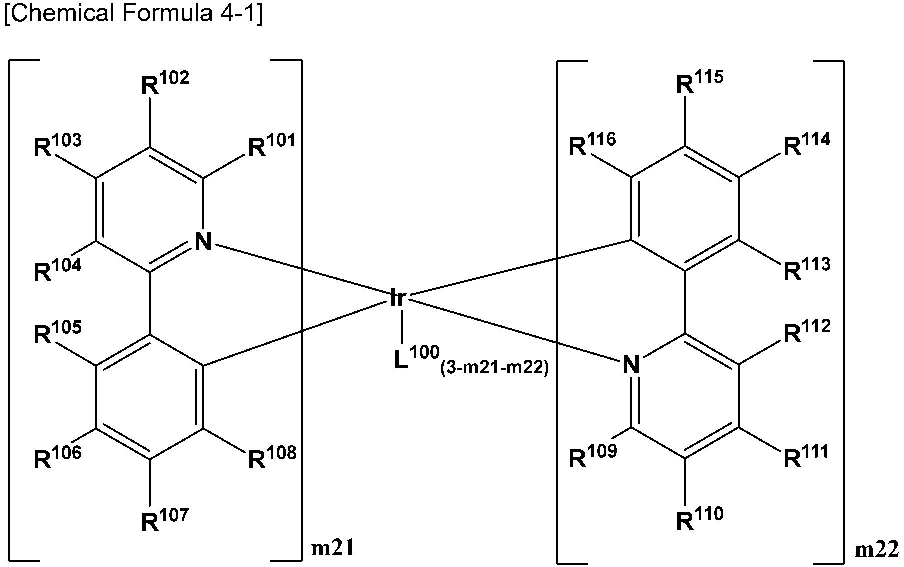

In Chemical Formula 4-1,
R¹⁰¹ to R¹¹⁶ are each independently hydrogen, deuterium, a substituted or unsubstituted C1 to C10 alkyl group, a substituted or unsubstituted C6 to C20 aryl group, or -SiR¹³²R¹³³R¹³⁴,
R¹³² to R¹³⁴ are each independently a substituted or unsubstituted C1 to C6 alkyl group,
at least one of R¹⁰¹ to R¹¹⁶ is a functional group represented by Chemical Formula V-1,
L¹⁰⁰ is a bidentate ligand of a monovalent anion, and is a ligand that coordinates to iridium through a lone pair of carbons or heteroatoms, and
m21 and m22 are each independently any one of integers of 0 to 3, and m21 + m22 is any one of integers of 1 to 3, 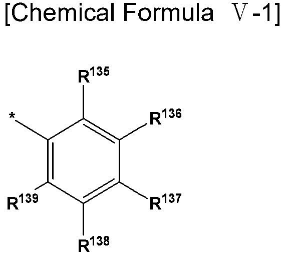
wherein, in Chemical Formula V-1,
R¹³⁵ to R¹³⁹ are each independently hydrogen, deuterium, a substituted or unsubstituted C1 to C10 alkyl group, a substituted or unsubstituted C6 to C20 aryl group, or -SiR¹³²R¹³³R¹³⁴, and
* refers to a portion linked to a carbon atom. 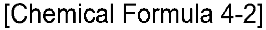 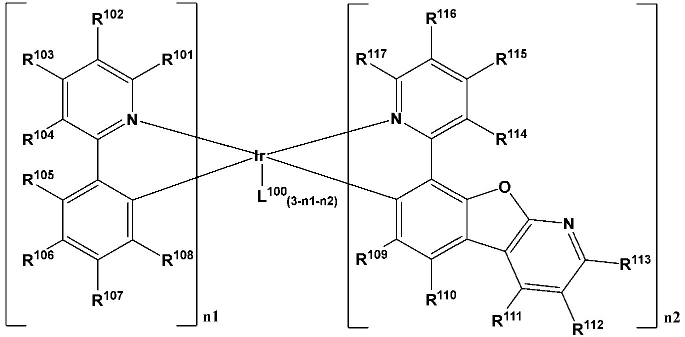
wherein, in Chemical Formula 4-2,
R¹⁰¹ to R¹¹⁷ are each independently hydrogen, deuterium, a substituted or unsubstituted C1 to C10 alkyl group, a substituted or unsubstituted C6 to C20 aryl group, or -SiR¹³³R¹³⁴R¹³⁵
R¹³³ to R¹³⁵ are each independently a substituted or unsubstituted C1 to C6 alkyl group,
L¹⁰⁰ is a bidentate ligand of a monovalent anion, and is a ligand that coordinates to iridium through a lone pair of carbons or heteroatoms, and
n1 and n2 are each independently any one of integers of 0 to 3, and n1 + n2 is any one of integers of 1 to 3.

In another embodiment, the dopant may be a platinum complex, for example, represented by Chemical Formula Z-1.

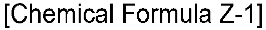

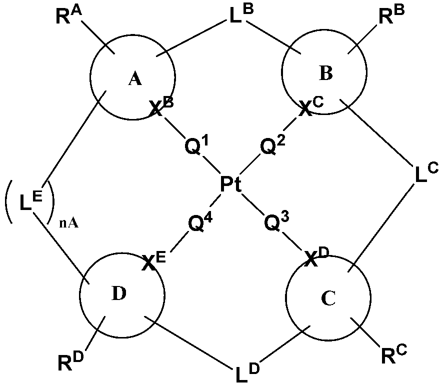

In Chemical Formula Z-1, rings A, B, C, and D are each independently a 5-membered or 6-membered carbocyclic or heterocyclic ring;
R^{A}, R^{B}, R^{C}, and R^{D} are each independently mono-, di-, tri-, or tetra-substitution, or unsubstitution;
L^{B}, L^{C}, and L^{D} are each independently a direct bond, BR, NR, PR, O, S, Se, C=O, S=O, SO₂, CRR', SiRR', GeRR', or a combination thereof,
when nA is 1, L^{E} may be a direct bond, BR, NR, PR, O, S, Se, C=O, S=O, SO₂, CRR', SiRR', GeRR', or a combination thereof; and when nA is 0, L^{E} does not exist;
R^{A}, R^{B}, R^{C}, R^{D}, R, and R' are each independently hydrogen, deuterium, a halogen, alkyl group, a cycloalkyl group, a heteroalkyl group, arylalkyl group, an alkoxy group, aryloxy group, an amino group, a silyl group, an alkenyl group, a cycloalkenyl group, a heteroalkenyl group, an alkynyl group, aryl group, a heteroaryl group, an acyl group, a carbonyl group, a carboxylic acid group, an ester group, a nitrile group, an isonitrile group, a sulfanyl group, a sulfinyl group, a sulfonyl group, a phosphino group, or a combination thereof; any adjacent R^{A}, R^{B}, R^{C}, R^{D}, R, and R' are optionally linked to each other to provide a ring; X^{B}, X^{C}, X^{D}, and X^{E} are each independently selected from carbon and nitrogen; and Q¹, Q², Q³, and Q⁴ each represent oxygen or a direct bond.

The platinum complex may be represented, for example, by Chemical Formula 5-1 or Chemical Formula 5-2.

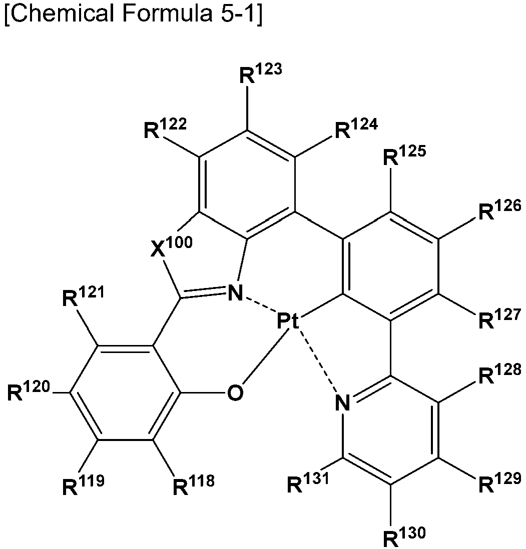

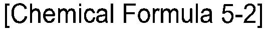

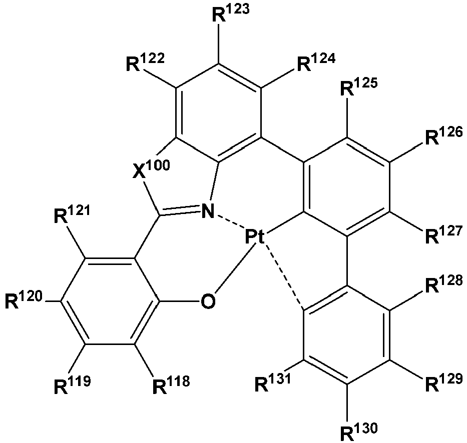

In Chemical Formula 5-1 and Chemical Formula 5-2,
X¹⁰⁰ is selected from O, S, and NR¹³²,
R¹¹⁸ to R¹³² are each independently hydrogen, deuterium, a substituted or unsubstituted C1 to C10 alkyl group, a substituted or unsubstituted C6 to C20 aryl group, or - SiR¹³³R¹³⁴R¹³⁵
R¹³³ to R¹³⁵ are each independently a substituted or unsubstituted C1 to C6 alkyl group,
at least one of R¹¹⁸ to R¹³² is -SiR¹³³R¹³⁴R¹³⁵ or a tert-butyl group, and
R¹³³ to R¹³⁵ are each independently a substituted or unsubstituted C1 to C6 alkyl group.

Hereinafter, an organic optoelectronic device including the aforementioned compound for the organic optoelectronic device or composition for the organic optoelectronic device is described.

The organic optoelectronic device may be a suitable device to convert electrical energy into photoenergy and vice versa, e.g., an organic photoelectric device, an organic light emitting diode, an organic solar cell, or an organic photoconductor drum.

Herein, an organic light emitting diode as one example of an organic optoelectronic device is described referring to drawings.

FIG. 1 is a cross-sectional view showing an organic light emitting diode according to an embodiment.

Referring to FIG. 1, an organic light emitting diode 100 according to an embodiment includes an anode 120 and a cathode 110 facing each other and an organic layer 105 disposed between the anode 120 and cathode 110.

The anode 120 may be made of a conductor having a large work function to help hole injection, and may be for example a metal, a metal oxide and/or a conductive polymer. The anode 120 may be, for example a metal such as nickel, platinum, vanadium, chromium, copper, zinc, gold, and the like or an alloy thereof; a metal oxide such as zinc oxide, indium oxide, indium tin oxide (ITO), indium zinc oxide (IZO), and the like; a combination of a metal and an oxide such as ZnO and Al or SnO₂ and Sb; a conductive polymer such as poly(3-methylthiophene), poly(3,4-(ethylene-1,2-dioxy)thiophene) (PEDOT), polypyrrole, and polyaniline, but is not limited thereto.

The cathode 110 may be made of a conductor having a small work function to help electron injection, and may be for example a metal, a metal oxide, and/or a conductive polymer. The cathode 110 may be for example a metal such as magnesium, calcium, sodium, potassium, titanium, indium, yttrium, lithium, gadolinium, aluminum silver, tin, lead, cesium, barium, and the like, or an alloy thereof; a multi-layer structure material such as LiF/Al, LiO₂/Al, LiF/Ca, LiF/Al, and BaF₂/Ca, but is not limited thereto.

The organic layer 105 may include the aforementioned compound for the organic optoelectronic device or composition for the organic optoelectronic device.

The organic layer 105 may include a light emitting layer 130, and the light emitting layer 130 may include the aforementioned compound for the organic optoelectronic device or composition for the organic optoelectronic device.

The composition for the organic optoelectronic device further including a dopant may be, for example, a green light emitting composition.

The light emitting layer 130 may include, for example, the aforementioned compound for the organic optoelectronic device or composition for the organic optoelectronic device as a phosphorescent host.

The organic layer may further include a charge transport region in addition to the light emitting layer.

The charge transport region may be, for example, a hole transport region 140.

The hole transport region 140 can further increase hole injection and/or hole mobility and block electrons between the anode 120 and the light emitting layer 130.

Specifically, the hole transport region 140 may include a hole transport layer between the anode 120 and the light emitting layer 130, and a hole transport auxiliary layer between the light emitting layer 130 and the hole transport layer, and at least one of the compounds listed in Group B may be included in at least one layer of the hole transport layer and the hole transport auxiliary layer. 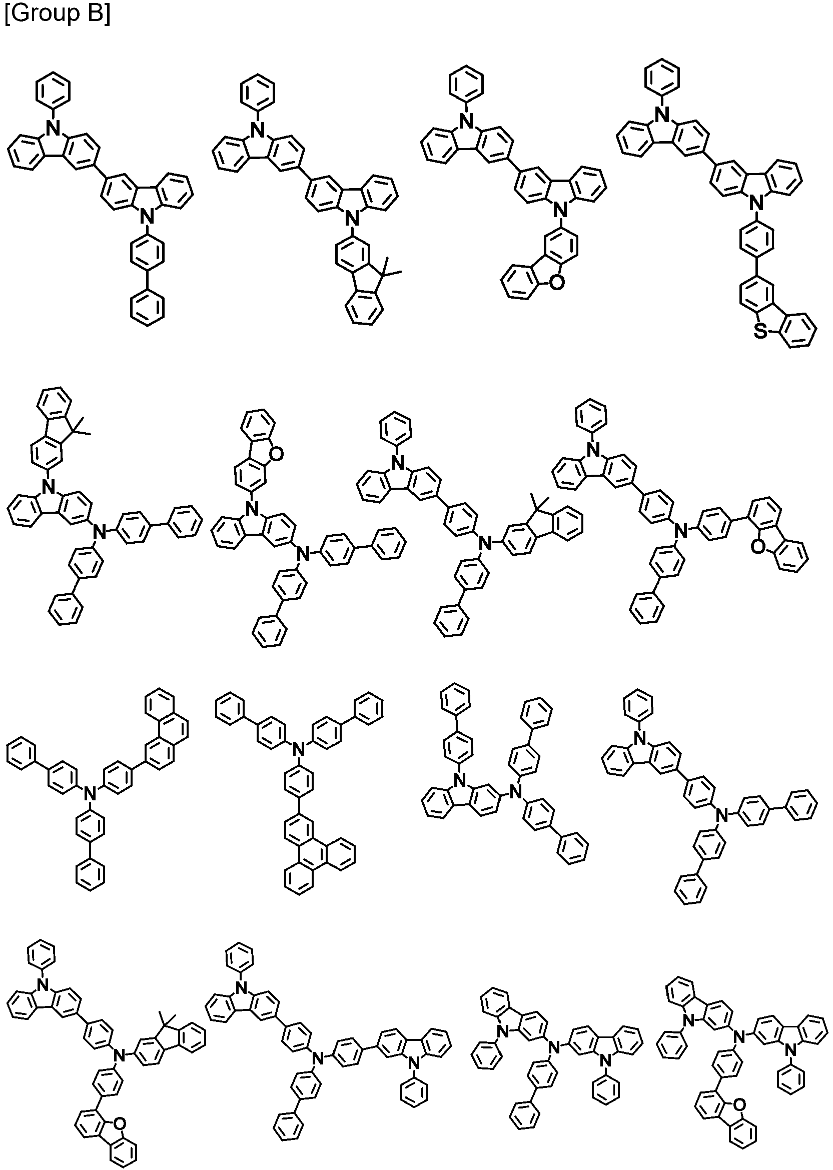 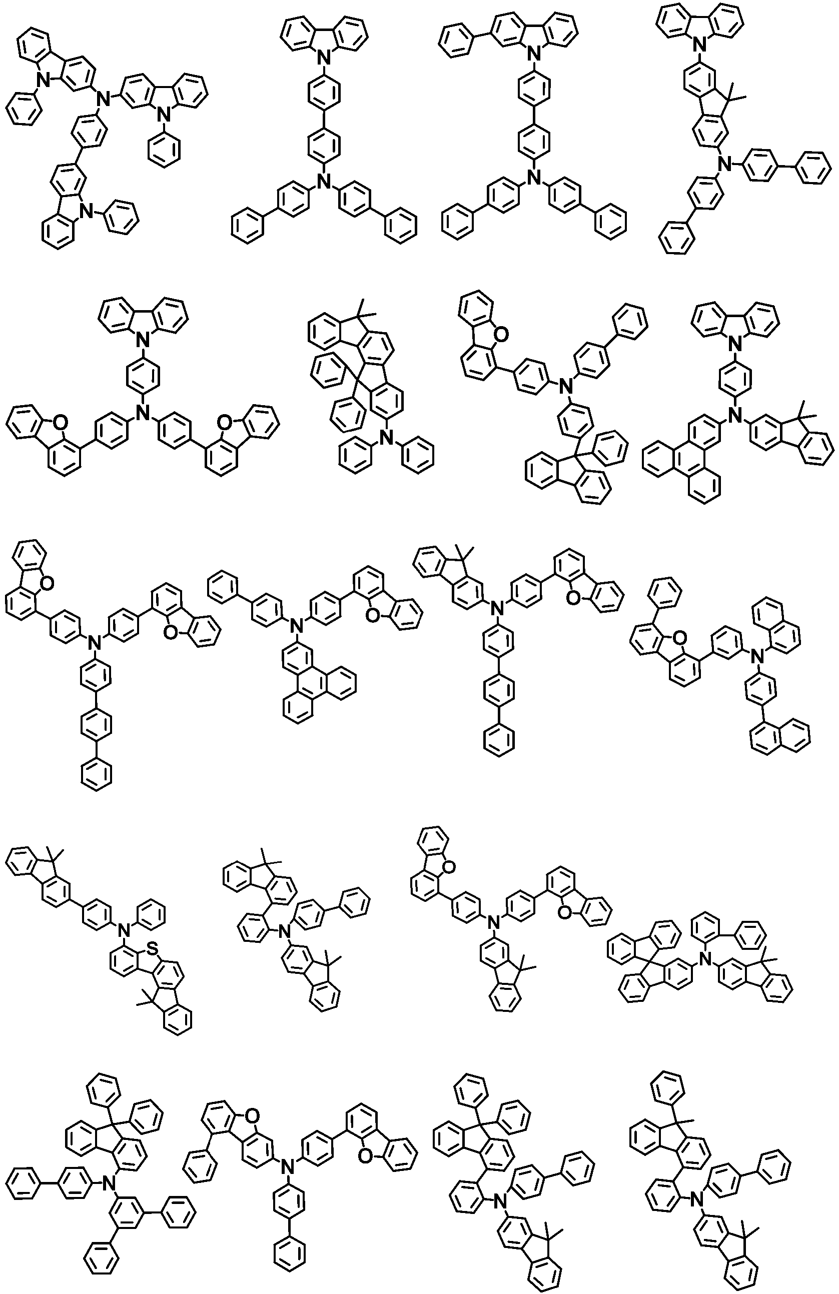 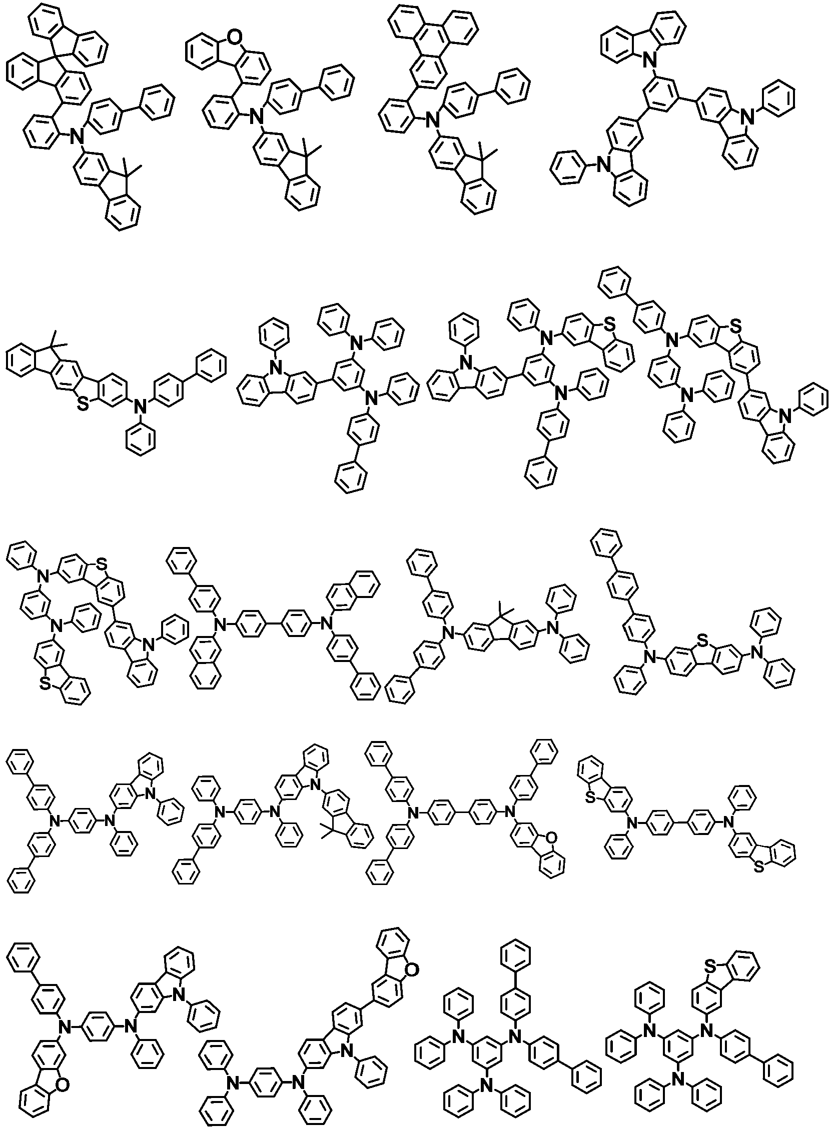 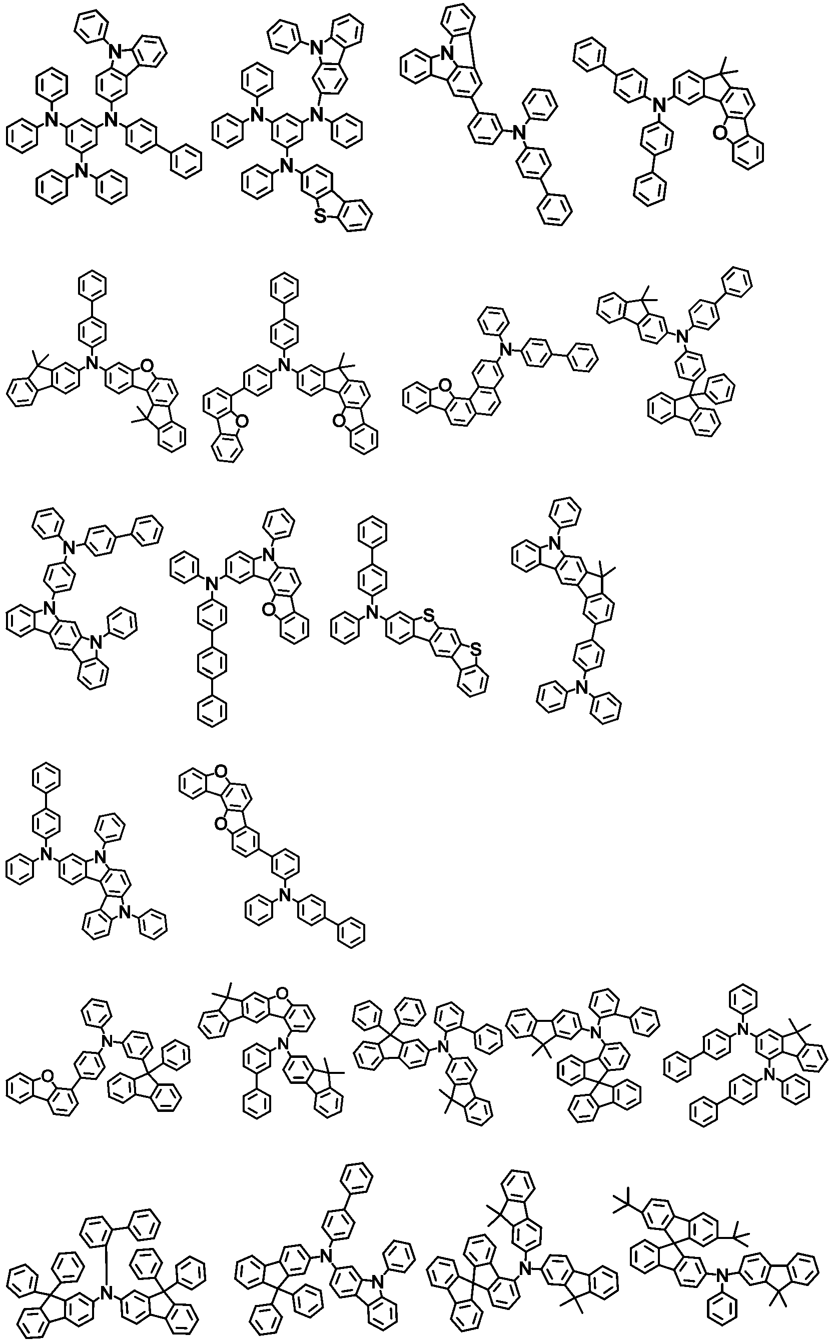 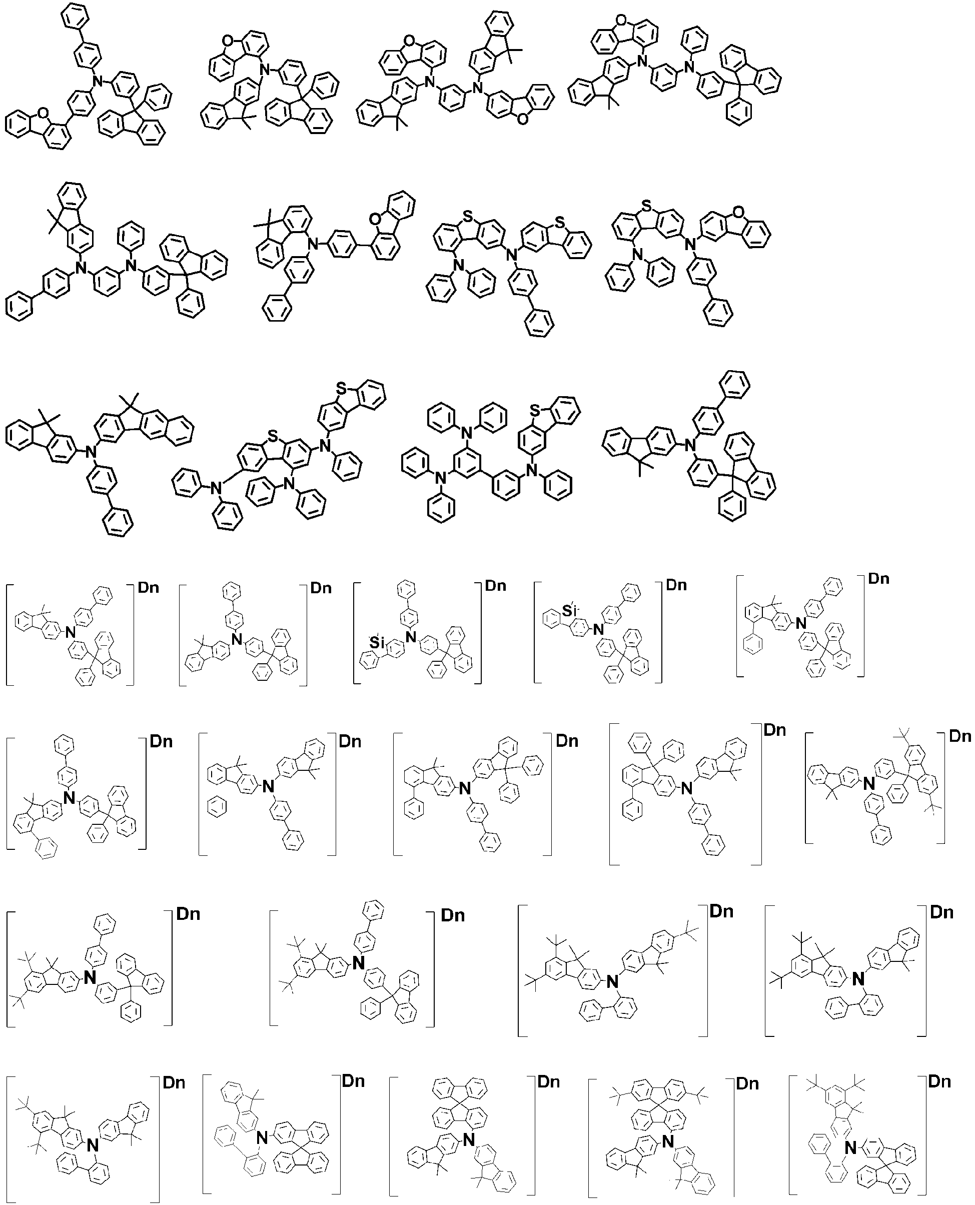 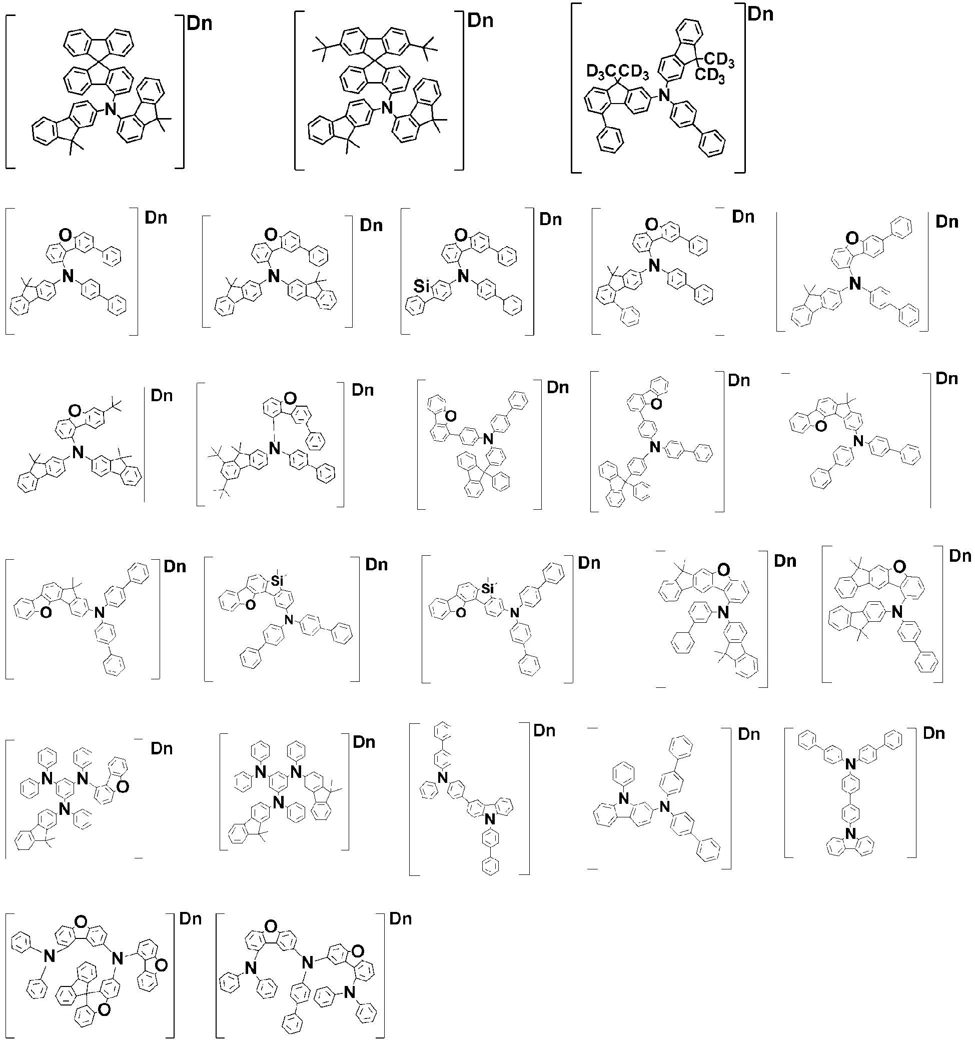 (Dn refers to the number of deuterium atoms substituted, and indicates a structure in which one or more deuterium atoms are substituted)

In the hole transport region 140, in addition to the compounds described above, known compounds disclosed in US5061569A, JP1993-009471A, WO1995-009147A1, JP1995-126615A, JP1998-095973A, etc. and compounds having a similar structure may also be used.

Also, the charge transport region may be, for example, the electron transport region 150.

The electron transport region 150 may further increase electron injection and/or electron mobility and block holes between the cathode 110 and the light emitting layer 130.

Specifically, the electron transport region 150 may include an electron transport layer between the cathode 110 and the light emitting layer 130, and an electron transport auxiliary layer between the light emitting layer 130 and the electron transport layer, and at least one of the compounds of Group C may be included in at least one of the electron transport layer and the electron transport auxiliary layer.

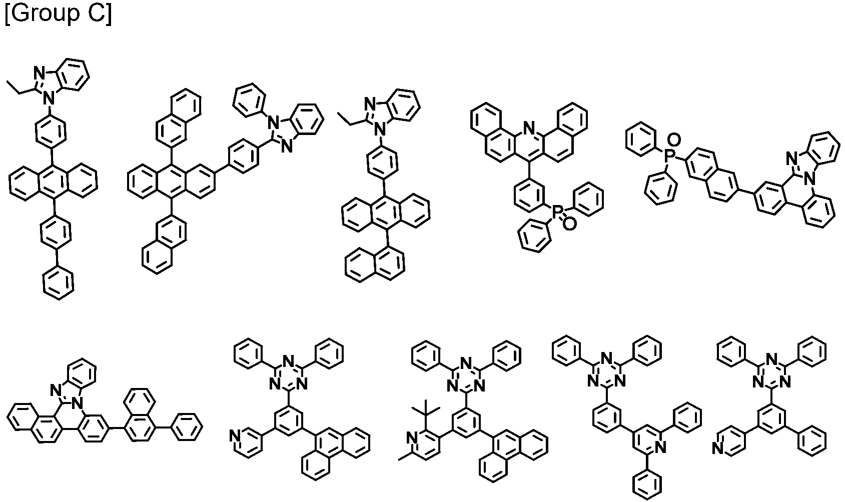

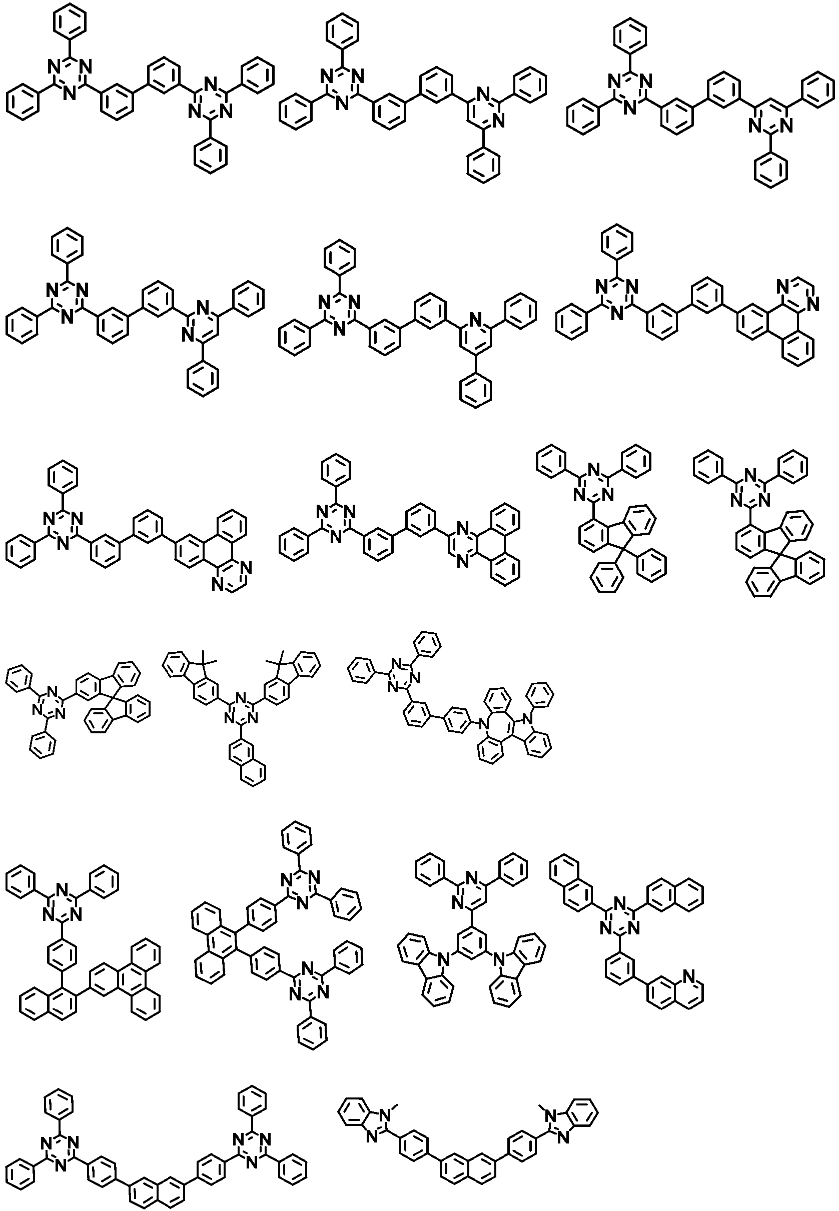

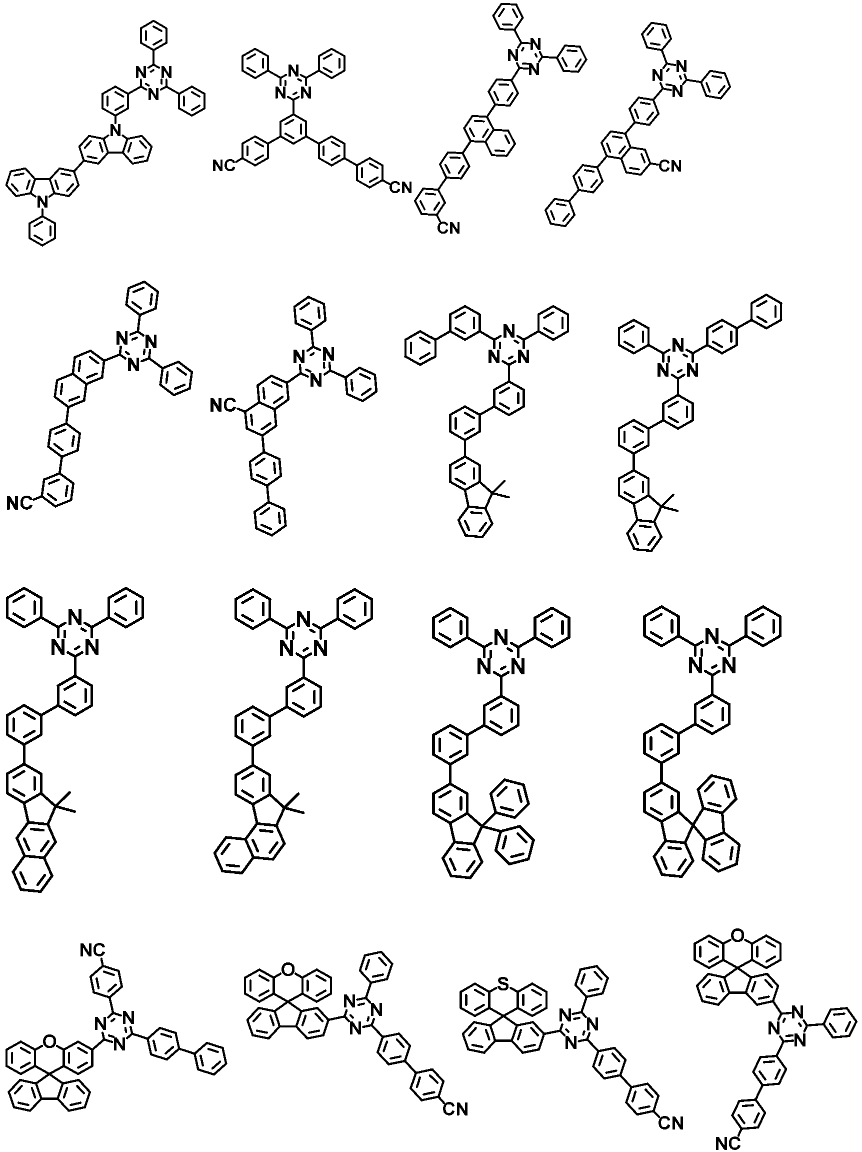

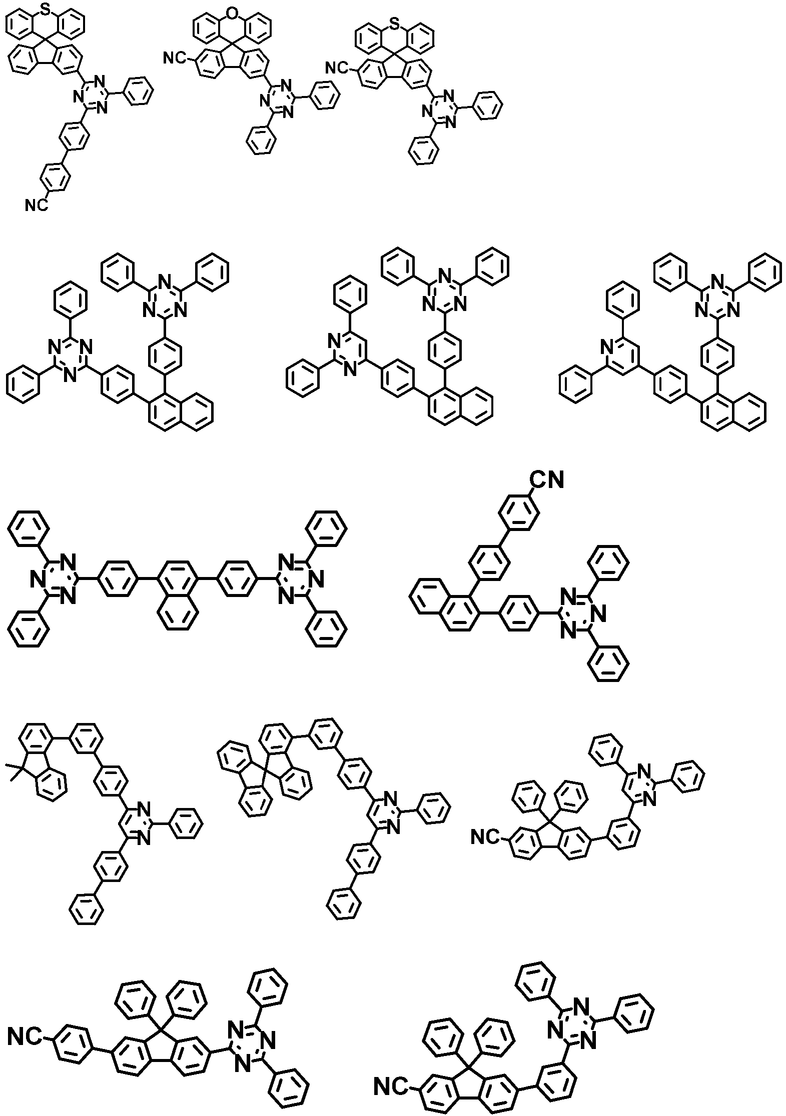

An embodiment may be an organic light emitting diode including the light emitting layer as the organic layer.

Another embodiment may be an organic light emitting diode including a light emitting layer and a hole transport region as the organic layer.

Another embodiment may be an organic light emitting diode including a light emitting layer and an electron transport region as the organic layer.

An organic light emitting diode according to an embodiment includes a hole transport region 140 and an electron transport region 150 in addition to the light emitting layer 130 as the organic layer 105, as shown in FIG. 1.

On the other hand, an organic light emitting diode may further include an electron injection layer (not shown), a hole injection layer (not shown), etc. in addition to the light emitting layer as the organic layer.

The organic light emitting diodes 100 may be manufactured by forming an anode or a cathode on a substrate, and then forming an organic layer by a dry film method such as vacuum deposition, sputtering, plasma plating and ion plating, and forming a cathode or an anode thereon.

The organic light emitting diode may be applied to an organic light emitting display device.

Hereinafter, the embodiments are illustrated in more detail with reference to examples. However, these examples are exemplary, and the present scope is not limited thereto.

### [Mode for Invention]

Hereinafter, starting materials and reactants used in Examples and Synthesis Examples were purchased from Sigma-Aldrich Co. Ltd., TCI Inc., Tokyo chemical industry, or P&H tech as far as there is no particular comment or were synthesized by known methods.

### (Preparation of Compound for Organic Optoelectronic Device)

### Synthesis Example 1: Synthesis of Compound 1

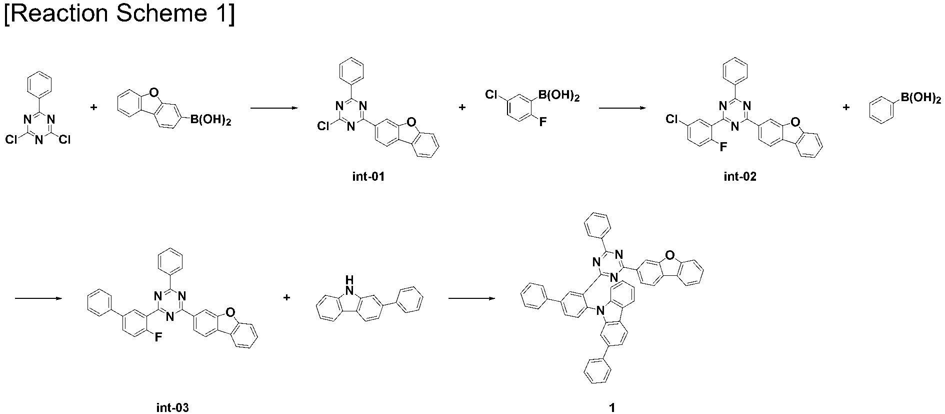

### 1st step: Synthesis of Intermediate int-01

2,4-Dichloro-6-phenyl-1,3,5-triazine (20.0 g, 88.5 mmol), 3-dibenzofuranylboronic acid (17.8 g, 84.1 mmol), K₂CO₃ (24.5 g, 176.9 mmol), and Pd(dppf)Cl₂ (3.6 g, 4.4 mmol) were added to a round bottom flask and dissolved in toluene (250 ml) and distilled water (90 ml) and then, stirred at 60 °C for 6 hours. When a reaction was completed, after separating an aqueous layer by using a separatory funnel, an organic layer therefrom was distilled under a reduced pressure. The obtained product was dissolved by heating with monochlorobenzene and then, silica-filtered and recrystallized, obtaining 14.4 g (48%) of Intermediate int-01.

### 2nd step: Synthesis of Intermediate int-02

Intermediate int-01 (14.4 g, 40.2 mmol), 5-chloro-2-fluorophenylboronic acid (6.8 g, 39.0 mmol), K₂CO₃ (10.8 g, 78.0 mmol), and Pd(PPh₃)₄ (2.25 g, 1.95 mmol) were added to a round bottom flask and dissolved in THF (180 ml) and distilled water (40 ml) and then, stirred under reflux at 55 °C for 6 hours. When a reaction was completed, after removing an aqueous layer, 13.2 g (75%) of Intermediate int-02 was obtained by using column chromatography (hexane:DCM (30%)).

### 3rd step: Synthesis of Intermediate int-03

Intermediate int-02 (13.2 g, 29.2 mmol), phenylboronic acid (10.7 g, 86.6 mmol), Cs₂CO₃ (19.0 g, 58.4 mmol), tri-tert-butylphosphine (2.9 ml, 5.8 mmol), and Pd₂(dba)₃ (1.3 g, 1.5 mmol) were added to a round bottom flask and dissolved in 120 ml of 1,4-dioxane and then, stirred under reflux at 100 °C for 8 hours. When a reaction was completed, after cooling to room temperature, the reactant was poured into an excessive amount of methanol to precipitate a solid, which was filtered and recrystallized with monochlorobenzene, obtaining 10.8 g (75%) of Intermediate int-03.

### 4th step: Synthesis of Compound 1

Intermediate int-03 (10.8 g, 21.9 mmol), 2-phenyl-9H-carbazole (6.4 g, 26.3 mmol), and K₃PO4 (9.3 g, 43.8 mmol) were added to a round bottom flask and dissolved in DMF (100 ml) and then, stirred under reflux at 150 °C for 4 hours. When a reaction was completed, the reactant was slowly added in a dropwise fashion to an excessive amount of water to precipitate a solid, which was recrystallized with toluene, obtaining 12.6 g (80%) of Compound 1.

### Synthesis Example 2: Synthesis of Compound 40

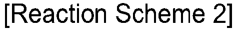

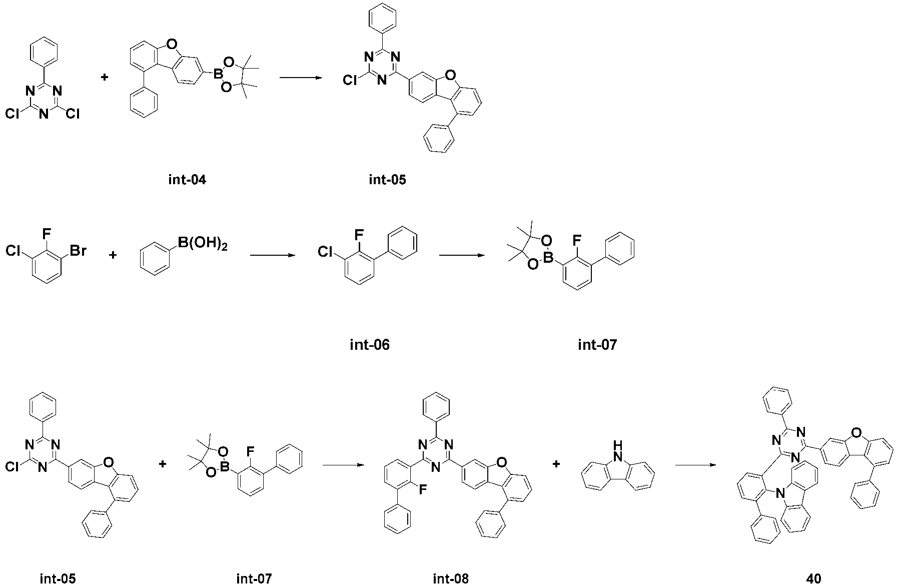

### 1st step: Synthesis of Intermediate int-05

45.6 g (83%) of Intermediate int-05 was obtained in the same manner as in the 1^{st} step of Synthesis Example 1 by using 2,4-dichloro-6-phenyl-1,3,5-triazine (30.0 g, 132.7 mmol), Intermediate Int-04 (46.7 g, 126.1 mmol), K₂CO₃ (36.7 g, 265.4 mmol), and Pd(dppf)Cl₂ (5.42 g, 6.64 mmol).

### 2nd step: Synthesis of Intermediate int-06

1-Bromo-3-chloro-2-fluorobenzene (25.0 g, 119.4 mmol), phenylboronic acid (16.0 g, 131.3 mmol), K₂CO₃ (33.0 g, 238.7 mmol), and Pd(PPh₃)₄ (6.9 g, 6.0 mmol) were added to a round bottom flask and dissolved in THF (350 ml) and distilled water (120 ml) and then, stirred under reflux at 65 °C for 6 hours. When a reaction was complete, after removing an aqueous layer, 21.7 g (88%) of Intermediate int-06 was obtained by using column chromatography (hexane:DCM (20%)).

### 3rd step: Synthesis of Intermediate int-07

Intermediate int-06 (21.7 g, 105.0 mmol), bis(pinacolato)diboron (32.0 g, 126.0 mmol), tricyclohexylphosphine (5.1 g, 21.0 mmol), potassium acetate (20.6 g, 210.0 mmol), and Pd(dppf)Cl₂ (4.29 g, 5.25 mmol) were added to a round bottom flask and dissolved in DMF (250 ml). The mixture was stirred under reflux at 140 °C for 8 hours. When a reaction was completed, after cooling to room temperature and removing a salt by filtering, an excessive amount of DCM and distilled water were added thereto for extraction. 25.1 g (80%) of Intermediate int-07 was obtained therefrom by using column chromatography (Hexane:DCM (30% to 50%)).

### 4th step: Synthesis of Intermediate int-08

Intermediate int-05 (14.5 g, 33.4 mmol), Intermediate int-07 (11.0 g, 36.8 mmol), K₂CO₃ (9.2 g, 66.8 mmol), and Pd(PPh₃)₄ (1.93 g, 1.67 mmol) were added to a round bottom flask and dissolved in THF (170 ml) and distilled water (40 ml) and then, stirred under reflux at 70 °C for 6 hours. When a reaction was completed, after removing an aqueous layer, 13.3 g (70%) of Intermediate int-08 was obtained by using column chromatography (hexane:DCM (30%)).

### 5th step: Synthesis of Compound 40

Intermediate int-08 (13.3 g, 23.4 mmol), 9H-carbazole (4.7 g, 28.0 mmol), and K₃PO4 (9.9 g, 46.7 mmol) were added to a round bottom flask and dissolved in DMF (100 ml) and then, stirred under reflux at 150 °C for 4 hours. When a reaction was completed, the reactant was slowly added in a dropwise fashion to an excessive amount of water to precipitate a solid, which was filtered and recrystallized with monochlorobenzene, obtaining 14.1 g (84%) of Compound 40.

### Synthesis Example 3: Synthesis of Compound B-136

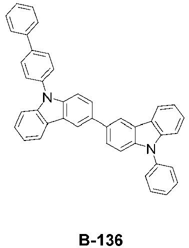

Compound B-136 was synthesized by referring to the synthetic method of patent EP3034581.

### Comparative Synthesis Example 1: Synthesis of Compound Host 1

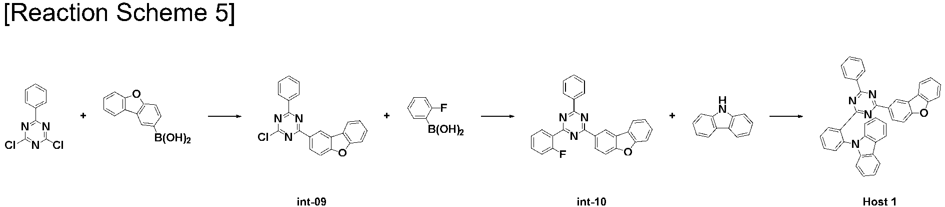

### 1st step: Synthesis of Intermediate int-09

24.4 g (65%) of Intermediate int-09 was synthesizes in the same manner as in the 1st step of Synthesis Example 1 except that 2,4-dichloro-6-phenyl-1,3,5-triazine (25.0 g, 110.6 mmol), 2-dibenzofuranylboronic acid (22.3 g, 105.1 mmol), K₂CO₃ (30.6 g, 221.2 mmol), and Pd(dppf)Cl₂ (4.52 g, 5.53 mmol) were used.

### 2nd step: Synthesis of Intermediate int-10

Intermediate int-9 (24.4 g, 68.2 mmol), 2-fluorophenylboronic acid (11.5 g, 81.8 mmol), K₂CO₃ (18.9 g, 136.4 mmol), and Pd(PPh₃)₄ (3.94 g, 3.41 mmol) were added to a round bottom flask and dissolved in THF (270 ml) and distilled water (70 ml) and then, stirred under reflux at 70 °C for 6 hours. When a reaction was completed, after removing an aqueous layer, 17.1 g (60%) of Intermediate int-10 was obtained by using column chromatography (hexane:DCM (30%)).

### 3rd step: Synthesis of Compound Host 1

Intermediate int-10 (17.1 g, 41.0 mmol), 9H-carbazole (13.7 g, 81.9 mmol), and K₃PO4 (17.4 g, 81.9 mmol) were added to a round bottom flask and dissolved in 150 ml of DMF and then, stirred under reflux at 150 °C for 4 hours. When a reaction was completed, the reactant was slowly added in a dropwise fashion to an excessive amount of water to precipitate a solid, which was filtered and recrystallized with monochlorobenzene, obtaining 18.5 g (80%) of Compound Host 1.

### Comparative Synthesis Example 2: Synthesis of Compound Host 2

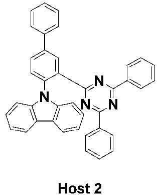

Compound Host 2 was synthesized by referring to the synthetic method of patent KR2020-0023984.

### Comparative Synthesis Example 3: Synthesis of Compound Host 3

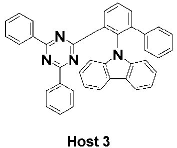

Compound Host 3 was synthesized by referring to the synthetic method of patent WO2014-146752.

### Example 1

A glass substrate coated with ITO (Indium tin oxide) was washed with distilled water and ultrasonic waves. After washing with the distilled water, the glass substrate was washed with a solvent such as isopropyl alcohol, acetone, methanol, and the like ultrasonically and dried and then, moved to a plasma cleaner, cleaned by using oxygen plasma for 10 minutes, and moved to a vacuum depositor. This obtained ITO transparent electrode was used as an anode, Compound A doped with 3% NDP-9 (available from Novaled) was vacuum-deposited on the ITO substrate to form a 100 A-thick hole injection layer, and Compound A was deposited to on the hole injection layer to form a 1350 A-thick hole transport layer. Compound B was deposited on the hole transport layer to form a 350 A-thick hole transport auxiliary layer, and Compound 1 synthesized in Synthesis Example 1 was used as a host on the hole transport auxiliary layer and PhGD was doped as a dopant at 9 wt% to form a 350 A-thick light emitting layer by vacuum deposition. The ratios were described separately for the following examples and comparative examples. Subsequently, Compound C was deposited on the light emitting layer to a thickness of to form a 50 A-thick electron transport auxiliary layer, and Compound D and Liq were simultaneously vacuum-deposited at a weight ratio of 1:1 to form a 300 A-thick electron transport layer. LiQ (15 Å) and Al (1200 Å) were sequentially vacuum-deposited on the electron transport layer to form a cathode, thereby manufacturing an organic light emitting diode.

The organic light emitting diode has a structure of ITO / Compound A (3 % NDP-9 doping, 100 Å) / Compound A (1350 Å) / Compound B (350 Å) / EML [Compound 1 (91 wt%) : PhGD (9 wt%)] (350 Å) / Compound C (50 Å) / Compound D : LiQ (300 Å) / LiQ (15 Å) / Al (1200 Å).
Compound A: N-(biphenyl-4-yl)-9,9-dimethyl-N-(4-(9-phenyl-9H-carbazol-3-yl)phenyl)-9H-fluoren-2-amine
Compound B: N-[4-(4-Dibenzofuranyl)phenyl]-N-[4-(9-phenyl-9H-fluoren-9-yl)phenyl][1,1'-biphenyl]-4-amine
Compound C: 2,4-Diphenyl-6-(4',5',6'-triphenyl[1,1':2',1":3",1‴:3‴,1ʺʺ-quinquephenyl]-3ʺʺ-yl)-1,3,5-triazine
Compound D: 2-[4-[4-(4'-Cyano-1,1'-biphenyl-4-yl)-1-naphthyl]phenyl]-4,6-diphenyl-1,3,5-triazine

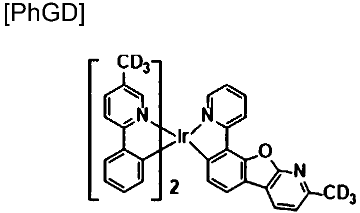

### Example 2 and Comparative Examples 1 to 3

Each organic light emitting diode was manufactured in the same manner as Example 1, except that the compositions were changed to that described in Table 1.

### Example 3

A glass substrate coated with ITO (Indium tin oxide) was washed with distilled water and ultrasonic waves. After washing with the distilled water, the glass substrate was washed with a solvent such as isopropyl alcohol, acetone, methanol, and the like ultrasonically and dried and then, moved to a plasma cleaner, cleaned by using oxygen plasma for 10 minutes, and moved to a vacuum depositor. This obtained ITO transparent electrode was used as an anode, Compound A doped with 3% NDP-9 (available from Novaled) was vacuum-deposited on the ITO substrate to form a 100 A-thick hole injection layer, and Compound A was deposited to on the hole injection layer to form a 1350 A-thick hole transport layer. Compound E was deposited on the hole transport layer to a thickness of 350 Å to form a hole transport auxiliary layer. Compound 1 synthesized in Synthesis Example 1 and Compound B-136 synthesized in Synthesis Example 3 were simultaneously used as a host on the hole transport auxiliary layer, and PhGD was doped at 9 wt% as a dopant to form a 380 A-thick light emitting layer by vacuum deposition. Here, Compound 1 and Compound B-136 were used in a weight ratio of 3:7. Next, Compound F was deposited on the light emitting layer to form a 50 A-thick electron transport auxiliary layer, and Compound G and Liq were simultaneously vacuum deposited at a weight ratio of 1:1 to form a 300 A-thick electron transport layer. LiQ (15 Å) and Al (1200 Å) were sequentially vacuum-deposited on the electron transport layer to form a cathode, thereby manufacturing an organic light emitting diode.

The organic light emitting diode has a structure of ITO/ Compound A (3% NDP-9 doping, 100 Å)/ Compound A (1350 Å)/Compound E (350 Å)/EML [host (Compound 1 : Compound B-136 = 30 wt% : 70 wt%) : dopant (PhGD) = 91 wt% : 9 wt%] (380 Å)/ Compound F (50 Å)/Compound G:LiQ (300 Å)/ LiQ (15 Å)/Al (1200 Å).
Compound E: N,N-bis(9,9-dimethyl-9H-fluoren-4-yl)-9,9-spirobi(fluorene)-2-amine
Compound F: 2-[3'-(9,9-Dimethyl-9H-fluoren-2-yl)[1,1'-biphenyl]-3-yl]-4,6-diphenyl-1,3,5-triazine
Compound G: 2-[4-[4-(4'-Cyano-1,1'-biphenyl-4-yl)-1-naphthyl]phenyl]-4,6-diphenyl-1,3,5-triazine

### Example 4 and Comparative Examples 4 to 6

Each organic light emitting diode was manufactured in the same manner as in Example 3, except that the composition was changed to that described in Table 2.

### Evaluation

The driving voltage, luminous efficiency, and life-span characteristics of the organic light emitting diodes according to Examples 1 to 4 and Comparative Examples 1 to 6 were evaluated.

Specific measurement methods are as follows, and the results are shown in Tables 1 and 2.

### (1) Measurement of Current Density Change Depending on Voltage Change

The obtained organic light emitting diodes were measured regarding a current value flowing in the unit diode, while increasing the voltage from 0 V to 10 V using a current-voltage meter (Keithley 2400), and the measured current value was divided by area to provide the results.

### (2) Measurement of Luminance Change Depending on Voltage Change

Luminance was measured by using a luminance meter (Minolta Cs-1000A), while the voltage of the organic light emitting diodes was increased from 0 V to 10 V.

### (3) Measurement of Luminous Efficiency

The luminous efficiency (cd/A) at the same current density (10 mA/cm²) was calculated using the luminance and current density measured from (1) and (2) above and the voltage.

The luminous efficiency values of Examples 1 to 2 and Comparative Examples 1 to 3 were calculated as relative values based on Comparative Example 1 and are listed in Table 1.

The luminous efficiency values of Examples 3 to 4 and Comparative Examples 4 to 6 were calculated as relative values based on Comparative Example 4 and are listed in Table 2.

### (4) Measurement of Life-span

Time when each current efficiency (cd/A) was reduced to 97%, while maintaining luminance (cd/m²) at 24000 cd/m², was measured as a life-span.

The life-span measurement values of Examples 1 to 2 and Comparative Examples 1 to 3 were calculated as relative values based on Comparative Example 1 and are listed in Table 1.

The life-span measurement values of Examples 3 to 4 and Comparative Examples 4 to 6 were calculated as relative values based on Comparative Example 4 and are listed in Table 2.

### (5) Measurement of Driving Voltage

The results were obtained by measuring the driving voltage of each diode at 15 mA/cm² using a current-voltage meter (Keithley 2400).

The driving voltages of Examples 1 to 2 and Comparative Examples 1 to 3 were calculated as relative values based on Comparative Example 1 and are listed in Table 1.

The driving voltages of Examples 3 to 4 and Comparative Examples 4 to 6 were calculated as relative values based on Comparative Example 4 and are listed in Table 2.

**(Table 1)**

| No. | Host | Driving voltage (%) | Luminous efficiency (%) | Life-span T97 (%) |
|---|---|---|---|---|
| Example 1 | compound 1 | 95.0 | 105.5 | 130.1 |
| Example 2 | compound 40 | 98.3 | 108.4 | 128.5 |
| Comparative Example 1 | Host 1 | 100.0 | 100.0 | 100.0 |
| Comparative Example 2 | Host 2 | 101.1 | 101.1 | 104.3 |
| Comparative Example 3 | Host 3 | 101.5 | 103.8 | 95.5 |

**(Table 2)**

| No. | First host | Second host | Luminous efficiency (%) | Life-span T97 (%) |
|---|---|---|---|---|
| Example 3 | compound 1 | B-136 | 107.5 | 132.5 |
| Example 4 | compound 40 | B-136 | 109.2 | 131.1 |
| Comparative Example 4 | Host 1 | B-136 | 100.0 | 100.0 |
| Comparative Example 5 | Host 2 | B-136 | 100.4 | 105.8 |
| Comparative Example 6 | Host 3 | B-136 | 102.9 | 96.3 |

Referring to Tables 1 and 2, the organic light emitting diodes according to Examples 1 to 4 exhibited significantly improved driving voltage, luminous efficiency, and life-span characteristics compared to the organic light emitting diodes according to Comparative Examples 1 to 6.

## Claims

1. A compound for an organic optoelectronic device represented by Chemical Formula 1A or Chemical Formula 1B: 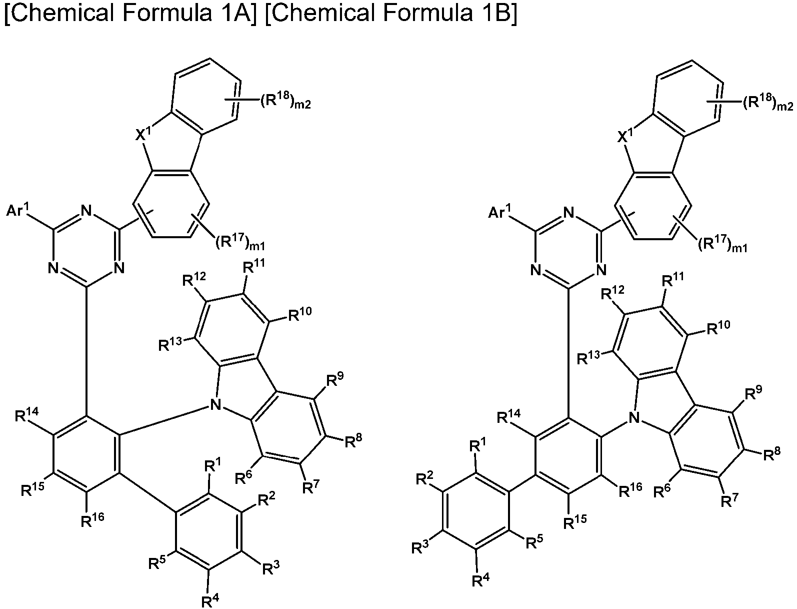 wherein, in Chemical Formula 1,
X¹ is O or S,
R¹ to R¹³, R¹⁷, and R¹⁸ are each independently hydrogen, deuterium, a substituted or unsubstituted C1 to C10 alkyl group, a substituted or unsubstituted C6 to C20 aryl group, or a substituted or unsubstituted C2 to C20 heterocyclic group,
R¹⁴ to R¹⁶ are each independently hydrogen or deuterium,
Ar¹ is a substituted or unsubstituted C6 to C20 aryl group or a substituted or unsubstituted C2 to C20 heterocyclic group,
m1 is one of integers of 1 to 3,
m2 is one of integers of 1 to 4,
when m1 is 2 or more, each R¹⁷ is the same or different from each other, and
when m2 is 2 or more, each R¹⁸ is the same or different from each other.

2. The compound for the organic optoelectronic device as claimed in claim 1, wherein
Chemical Formula 1A is represented by any one of Chemical Formula 1A-1 to Chemical Formula 1A-4: 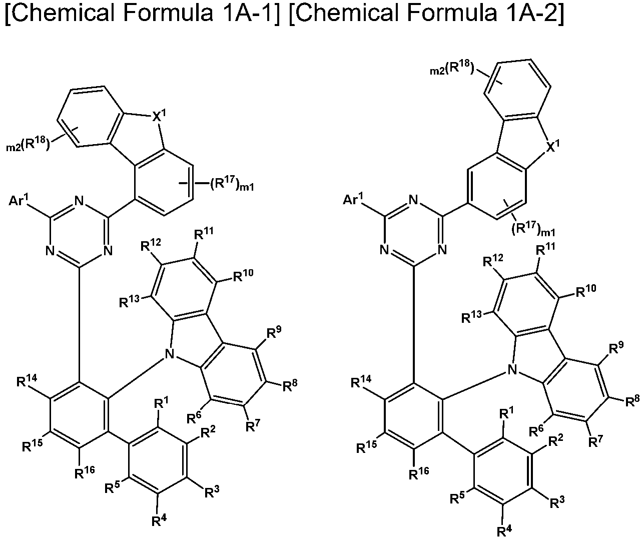 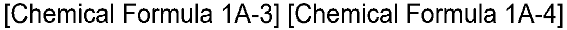 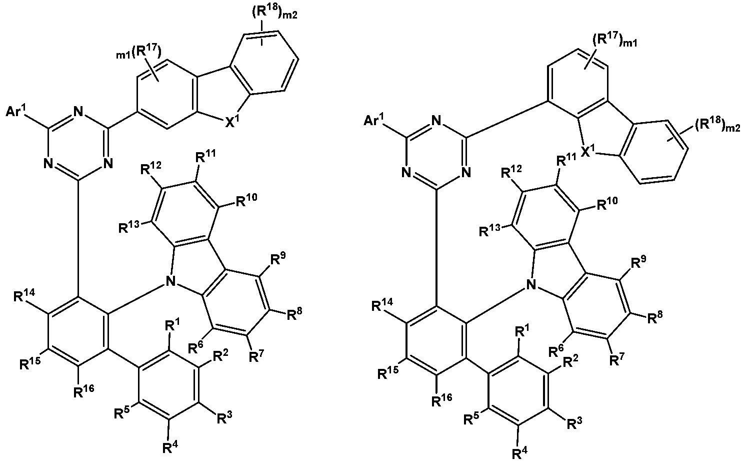
wherein, in Chemical Formula 1A-1 to Chemical Formula 1A-4,
R¹ to R¹⁸, Ar¹, m1 and m2 are as defined in claim 1.

3. The compound for the organic optoelectronic device as claimed in claim 1, wherein
Chemical Formula 1B is represented by any one of Chemical Formula 1B-1 to Chemical Formula 1B-4: 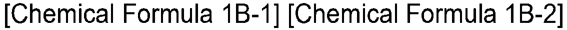 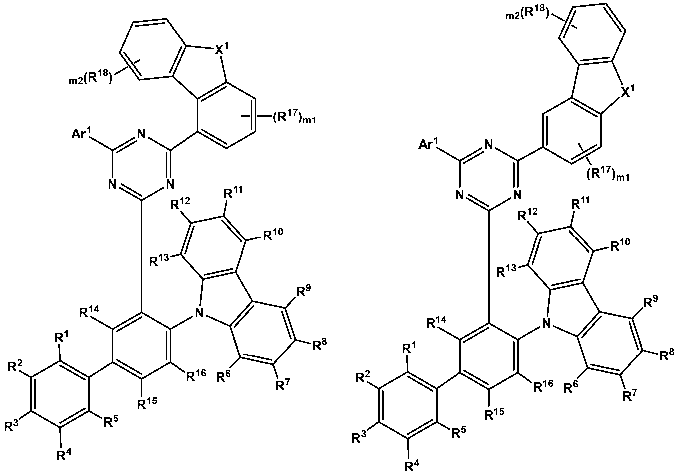 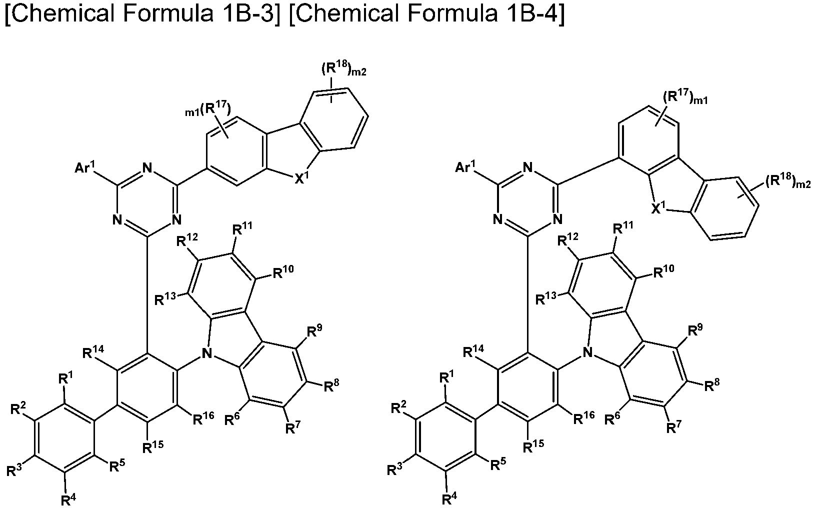
wherein, in Chemical Formula 1B-1 to Chemical Formula 1B-4,
R¹ to R¹⁸, Ar¹, m1, and m2 are as defined in claim 1.

4. The compound for the organic optoelectronic device as claimed in claim 1, wherein
Ar¹ is a substituted or unsubstituted phenyl group, a substituted or unsubstituted biphenyl group, or a substituted or unsubstituted terphenyl group.

5. The compound for the organic optoelectronic device as claimed in claim 1, wherein
R¹ to R¹³, R¹⁷ and R¹⁸ are each independently hydrogen, deuterium, or a substituted or unsubstituted C6 to C12 aryl group.

6. The compound for the organic optoelectronic device as claimed in claim 1, wherein
the compound is selected from the compounds listed in Group 1: 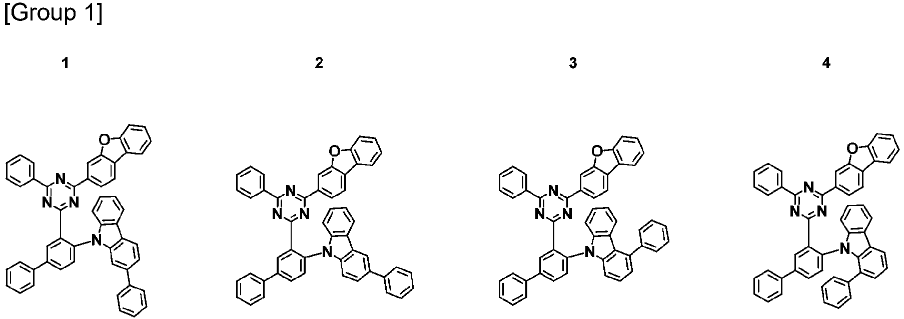 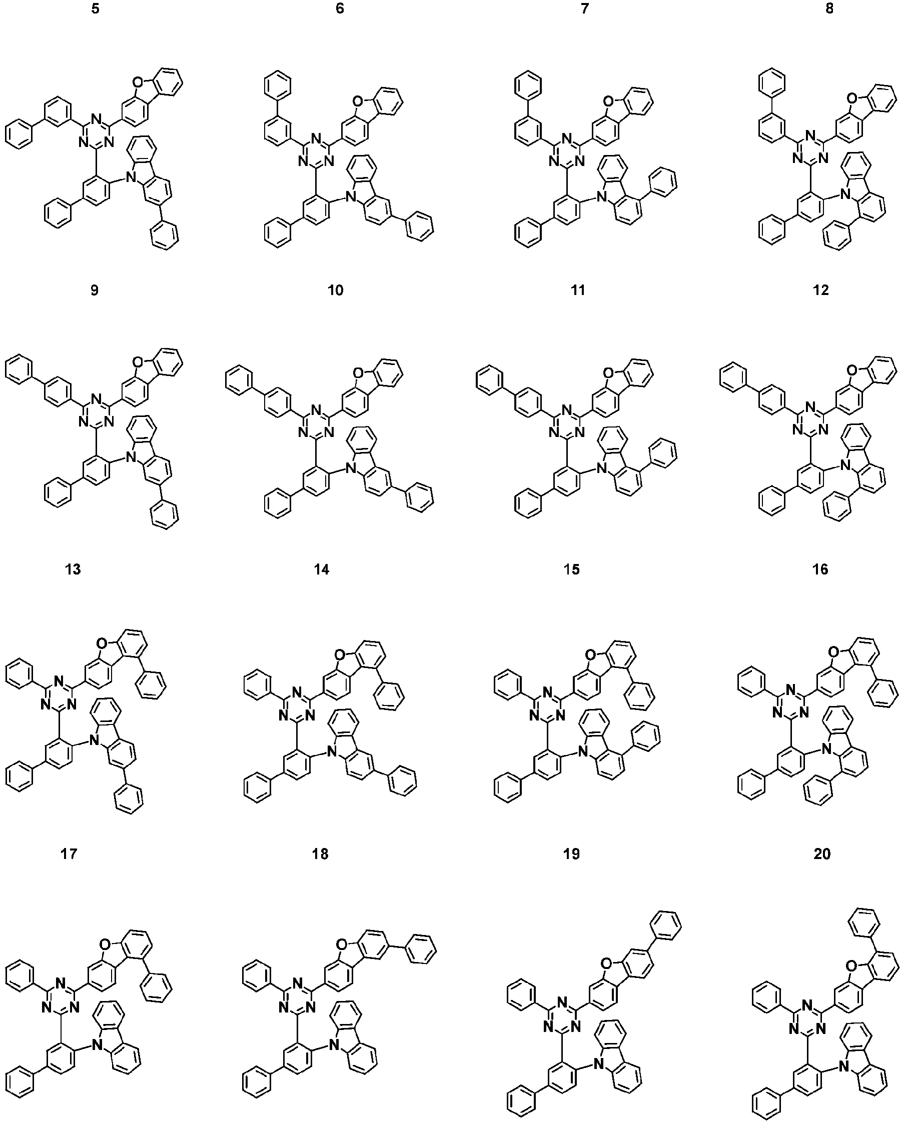 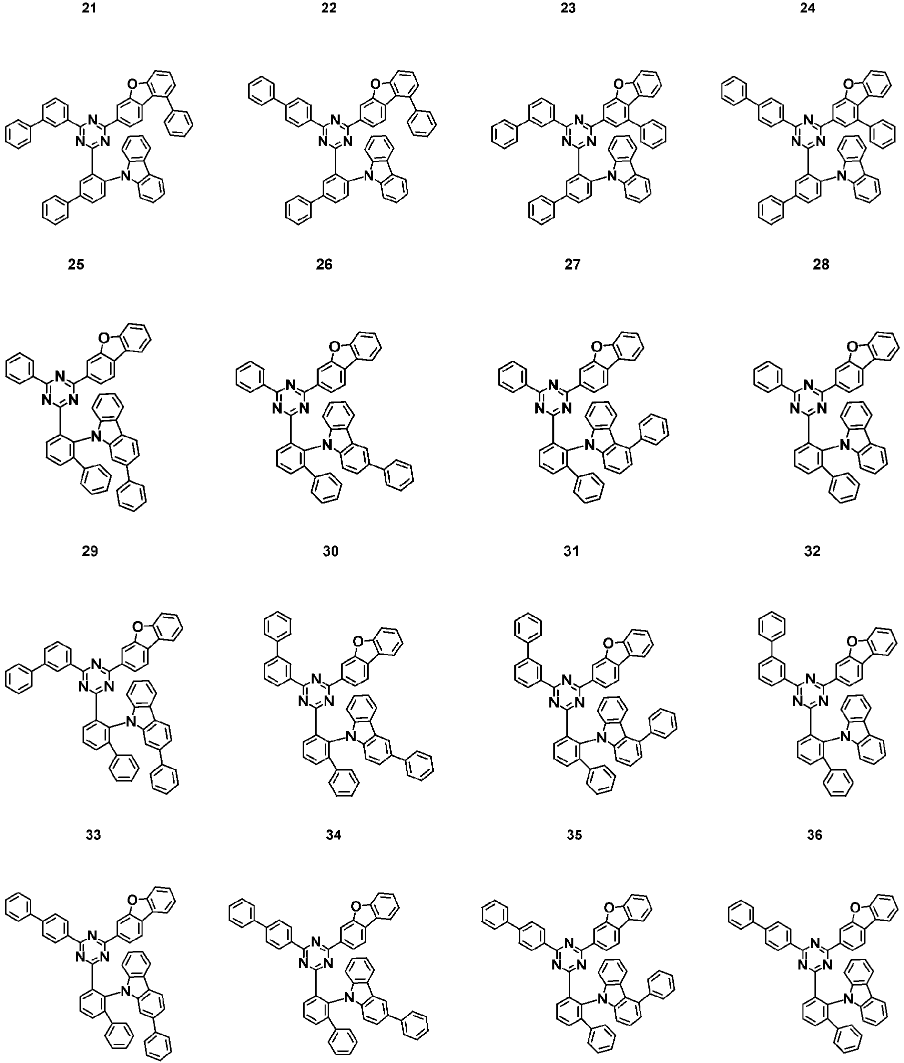 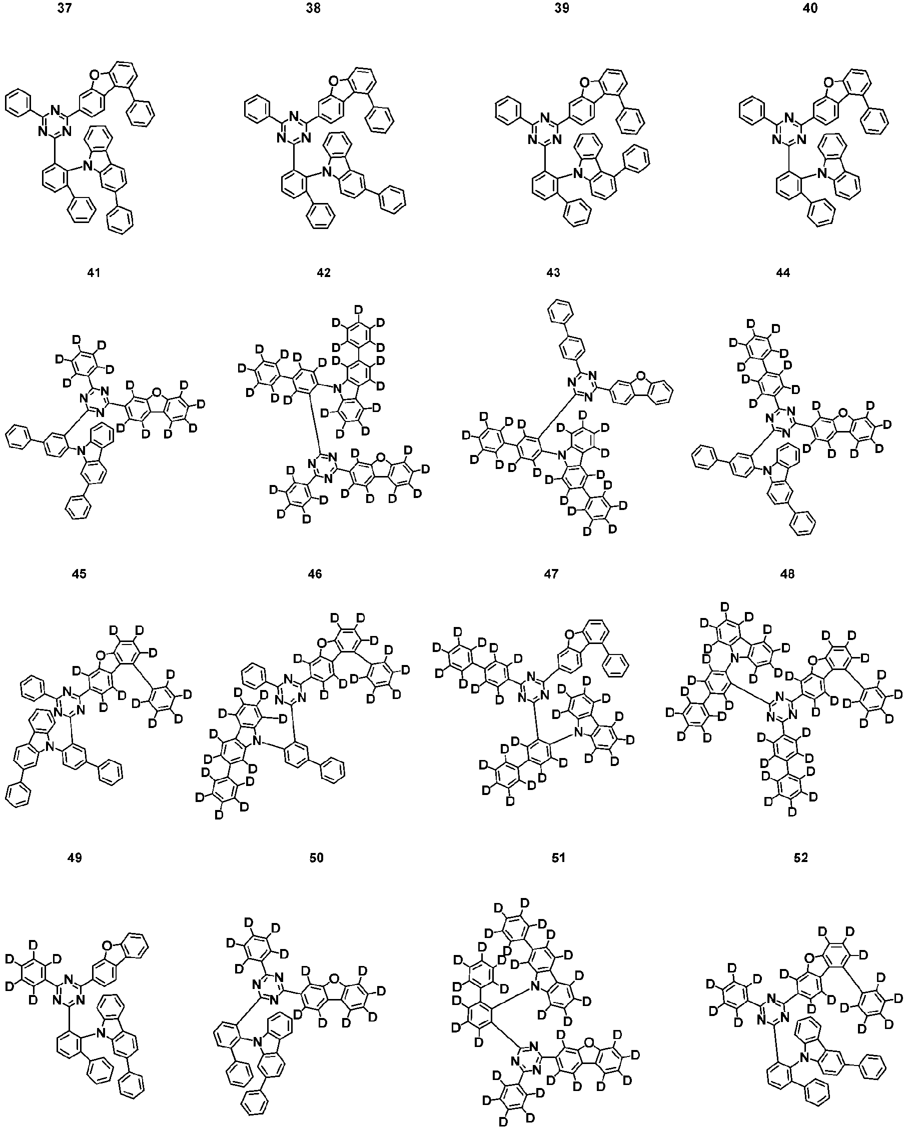 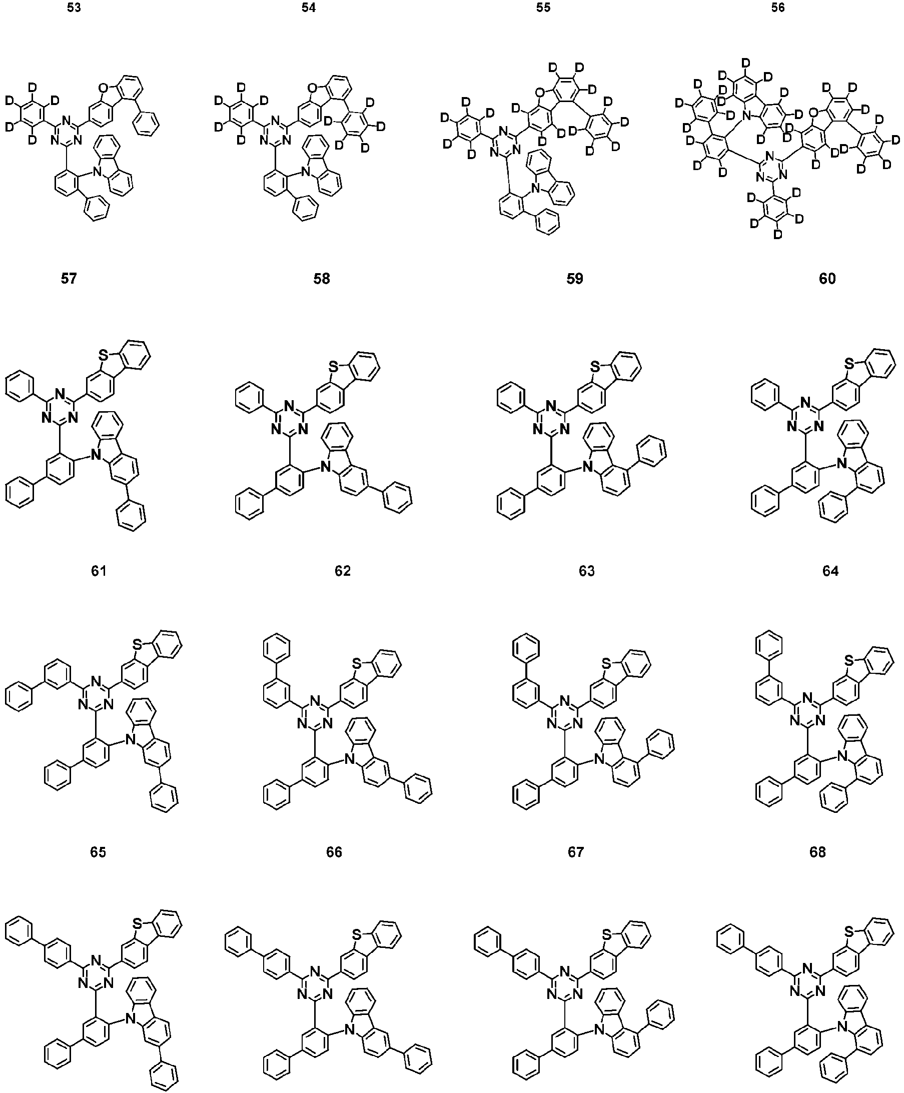 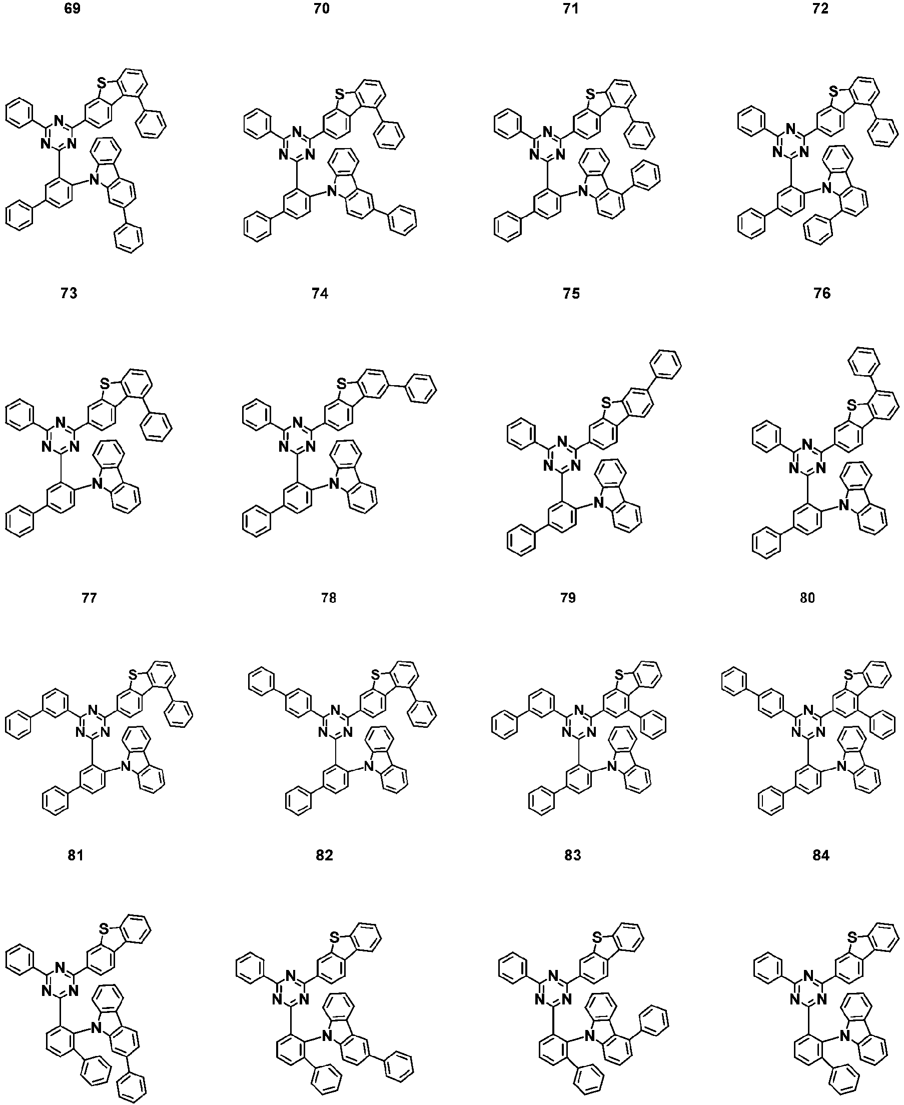 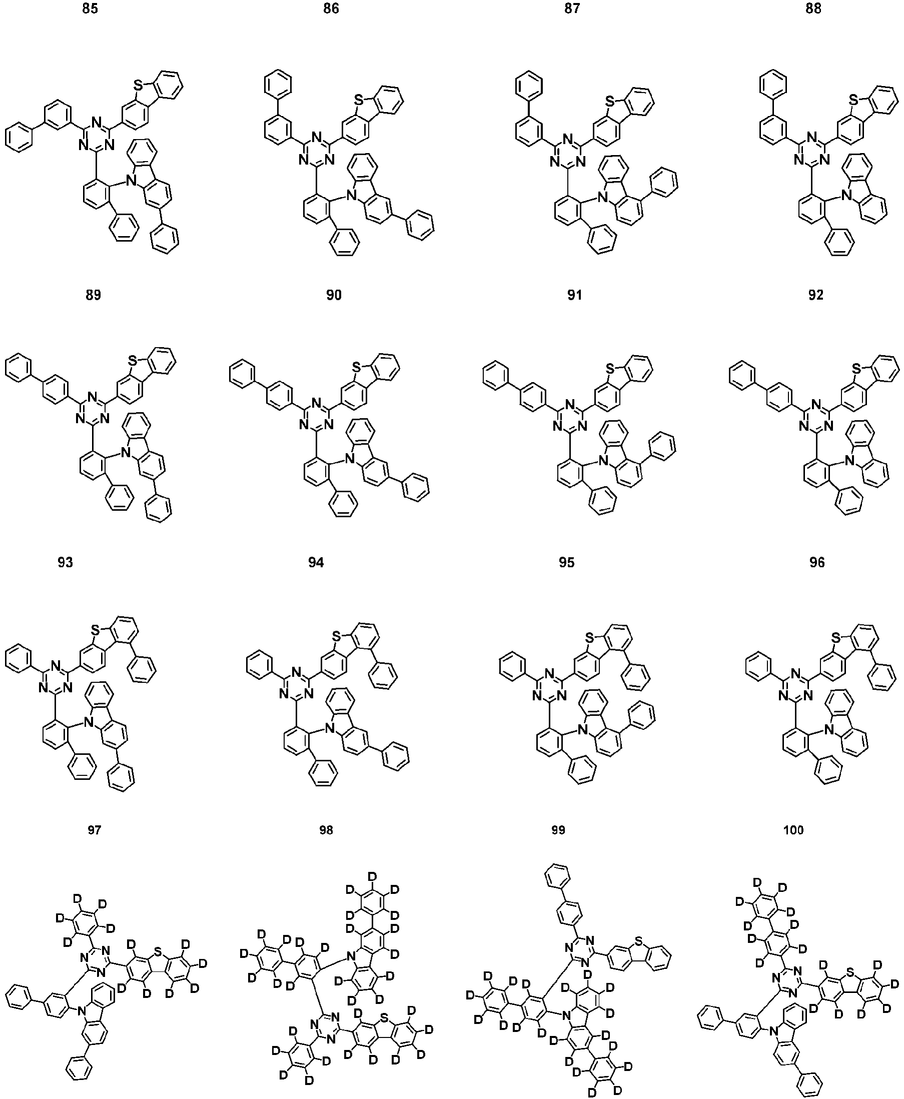 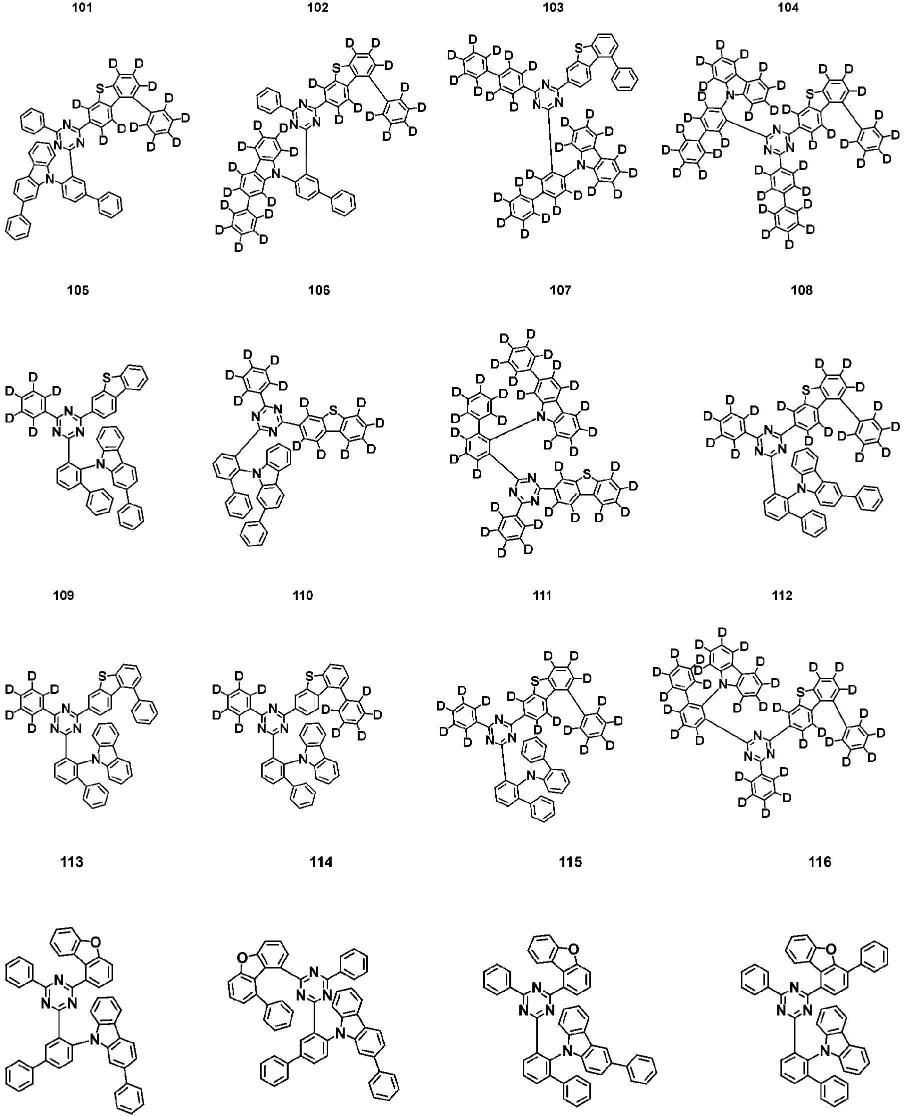 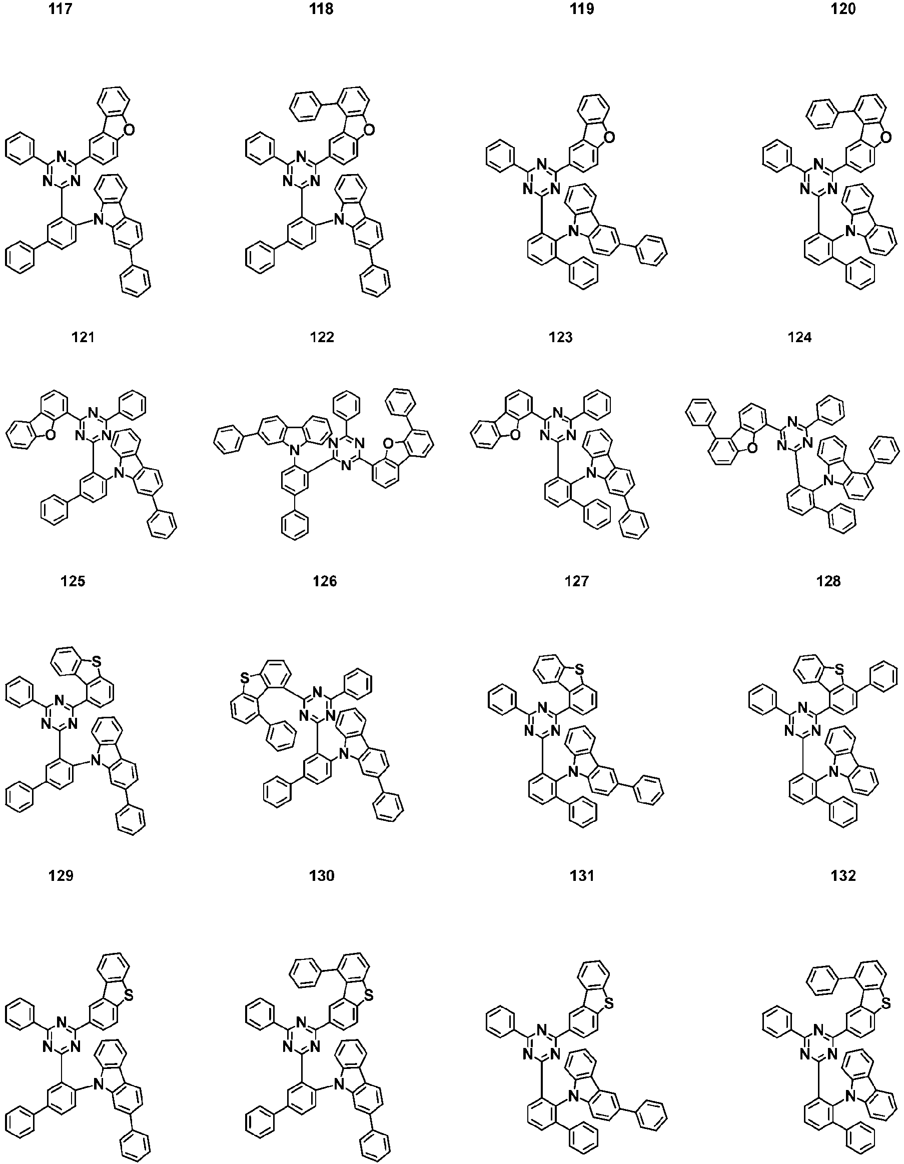 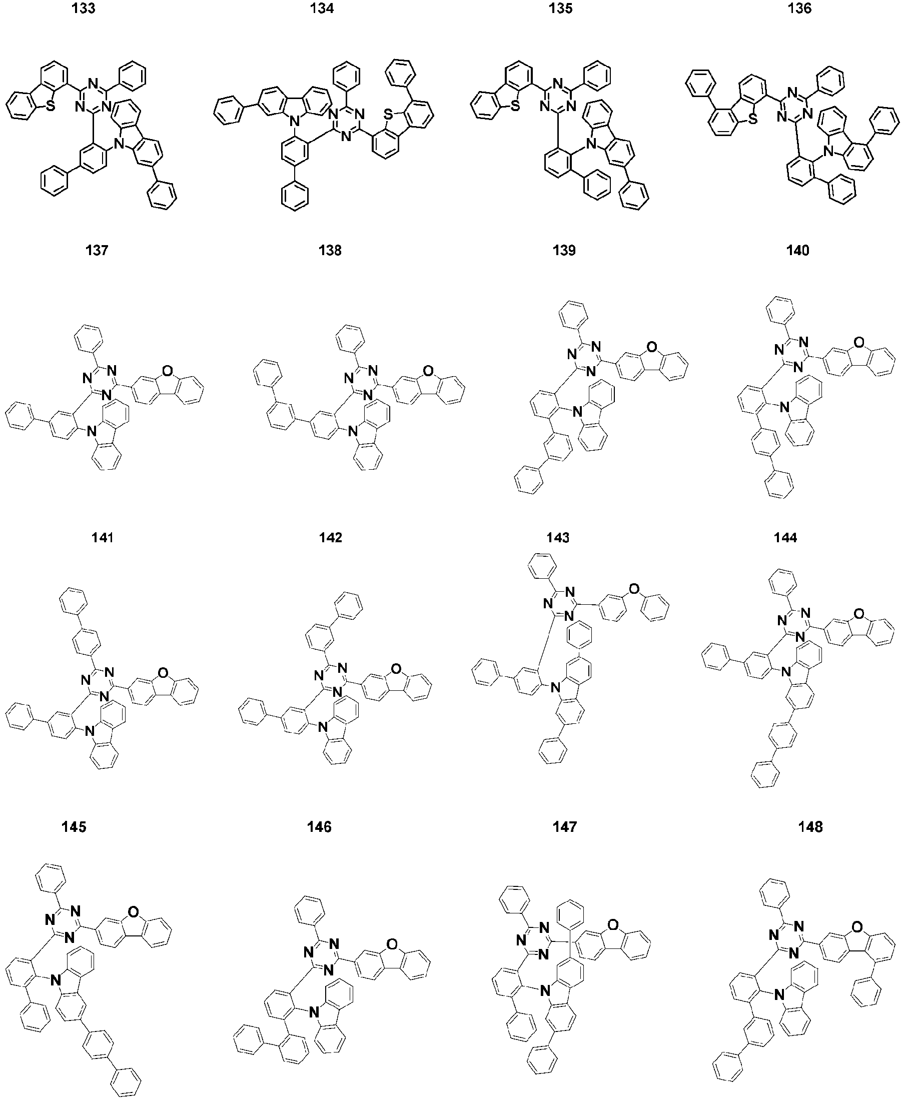 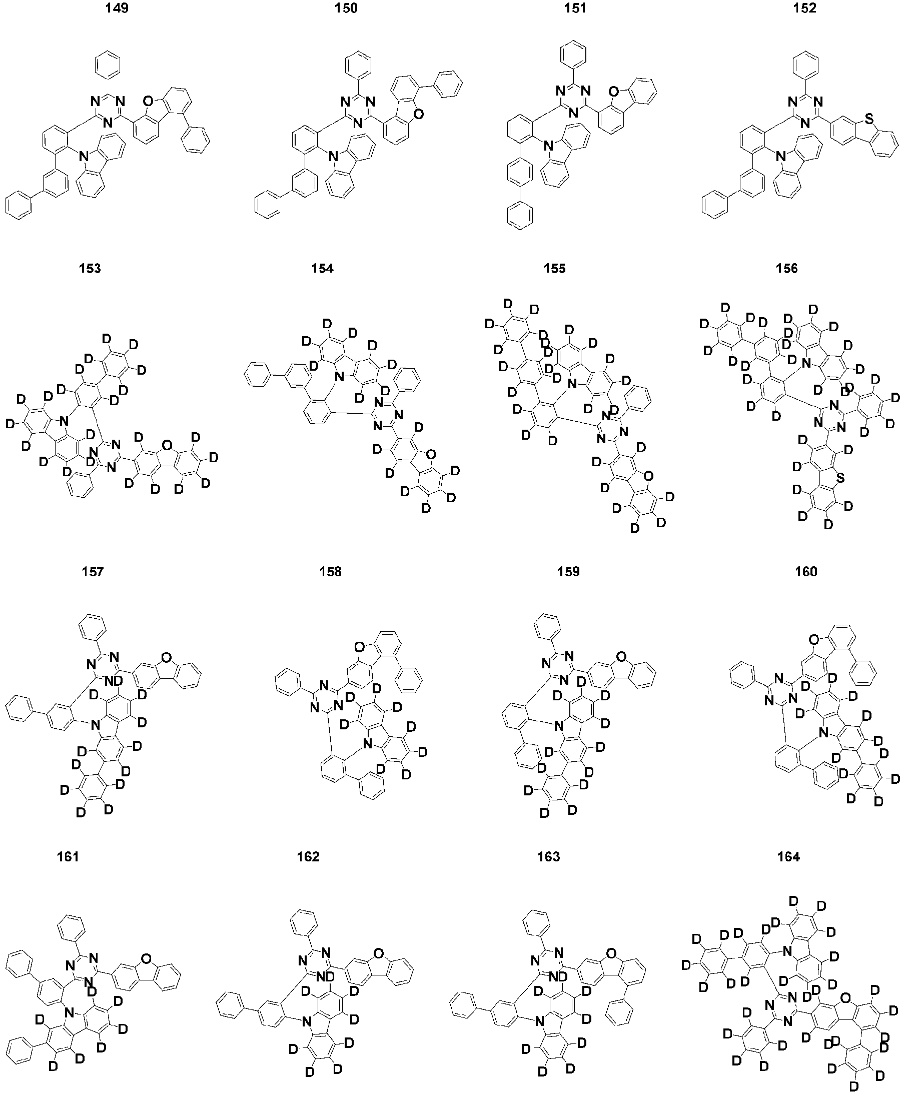 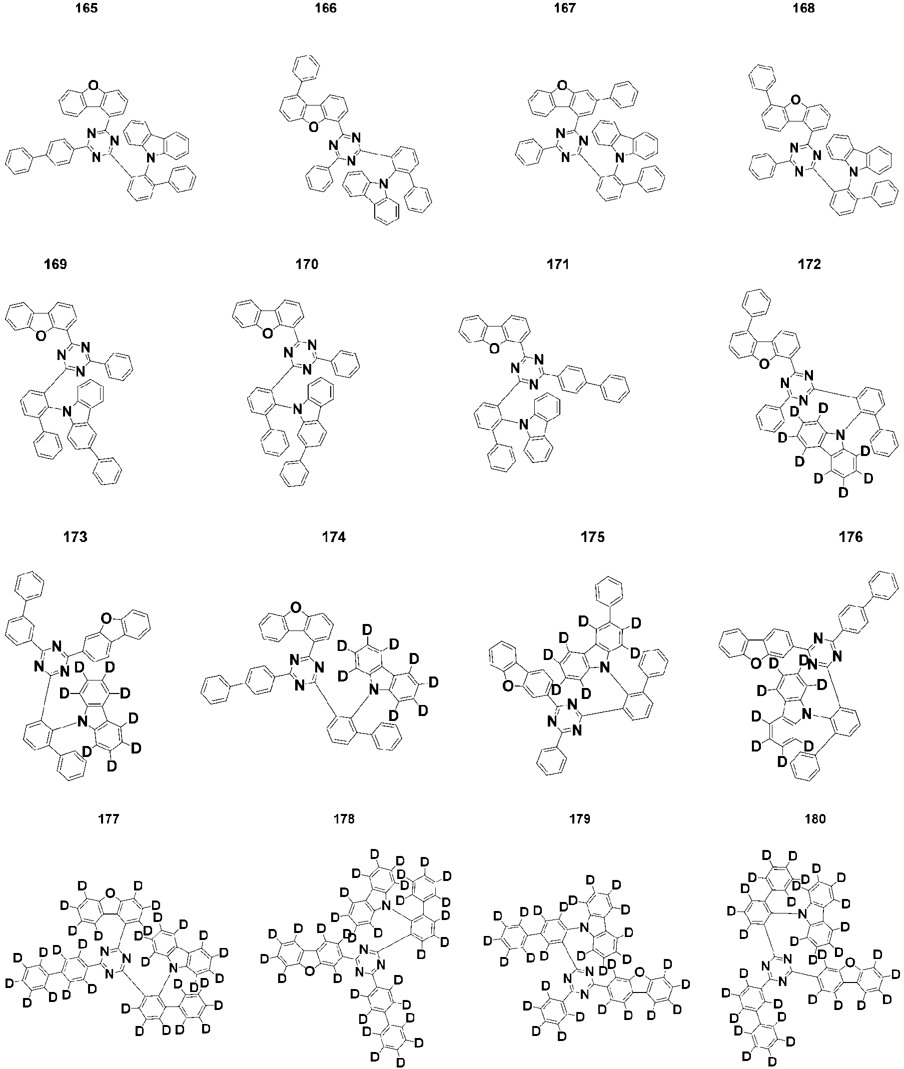 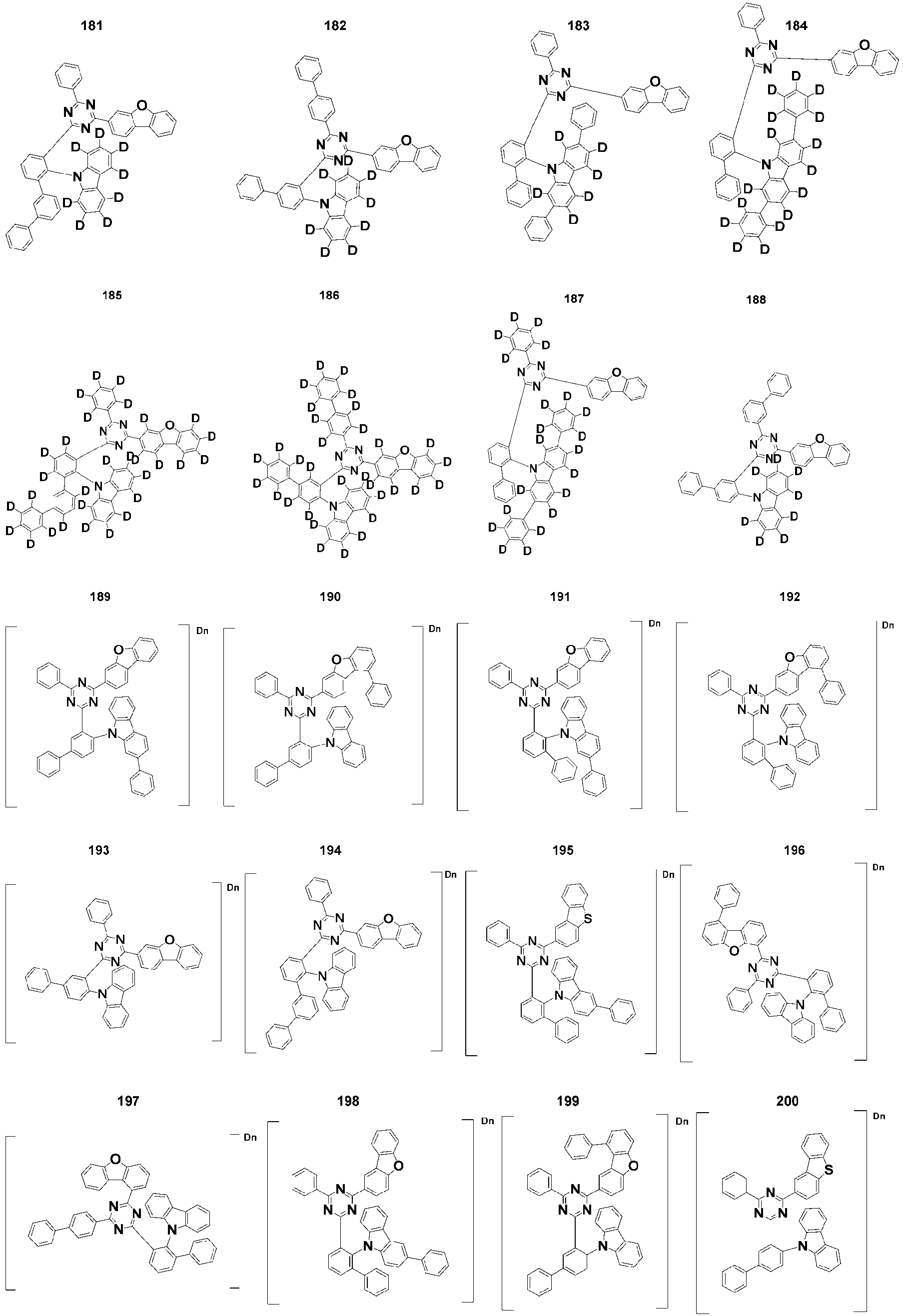 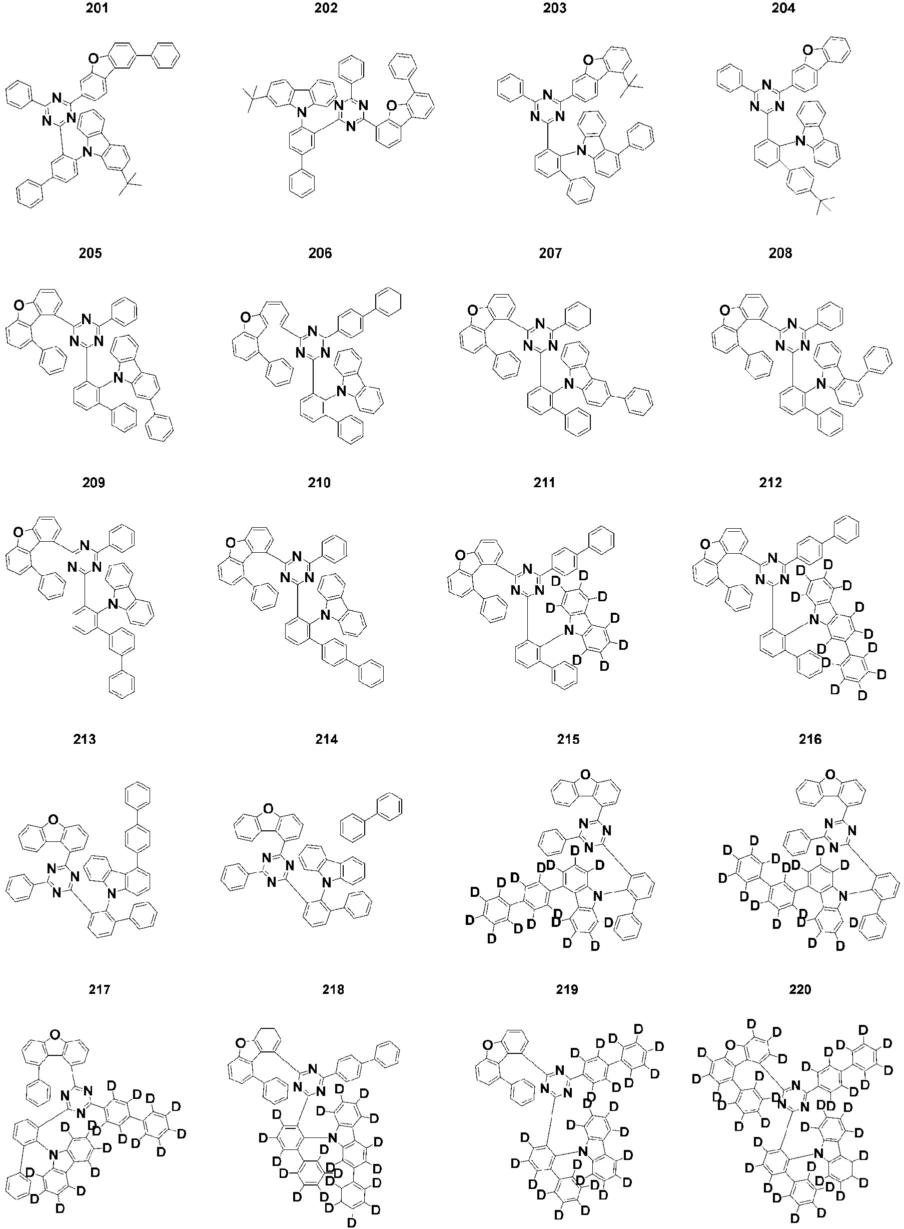 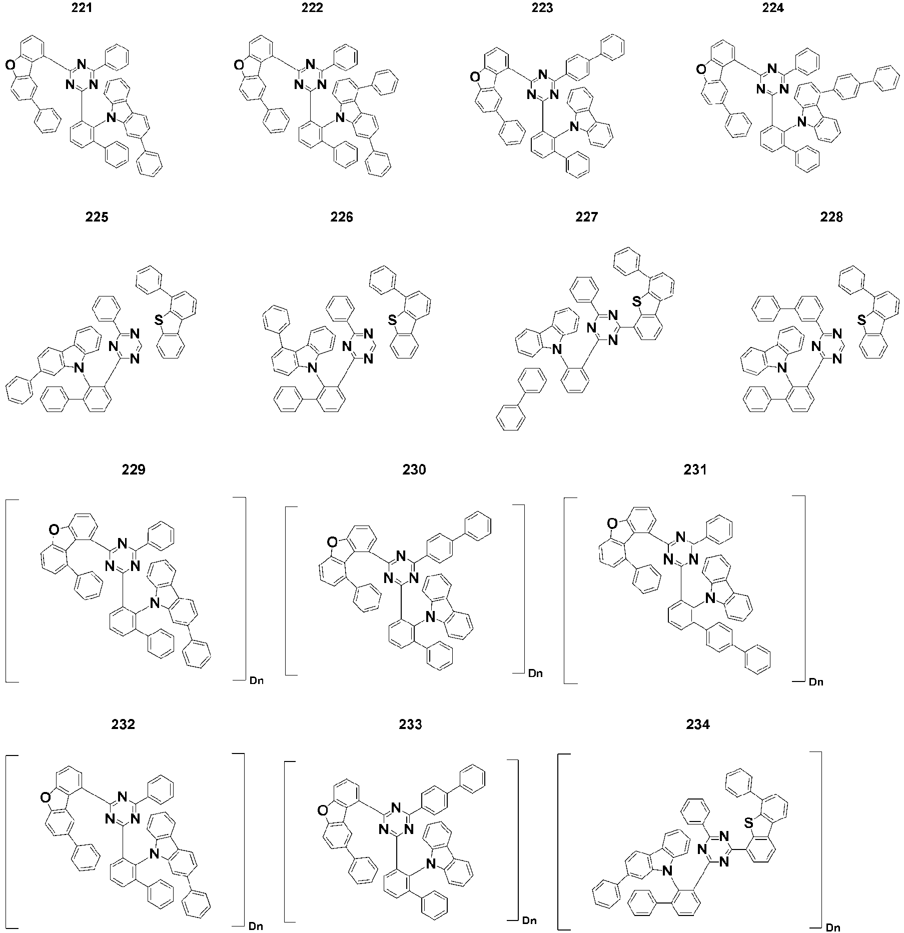
(Dn refers to the number of deuterium atoms substituted, and indicates a structure in which one or more deuterium atoms are substituted).

7. A composition for an organic optoelectronic device, comprising
a first compound and a second compound,
wherein the first compound is the compound for the organic optoelectronic device as claimed in claim 1, and
the second compound is represented by Chemical Formula 2; a combination of Chemical Formula 3 and Chemical Formula 4, or Chemical Formula 5: 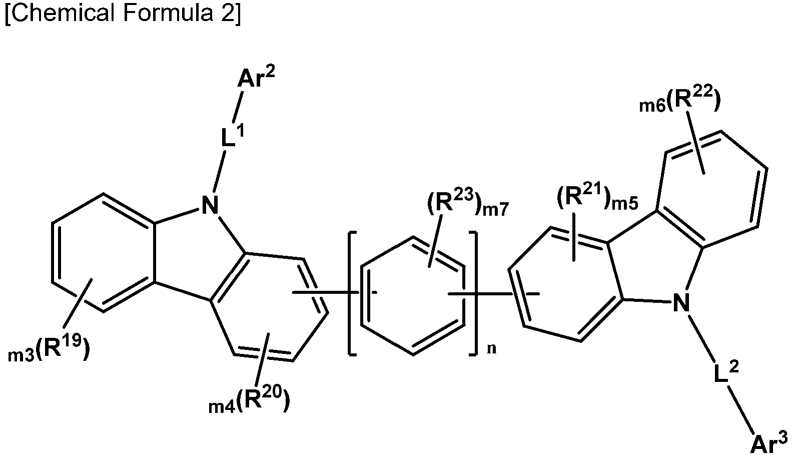
wherein, in Chemical Formula 2,
R¹⁹ to R²³ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar² and Ar³ are each independently a substituted or unsubstituted C6 to C20 aryl group or a substituted or unsubstituted C2 to C30 heterocyclic group,
L¹ and L² are each independently a single bond or a substituted or unsubstituted C6 to C20 arylene group,
m3, m6, and m7 are each independently one of integers of 1 to 4,
m4 and m5 are each independently one of integers of 1 to 3, and
n is one of integers of 0 to 2; 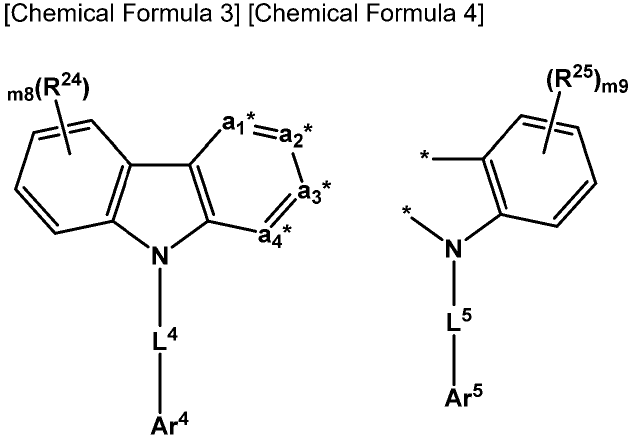
wherein, in Chemical Formula 3 and Chemical Formula 4,
a₁* to a₄* in Chemical Formula 3 are each independently a linking carbon (C) or C-L^{a}-R^{a},
among a₁* to a₄* in Chemical Formula 3, two adjacent ones are each linked to *s in Chemical Formula 4,
L^{a}, L⁴ and L⁵ are each independently a single bond or a substituted or unsubstituted C6 to C20 arylene group,
R^{a}, R²⁴ and R²⁵ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group,
m8 and m9 are each independently one of integers of 1 to 4; 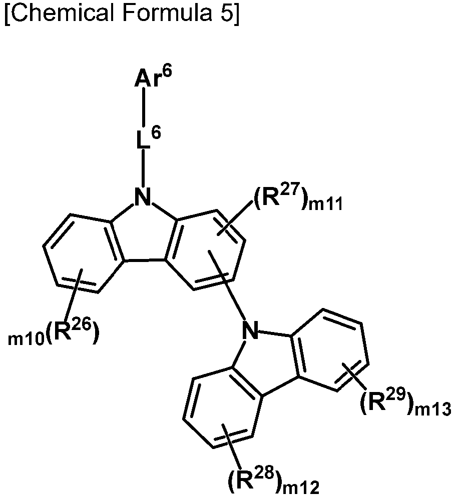
In Chemical Formula 5,
L⁶ are each independently a single bond or a substituted or unsubstituted C6 to C20 arylene group,
R²⁶ to R²⁹ are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁶ is a substituted or unsubstituted C6 to C20 aryl group or a substituted or unsubstituted C2 to C30 heterocyclic group,
m10, m12, and m13 are each independently one of integers of 1 to 4,
m11 is one of integers of 1 to 3,
m10 is 2 or more, each R²⁶ are the same or different from each other,
m11 is 2 or more, each R²⁷ are the same or different from each other,
m12 is 2 or more, each R²⁸ is the same or different from each other,
m13 is 2 or more, each R²⁹ are the same or different from each other.

8. The composition for the organic optoelectronic device as claimed in claim 7, wherein
Chemical Formula 2 is represented by Chemical Formula 2-8: 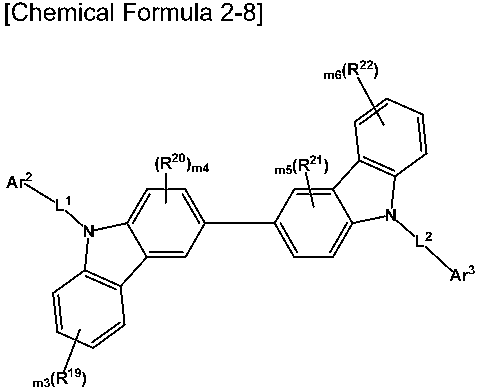
wherein, in Chemical Formula 2-8,
R¹⁹ to R²² are each independently hydrogen, deuterium, or a substituted or unsubstituted C6 to C12 aryl group,
m3 and m6 are each independently one of integers of 1 to 4,
m4 and m5 are each independently one of integers of 1 to 3, and
L¹-Ar² and L²-Ar³ are each independently one of substituents listed in Group I , 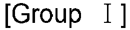 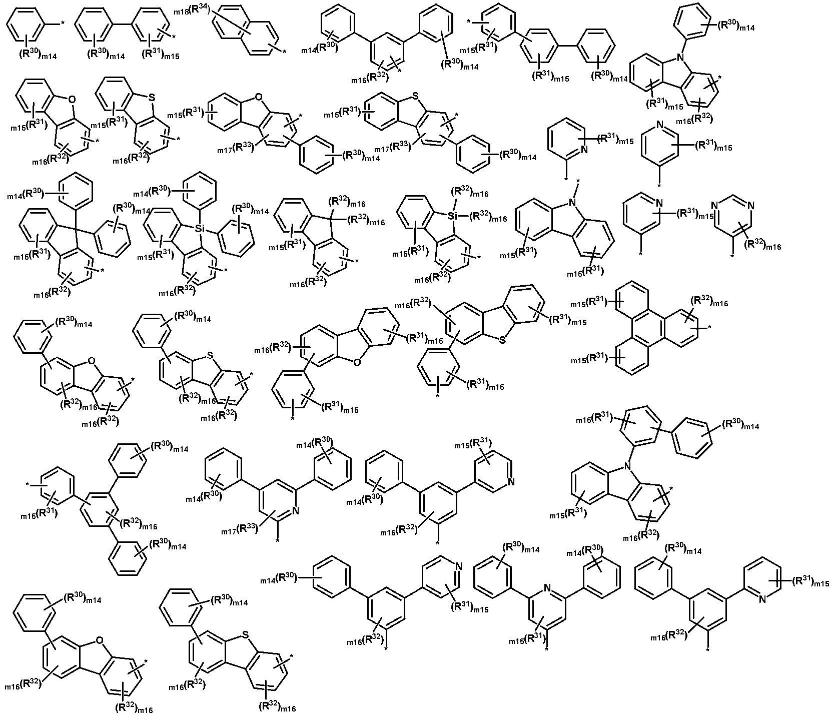
wherein, in Group I ,
R³⁰ to R³⁴ are each independently hydrogen, deuterium, a cyano group, C1 to C10 alkyl group or C6 to C12 aryl group,
m14 is one of integers of 1 to 5,
m15 is one of integers of 1 to 4,
m16 is one of integers of 1 to 3,
m17 is an integer of 1 or 2,
m18 is one of integers of 1 to 7, and
* is a linking point.

9. The composition for the organic optoelectronic device as claimed in claim 7, wherein
the combination of Chemical Formula 3 and Chemical Formula 4 is represented by Chemical Formula 3C: 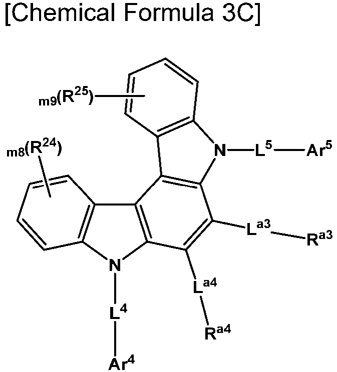
wherein, in Chemical Formula 3C,
L^{a3} and L^{a4} are a single bond,
R²⁴, R²⁵, R^{a3}, and R^{a4} are each independently hydrogen, deuterium, or a C6 to C12 aryl group,
m8 and m9 are each independently one of integers of 1 to 4, and
L⁴-Ar⁴ and L⁵-Ar⁵ are each independently one of substituents listed in Group I , 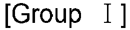 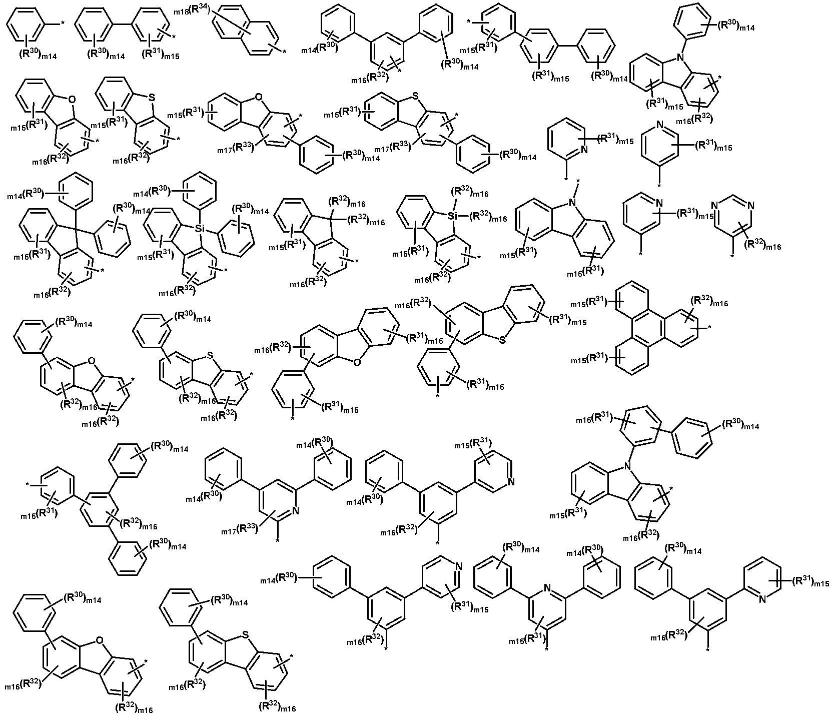
wherein, in Group I ,
R³⁰ to R³⁴ are each independently hydrogen, deuterium, a cyano group, a C1 to C10 alkyl group, or a C6 to C12 aryl group,
m14 is one of integers of 1 to 5,
m15 is one of integers of 1 to 4,
m16 is one of integers of 1 to 3,
m17 is an integer of 1 or 2,
m18 is one of integers of 1 to 7, and
* is a linking point.

10. An organic optoelectronic device, comprising
an anode and a cathode facing each other, and
at least one organic layer between the anode and the cathode,
wherein the organic layer comprises
the compound for the organic optoelectronic device as claimed in any one of claim 1 to claim 6; or
the composition for the organic optoelectronic device as claimed in any one of claim 7 to claim 9.

11. The organic optoelectronic device as claimed in claim 10, wherein
the organic layer comprises a light emitting layer, and
the light emitting layer comprises the compound for the organic optoelectronic device or the composition for the organic optoelectronic device.

12. A display device comprising the organic optoelectronic device as claimed in claim 10.
